# EUROPEAN PATENT APPLICATION

(11) **EP 4 498 159 A1**
(43) Date of publication of application: **29.01.2025**
(21) Application number: 24188912.0
(22) Date of filing: 16.07.2024
(51) Int. Cl.: G03F 7/004

(54) **COATING MATERIAL FOR PHOTOLITHOGRAPHY, RESIST COMPOSITION AND PATTERN FORMING PROCESS**

(30) Priority: 19.07.2023 JP 2023117489; 29.09.2023 JP 2023170395; 22.12.2023 JP 2023216833
(71) Applicant: SHIN-ETSU CHEMICAL CO., LTD., Tokyo 1000005 (JP)
(72) Inventor: Hatakeyama, Jun, Joetsu-shi (JP); Yamamoto, Yasuyuki, Joetsu-shi (JP); Imata, Tomohiro, Joetsu-shi (JP)
(74) Representative: Ter Meer Steinmeister & Partner

(57) **Abstract**

The coating material for photolithography contains 0.0001 to 3 wt% of a surfactant made from a resin having an aromatic group substituted with a fluorine atom, a trifluoromethoxy group, a difluoromethoxy group, a trifluoromethylthio group, or a difluoromethylthio group.

## Description

### TECHNICAL FIELD

The present invention relates to a coating material for photolithography, a resist composition and a pattern forming process.

### BACKGROUND ART

To meet the demand for higher integration density and higher operating speed of LSIs, the effort to reduce the pattern rule is in rapid progress. As the use of 5G high-speed communications and artificial intelligence (AI) is widely spreading, high-performance devices are needed for their processing. As the most advanced miniaturization technology, mass production of microelectronic devices at the 5-nm node by the lithography using extreme ultraviolet (EUV) having a wavelength of 13.5 nm has been implemented. Studies are made on the application of EUV lithography to 3-nm node devices of the next generation and 2-nm node devices of the next-but-one generation.

A material for use in photolithography, such as a resist composition, is applied in the form of a solution by a method such as spin coating, and the solvent is eliminated by baking to form a film. The film after baking is required to be uniform in thickness and flat, and the level of the required uniformity and flatness has been raised year by year.

In 3D-NAND memory applications, there is a demand for thick resist films, and higher flatness is required. It becomes more difficult to secure flatness as the film thickness increases. On the other hand, as the size is reduced, the film thickness is decreasing, and thus, the risk of generating pinhole defects and the like increases.

Occurrence of Marangoni convection in a solvent during application may cause generation of a striation. Selection of a solvent having an optimum boiling point and low viscosity and selection of a surfactant for lowering surface tension are important for prevention of Marangoni convection.

Surfactants having a fluoroalkyl group or a silicone chain have a high effect of reducing surface tension, and in particular, fluoroalkyl group-based surfactants having a decreased risk of generating particles derived from silicon after dry ashing of a resist film are widely used (Patent Documents 1 and 2). A fluorine-based surfactant is applied not only to a resist composition but also to a top coat formed at the upper layer of a resist and an underlying antireflection film formed at the lower layer of the resist (Patent Document 3).

Here, an impact of a perfluoroalkyl compound (PFAS) on the health has been pointed out, and there are moves in European REACH to place a restriction on the production and sale of PFAS compounds. There is a pressing need to develop a material having no PFAS structure.

A resist underlying film material has been proposed in which a polymer of phenylmethyl (meth)acrylate substituted with a fluorine atom or a trifluoromethoxy group is used (Patent Document 4). A polymer of phenylmethyl (meth)acrylate substituted with a fluorine atom or a trifluoromethoxy group, a resin having no fluorine atom, and a solvent are mixed, and applied, after which the fluorine atom-containing resin is oriented on the surface layer. In this way, two layers of antireflection film are formed by single application.

Surfactants having a trifluoromethoxy group or a pentafluorosulfanyl group and use thereof have been proposed (Patent Document 5).

### Citation List

Patent Document 1: JP-A H06-186735
Patent Document 2: JP-A H06-214380
Patent Document 3: JP-A H06-289620
Patent Document 4: JP-A 2010-139822
Patent Document 5: JP-W 2008-526792

### DISCLOSURE OF INVENTION

The present invention has been made in view of the above circumstances, and an object of the present invention is to provide a coating material for photolithography which contains a surfactant having no perfluoroalkyl structure, a resist composition which forms a film having excellent flatness after application and which generates little defects not only after application but also after development, and a pattern forming process using the coating material or the resist composition.

The present inventors have conducted intensive studies for obtaining a surfactant for a coating material for photolithography, which has recently desired high flatness after application, and good applicability at an outermost edge portion of a wafer, and generates little defects after application, after development and after etching. As a result, the present inventors have found that by adding a surfactant made from a resin having an aromatic group substituted with a fluorine atom, a trifluoromethoxy group, a difluoromethoxy group, a trifluoromethylthio group, or a difluoromethylthio group to a coating material for photolithography, a characteristic is exhibited that high flatness is achieved after application, and little defects are generated after application and development, leading to completion of the present invention. An aromatic group substituted with a fluorine atom, a trifluoromethoxy group, and a difluoromethoxy group do not belong to the classification of PFAS in REACH. A difluoromethoxy group and an aromatic group substituted with a fluorine atom do not belong to the classification of PFAS in OECD.

That is, the present invention provides the following coating material for photolithography, resist composition and pattern forming process.
1. A coating material for photolithography comprising 0.0001 to 3 wt% of a surfactant made from a resin having an aromatic group substituted with a fluorine atom, a trifluoromethoxy group, a difluoromethoxy group, a trifluoromethylthio group, or a difluoromethylthio group.
2. The coating material for photolithography as set forth in item 1, wherein the resin is a polymer containing repeat units Sa having an aromatic group substituted with a fluorine atom, a trifluoromethoxy group, a difluoromethoxy group, a trifluoromethylthio group, or a difluoromethylthio group.
3. The coating material for photolithography as set forth in item 2, wherein the repeat unit Sa has one of the following formulae (Sa1) to (Sa5): 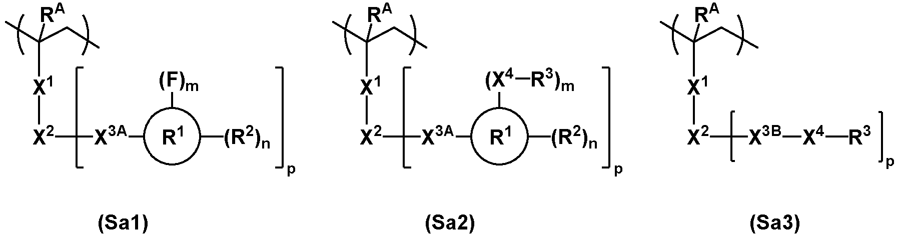 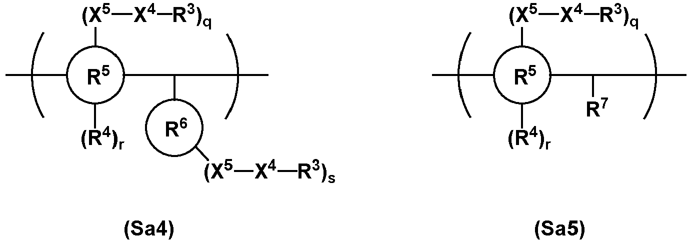 wherein m is each independently an integer of 1 to 5, n is each independently an integer of 0 to 4, p is each independently an integer of 1 to 3, q is each independently an integer of 0 to 3, r is an integer of 0 to 3, s is an integer of 0 to 4, provided that q + s is an integer of 1 to 5,
   R^{A} is each independently a hydrogen atom or a methyl group,
   X¹ is each independently a single bond, an ester bond, an ether bond, an amide bond or a phenylene group,
   X² is each independently a single bond or a C₁-C₂₀ hydrocarbylene group when p is 1, a C₁-C₂₀ (p+1)-valent hydrocarbon group when p is 2 or 3, and the hydrocarbylene group and the (p+1)-valent hydrocarbon group may contain at least one selected from an oxygen atom, a sulfur atom, a nitrogen atom and a halogen atom,
   X^{3A} is each independently a single bond, an ester bond, an ether bond, an amide bond, a sulfonic acid ester bond, a urethane bond, a thiourethane bond, a urea bond or -S(=O)-N(X³¹)-, X³¹ is a hydrogen atom or a C₁-C₆ saturated hydrocarbyl group,
   X^{3B} is a single bond or a carbonyl group,
   X⁴ is -O- or -S-,
   X⁵ is a single bond or a C₁-C₁₂ hydrocarbylene group, and the hydrocarbylene group may have at least one selected from a hydroxy group, a C₁-C₆ saturated hydrocarbyloxy group, an ether bond and an ester bond,
   the circle R¹ is each independently, a (m+n+1)-valent group derived from benzene or naphthalene,
   R² is each independently a hydrogen atom, a C₁-C₆ hydrocarbyl group, a C₁-C₁₂ hydrocarbyloxy group, a C₂-C₆ hydrocarbyloxycarbonyl group, a C₂-C₁₂ hydrocarbylcarbonyloxy group, a hydroxy group, a carboxy group, a halogen atom, a cyano group or a nitro group,
   R³ is each independently a trifluoromethyl group or a difluoromethyl group,
   R⁴ is each independently a C₁-C₆ hydrocarbyl group, a C₁-C₁₂ hydrocarbyloxy group, a C₂-C₆ hydrocarbyloxycarbonyl group, a C₂-C₁₂ hydrocarbylcarbonyloxy group, a hydroxy group, a carboxy group, a halogen atom, a cyano group or a nitro group,
   the circle R⁵ is each independently a C₆-C₃₀ (q+r+2)-valent aromatic hydrocarbon group,
   the circle R⁶ is a (s+1)-valent group derived from benzene or naphthalene, and
   R⁷ is a hydrogen atom or a C₁-C₁₀ hydrocarbyl group, and the hydrocarbyl group may contain an oxygen atom, provided that R⁷ does not have a group of -X⁵-X⁴-R³.
4. The coating material for photolithography as set forth in item 3, wherein at least one of X¹ and X² is not a single bond.
5. The coating material for photolithography as set forth in item 3, which is a polymer containing repeat units of formula (Sa1) and repeat units of formula (Sa2).
6. The coating material for photolithography as set forth in any one of items 2 to 5, wherein the polymer further contains repeat units Sb having a hydrophilic group selected from an ether bond, an ester bond, a hydroxy group, a carboxy group, a sulfonamide bond, a sulfonimide bond and a sulfo group.
7. The coating material for photolithography as set forth in item 6, wherein the polymer is a block copolymer.
8. A resist composition comprising the coating material for photolithography of any one of items 1 to 7.
9. The resist composition as set forth in item 8, further comprising a base polymer and an organic solvent.
10. A pattern forming process comprising the steps of:
   applying the resist composition of item 8 or 9 onto a substrate to form a resist film on the substrate,
   exposing the resist film to high-energy radiation, and
   developing the exposed resist film in a developer.
11. The pattern forming process as set forth in item 10, wherein the high-energy radiation is a g-ray, an i-ray, KrF excimer laser, ArF excimer laser, an ultraviolet ray, an electron beam (EB), or EUV having a wavelength of 3 to 15 nm.

### ADVANTAGEOUS EFFECTS OF INVENTION

A surfactant used for the coating material for photolithography according to the present invention is made from a resin having an aromatic group substituted with a fluorine atom, a trifluoromethoxy group, a difluoromethoxy group, a trifluoromethylthio group, or a difluoromethylthio group, and a film obtained from a coating material for photolithography which contains the surfactant is excellent in flatness and thickness uniformity over the entire surface of a coated substrate, is cleanly cut when subjected to edge cutting at an outermost line portion of the wafer with a solvent during application, and has excellent ability to fill irregularities that may be present on the substrate. When used as a photosensitive material such as a resist composition, the coating material for photolithography exhibits an effect of reducing defects after coating, after development and after dry etching, and can be applied to, for example, not only lithography in formation of semiconductor circuits, but also formation of mask circuit patterns, micromachining, and formation of thin-film magnetic head circuits.

### DESCRIPTION OF PREFERRED EMBODIMENTS

### Coating material for photolithography

A coating material for photolithography according to the present invention contains a surfactant made from a resin having an aromatic group substituted with a fluorine atom, a trifluoromethoxy group, a difluoromethoxy group, a trifluoromethylthio group, or a difluoromethylthio group.

The resin is preferably a polymer containing repeat units Sa having an aromatic group substituted with a fluorine atom, a trifluoromethoxy group, a difluoromethoxy group, a trifluoromethylthio group, or a difluoromethylthio group.

The repeat units Sa is preferably repeat units represented by the following formula (Sa1) (hereinafter, also referred to as "repeat units Sa1"), repeat units represented by the following formula (Sa2) (hereinafter, also referred to as "repeat units Sa2"), repeat units represented by the following formula (Sa3) (hereinafter, also referred to as "repeat units Sa3"), repeat units represented by the following formula (Sa4) (hereinafter, also referred to as "repeat units Sa4"), or repeat units represented by the following formula (Sa5) (hereinafter, also referred to as "repeat units Sa5").

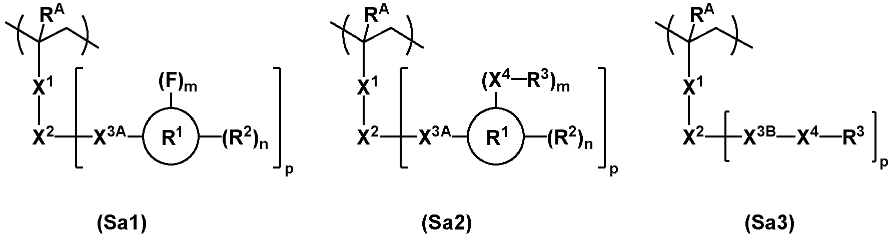

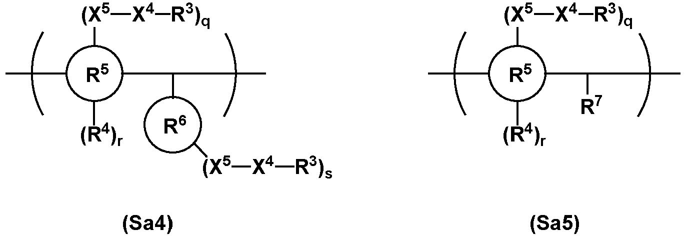

In formulae (Sa1) to (Sa5), m is each independently an integer of 1 to 5. n is each independently an integer of 0 to 4, p is each independently an integer of 1 to 3, q is each independently an integer of 0 to 3, r is an integer of 0 to 3, s is an integer of 0 to 4, provided that q + s is an integer of 1 to 5,

In formulae (Sa1) to (Sa3), R^{A} is each independently a hydrogen atom or a methyl group.

In formulae (Sa1) to (Sa3), X¹ is each independently a single bond, an ester bond, an ether bond, an amide bond or a phenylene group.

In formulae (Sal) to (Sa3), X² is each independently a single bond or a C₁-C₂₀ hydrocarbylene group when p is 1, a C₁-C₂₀ (p+1)-valent hydrocarbon group when p is 2 or 3, and the hydrocarbylene group and the (p+1)-valent hydrocarbon group may contain at least one selected from an oxygen atom, a sulfur atom, a nitrogen atom and a halogen atom.

The hydrocarbylene group X² may be saturated or unsaturated and straight, branched or cyclic. Specific examples thereof include C₁-C₂₀ alkanediyl groups such as methanediyl, ethane-1,1-diyl, ethane-1,2-diyl, propane-1,3-diyl, butane-1,4-diyl, pentane-1,5-diyl, hexane-1,6-diyl, heptane-1,7-diyl, octane-1,8-diyl, nonane-1,9-diyl, decane-1,10-diyl, undecane-1,11-diyl and dodecane-1,12-diyl; C₃-C₂₀ cyclic saturated hydrocarbylene groups such as cyclopentanediyl, cyclohexanediyl, norbornanediyl and adamantanediyl; C₂-C₂₀ unsaturated aliphatic hydrocarbylene groups such as vinylene and propene-1,3-diyl; C₆-C₂₀ arylene groups such as phenylene and naphthylene; and groups obtained by combining the foregoing. The C₁-C₂₀ (p+1)-valent hydrocarbon group represented by X² may be saturated or unsaturated, and may be linear, branched, or cyclic. Specific examples thereof include a group obtained by removing one or two hydrogen atoms from the foregoing hydrocarbylene group, and a group obtained by replacing one or two hydrogen atoms of the above-described hydrocarbylene group with a hydrocarbylene group.

Preferably, at least one of X¹ and X² is not a single bond.

In formulae (Sa1) and (Sa2), X^{3A} is each independently a single bond, an ester bond, an ether bond, an amide bond, a sulfonic acid ester bond, a urethane bond, a thiourethane bond, a urea bond or -S(=O)-N(X³¹)-. X³¹ is a hydrogen atom or a C₁-C₆ saturated hydrocarbyl group,

In formula (Sa3), X^{3B} is a single bond or a carbonyl group.

In formulae (Sa2) to (Sa5), X⁴ is -O- or -S-.

In formulae (Sa4) and (Sa5), X⁵ is a single bond or a C₁-C₁₂ hydrocarbylene group, and the hydrocarbylene group may have at least one selected from a hydroxy group, a C₁-C₆ saturated hydrocarbyloxy group, an ether bond and an ester bond.

In formulae (Sa1) and (Sa2), the circle R¹ is each independently a (m+n+1)-valent group derived from benzene or naphthalene.

In formulae (Sa1) and (Sa2), R² is each independently a hydrogen atom, a C₁-C₆ hydrocarbyl group, a C₁-C₁₂ hydrocarbyloxy group, a C₂-C₆ hydrocarbyloxycarbonyl group, a C₂-C₁₂ hydrocarbylcarbonyloxy group, a hydroxy group, a carboxy group, a halogen atom, a cyano group or a nitro group.

In formulae (Sa2) to (Sa5), R³ is each independently a trifluoromethyl group or a difluoromethyl group.

In formulae (Sa4) and (Sa5), R⁴ is each independently a C₁-C₆ hydrocarbyl group, a C₁-C₁₂ hydrocarbyloxy group, a C₂-C₆ hydrocarbyloxycarbonyl group, a C₂-C₁₂ hydrocarbylcarbonyloxy group, a hydroxy group, a carboxy group, a halogen atom, a cyano group or a nitro group.

In formulae (Sa4) and (Sa5), the circle R⁵ is each independently a C₆-C₃₀ (q+r+2)-valent aromatic hydrocarbon group. The C₆-C₃₀ (q+r+2)-valent aromatic hydrocarbon group is preferably one derived from benzene, naphthalene, anthracene, phenanthrene, pyrene, fluorene, biphenyl, diphenylmethane, tris-phenyl, fluorene bisphenol, fluorene bis naphthol or the like, and may have a substituted or unsubstituted hydroxy group or a C₁-C₁₂ saturated hydrocarbyl group, to which benzene or naphthalene having a substituted or unsubstituted hydroxy group may be bonded.

In formula (Sa4), the circle R⁶ is a (s+1)-valent group derived from benzene or naphthalene.

In formula (Sa5), R⁷ is a hydrogen atom or a C₁-C₁₀ hydrocarbyl group, and the hydrocarbyl group may contain an oxygen atom. Note that R⁷ does not have a group of -X⁵-X⁴-R³.

The polymer is preferably a polymer containing at least one selected from repeat units Sa1, Sa2 and Sa3 (hereinafter, also referred to as a polymer A).

Examples of the monomer which has an aromatic group substituted with a fluorine atom and from which repeat units Sa1 are derived include those shown below, but are not limited thereto. In the following formulae, R^{A} is as defined above.

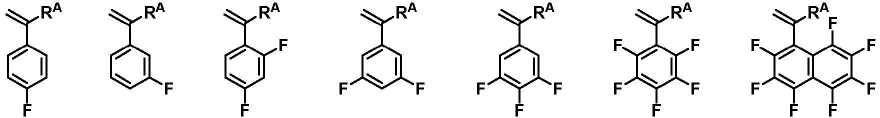

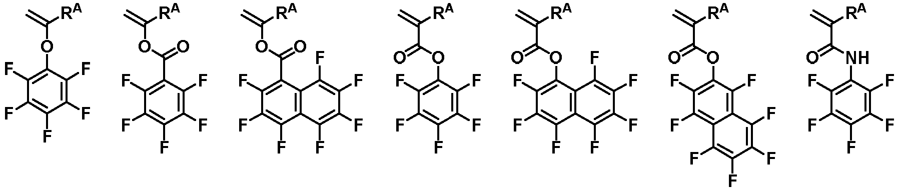

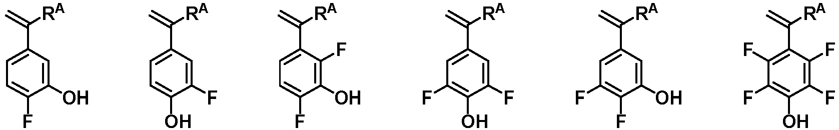

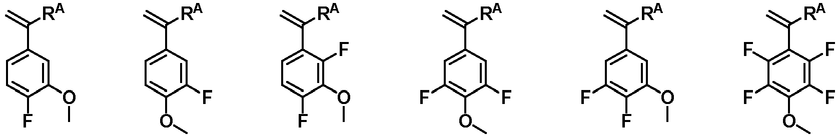

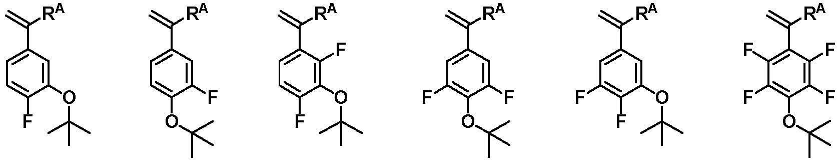

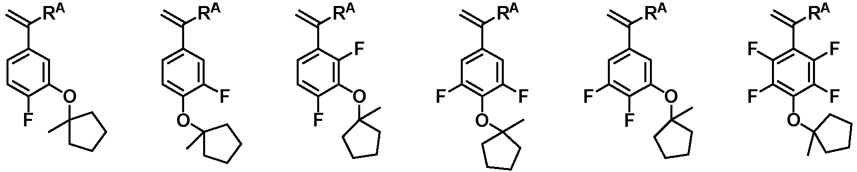

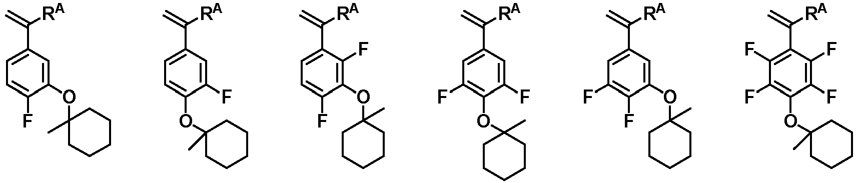

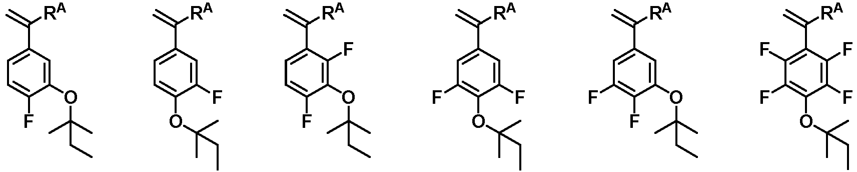

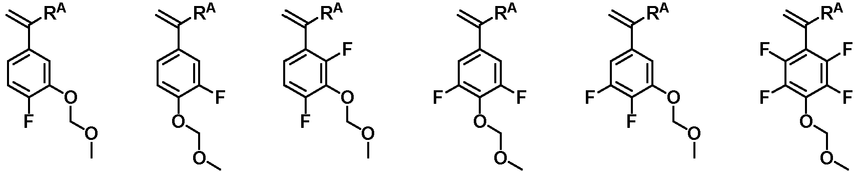

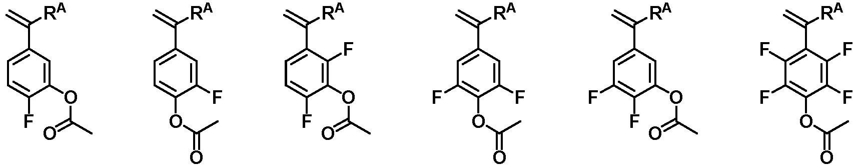

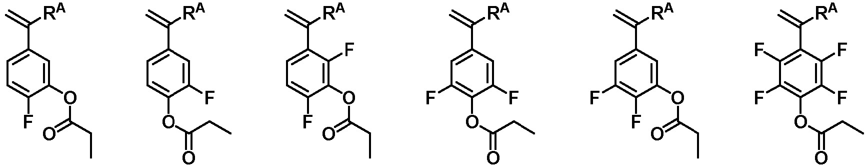

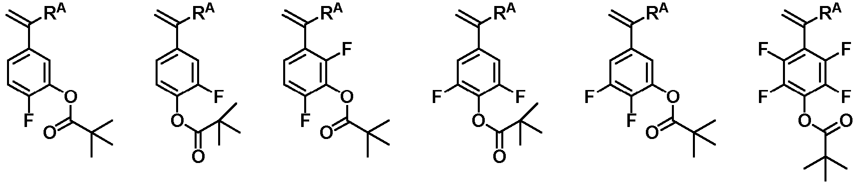

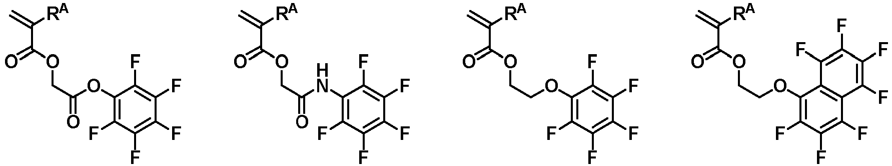

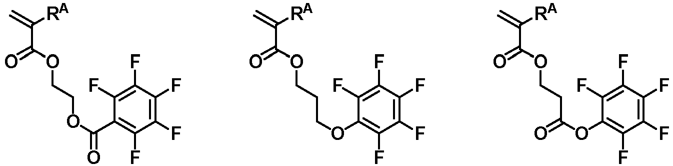

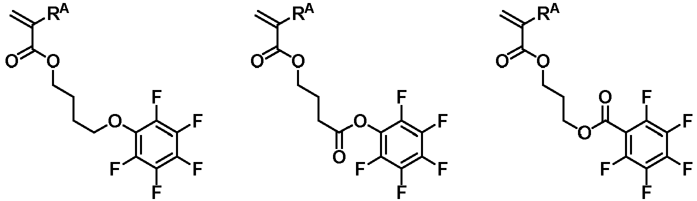

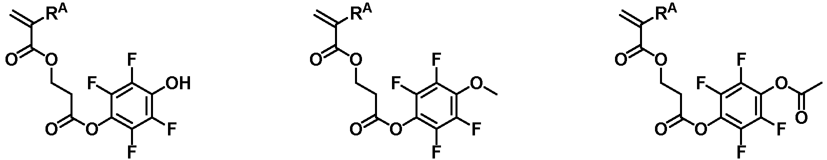

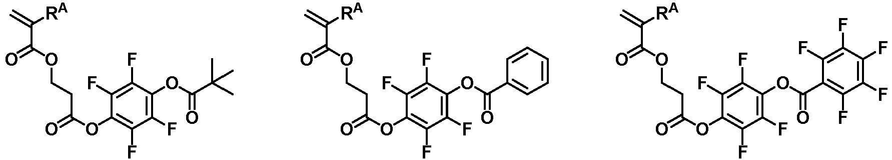

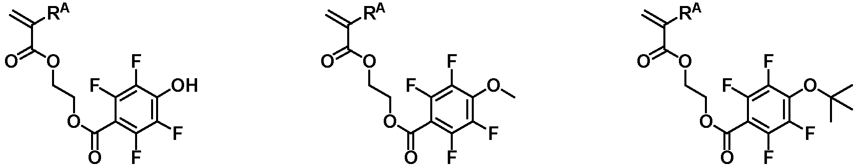

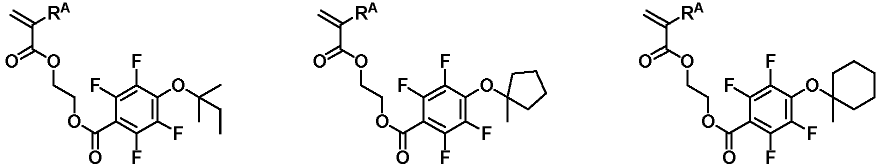

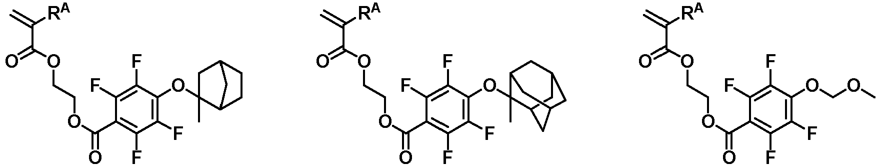

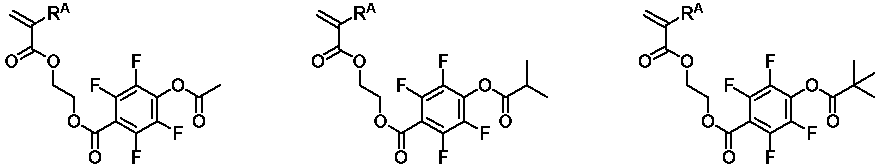

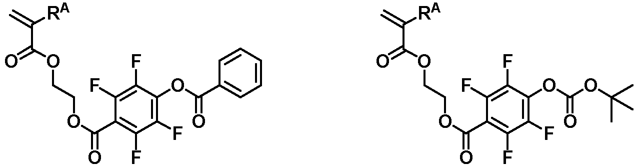

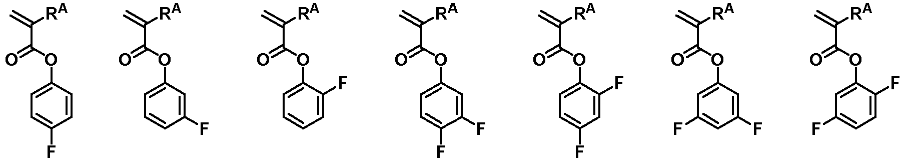

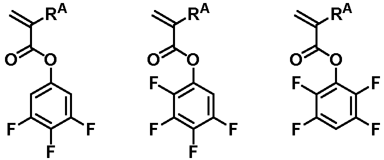

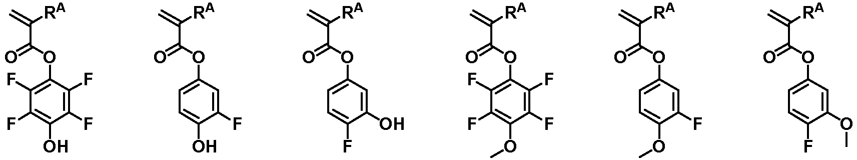

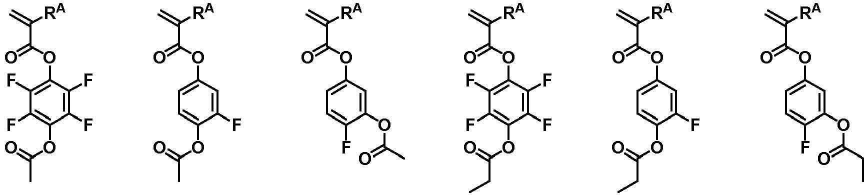

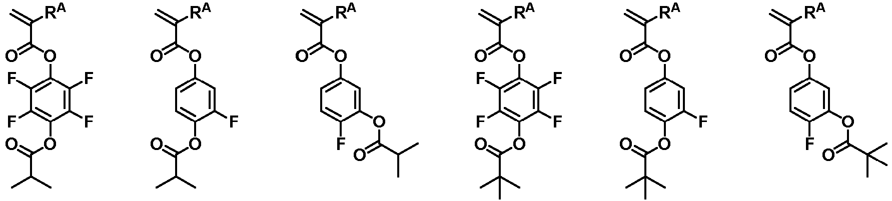

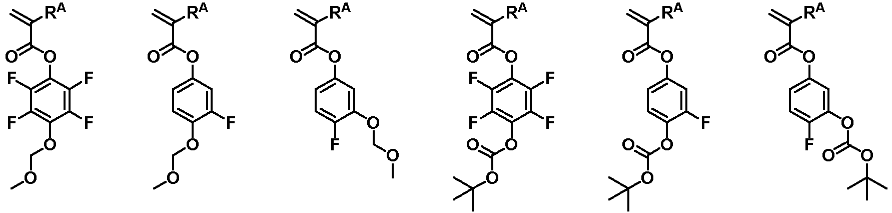

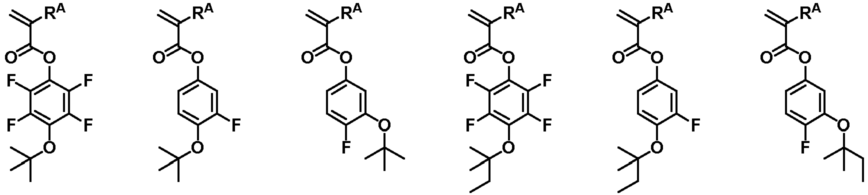

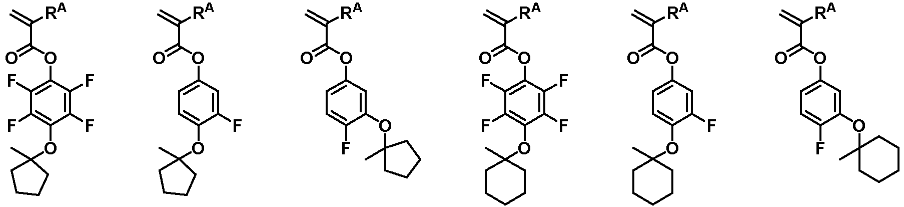

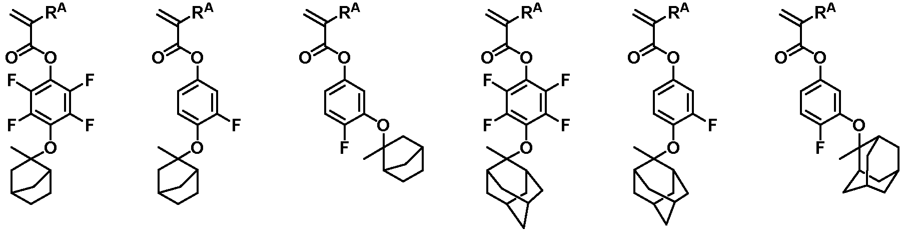

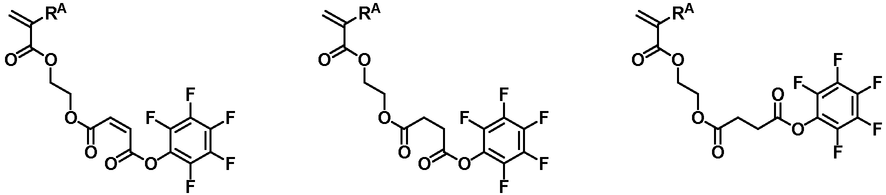

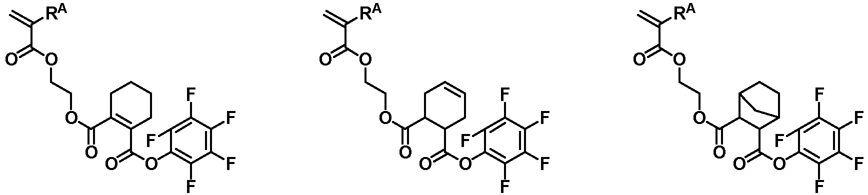

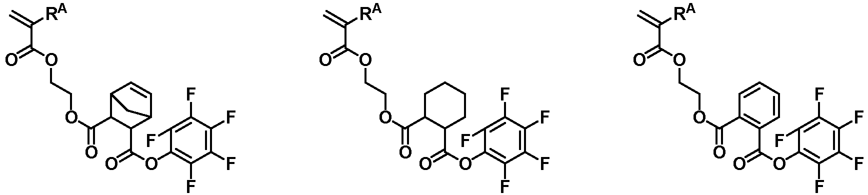

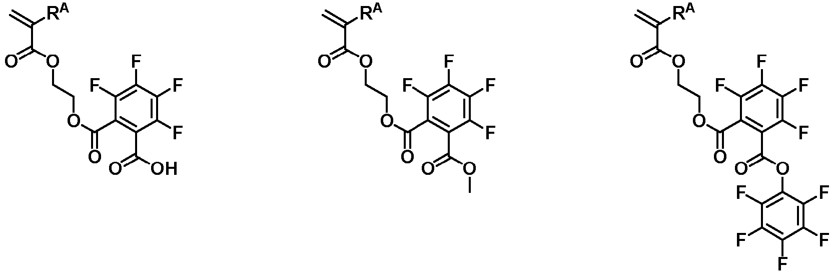

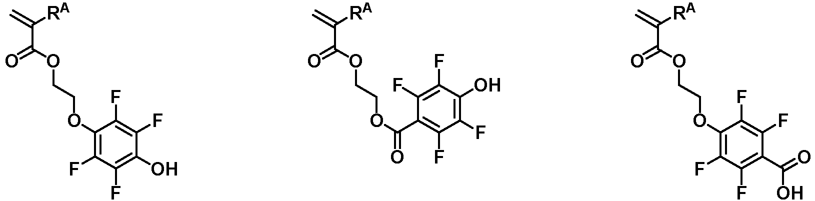

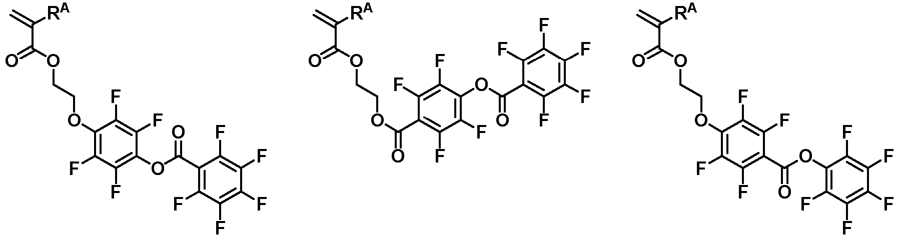

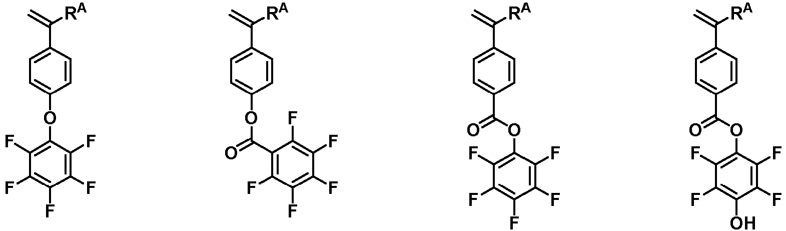

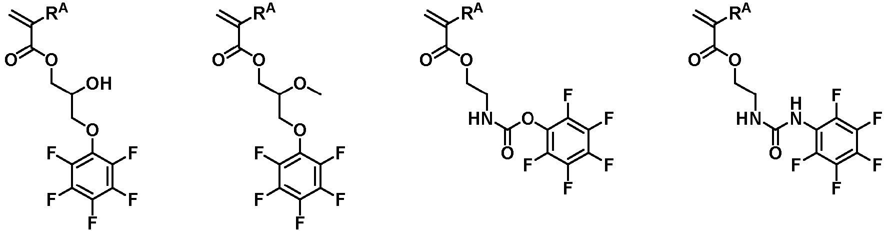

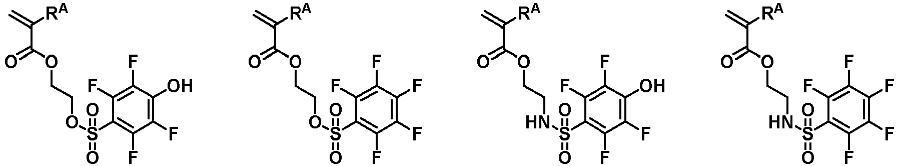

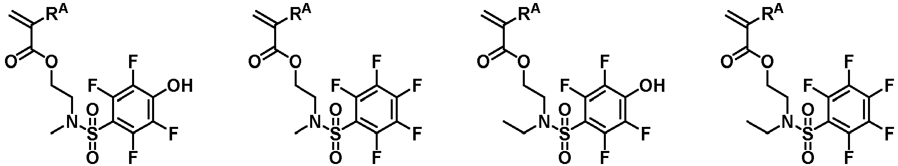

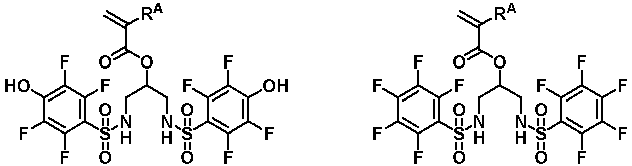

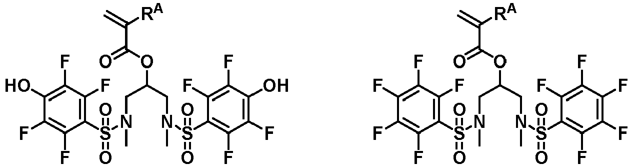

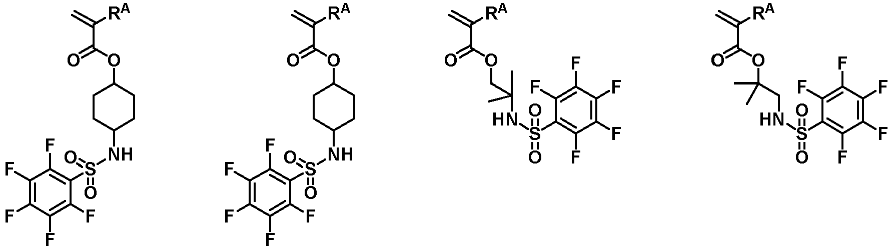

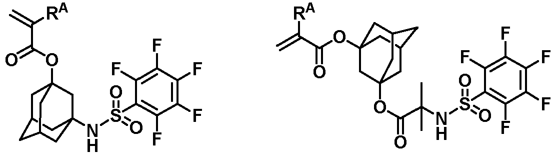

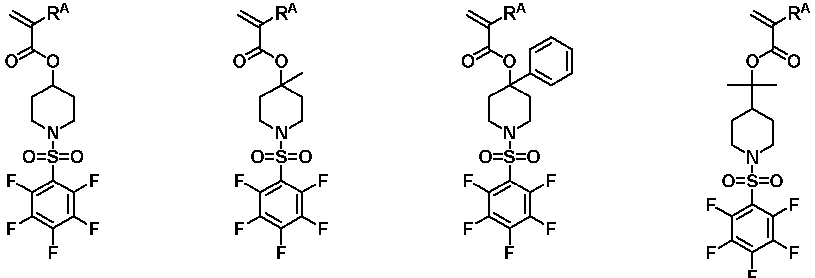

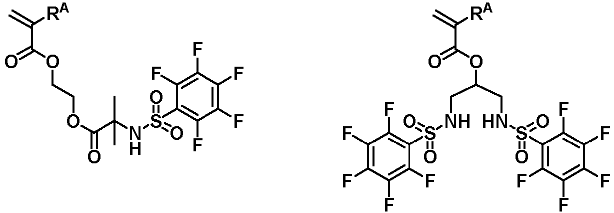

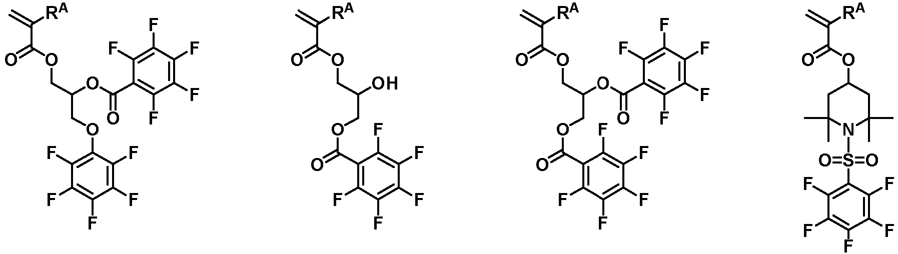

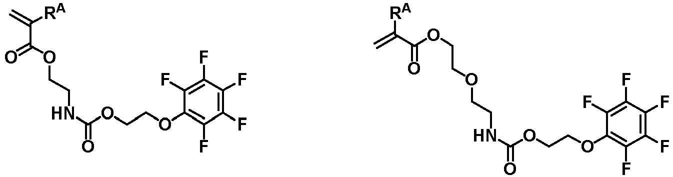

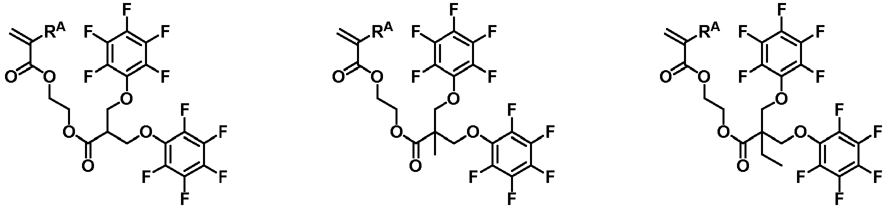

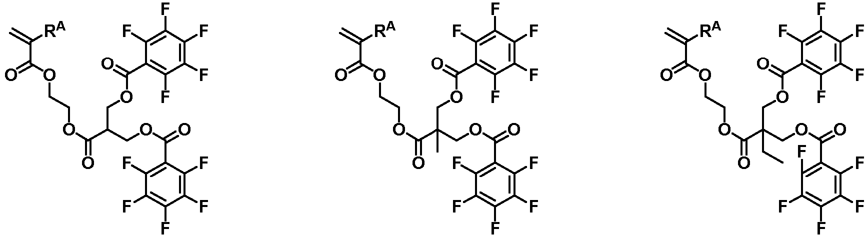

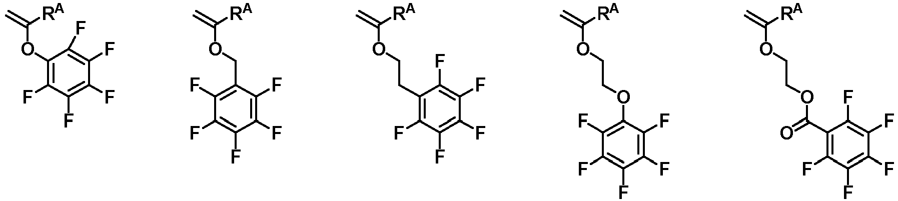

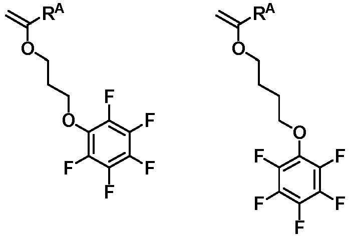

The monomer which has a trifluoromethoxy group, a difluoromethoxy group, a trifluoromethylthio group or a difluoromethylthio group and from which repeat units Sa2 are derived include those shown below, but are not limited thereto.

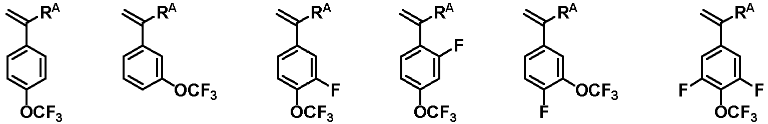

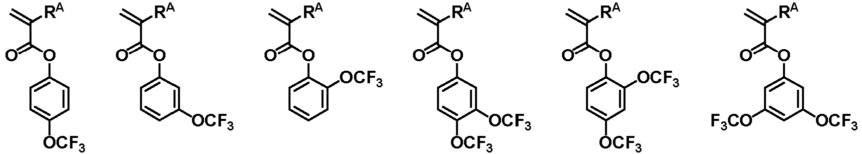

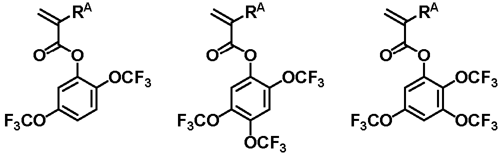

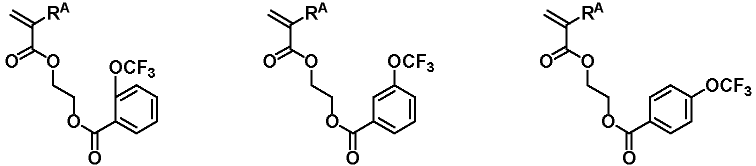

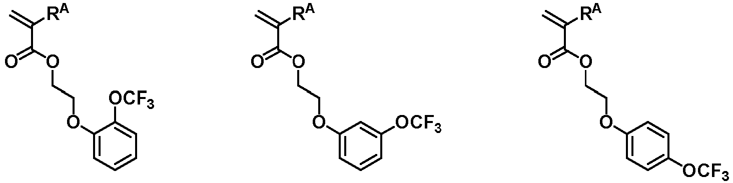

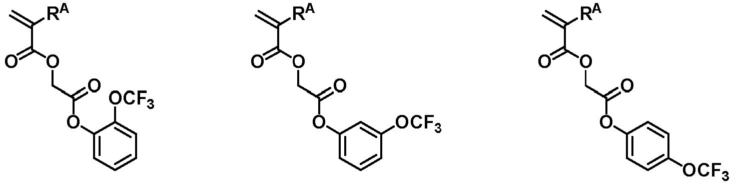

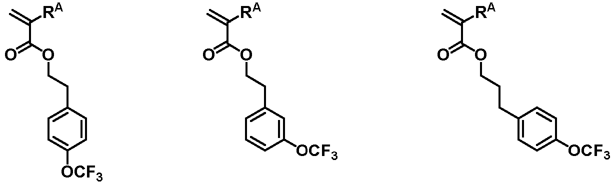

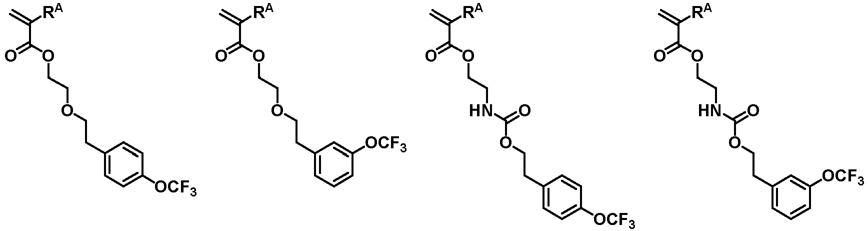

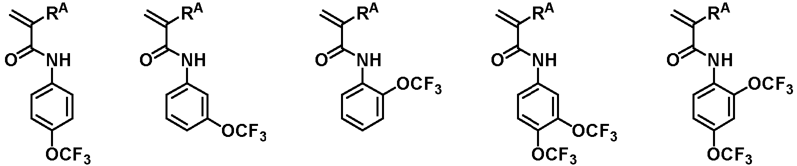

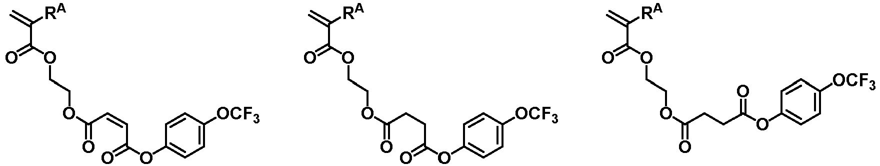

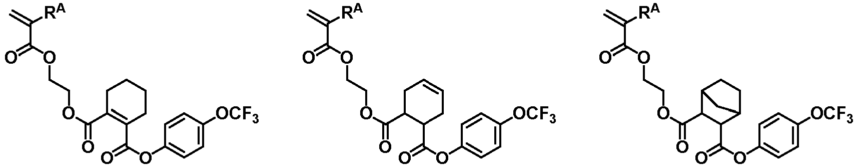

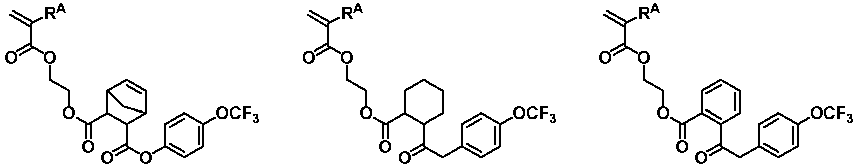

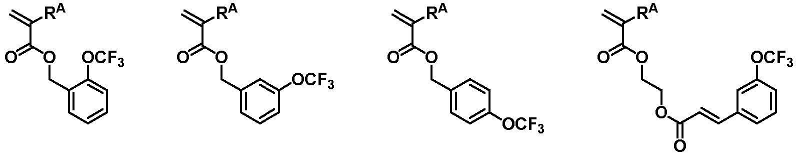

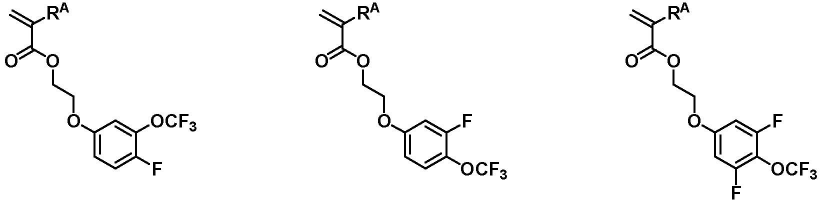

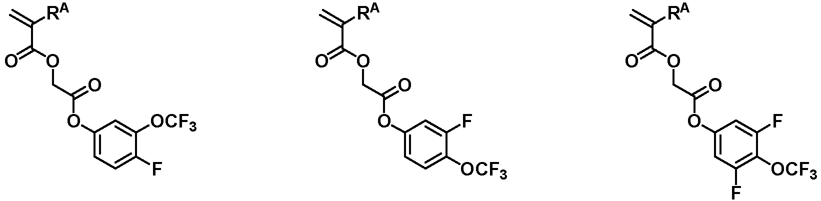

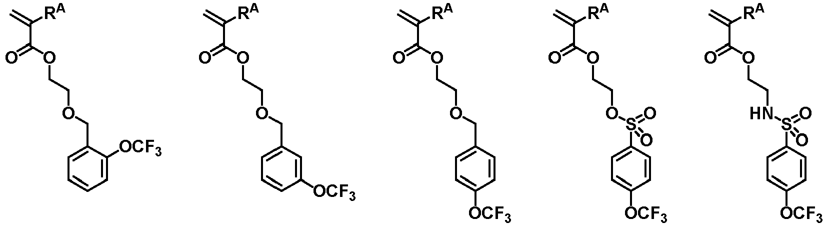

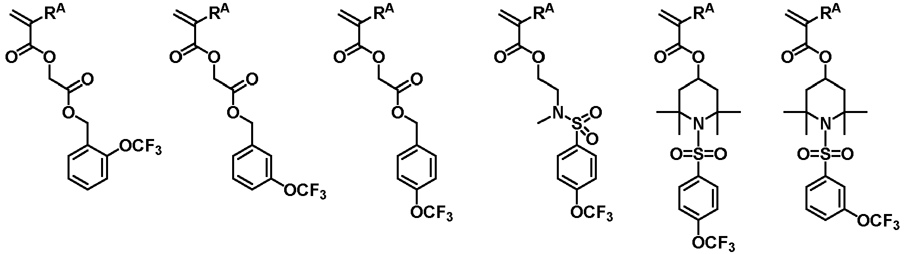

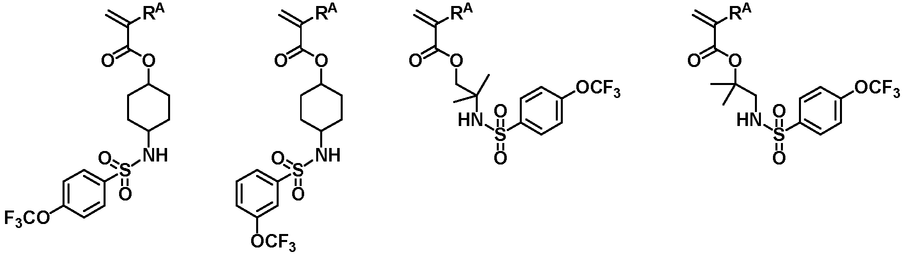

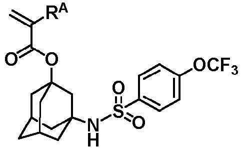

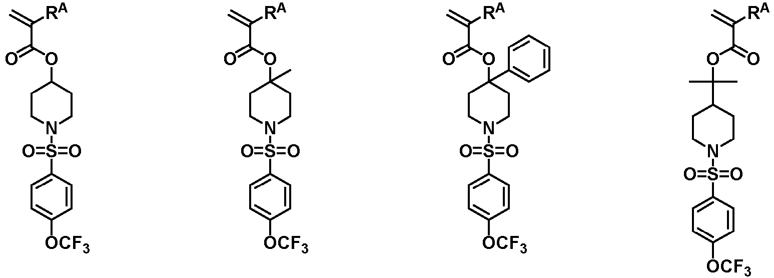

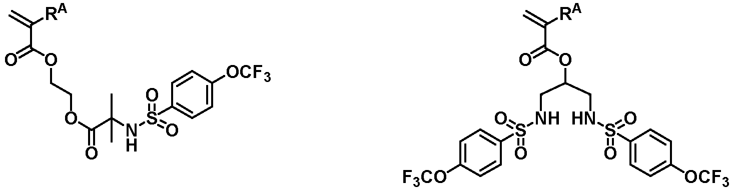

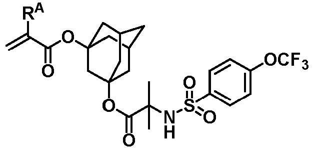

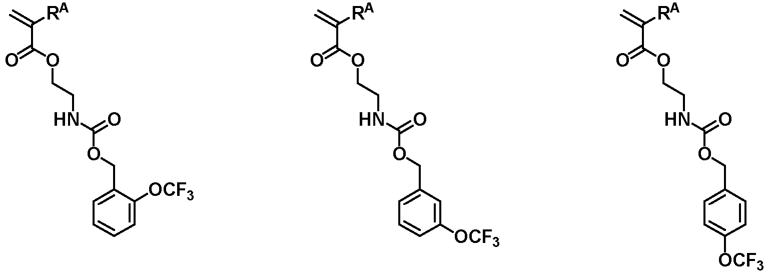

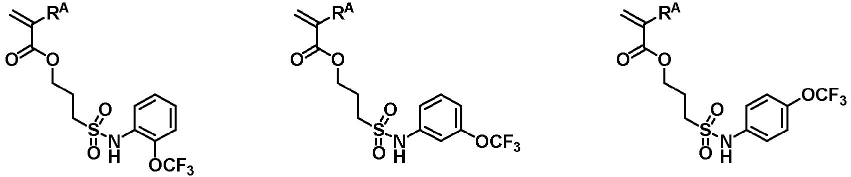

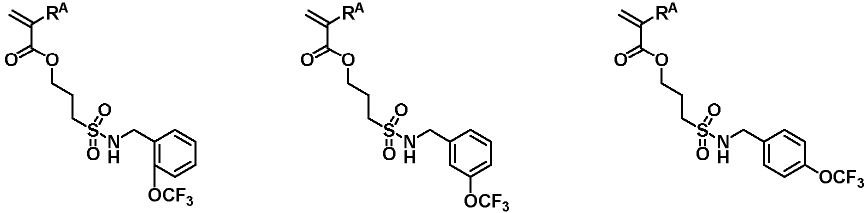

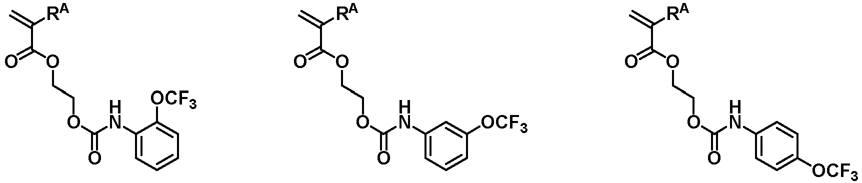

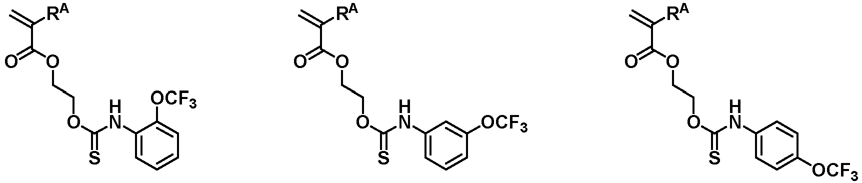

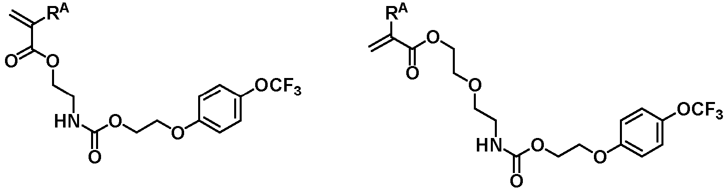

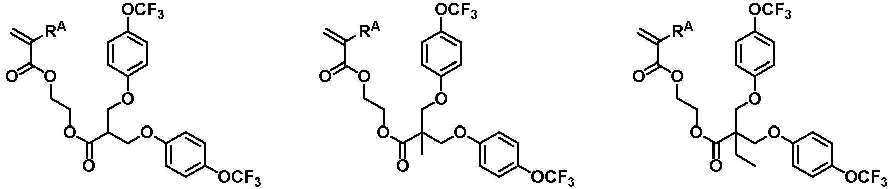

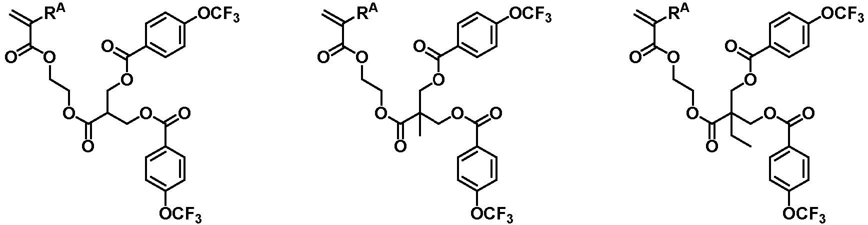

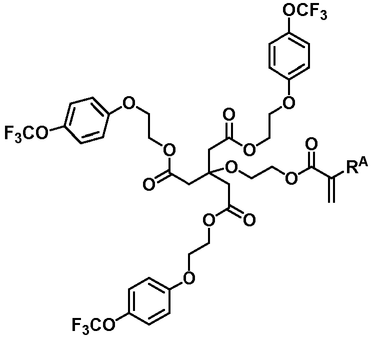

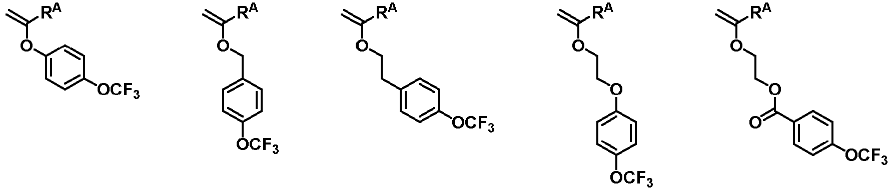

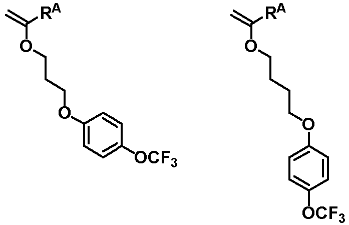

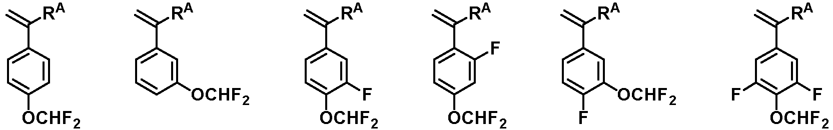

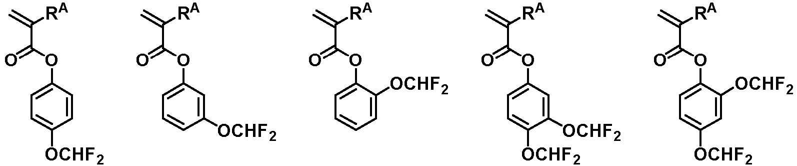

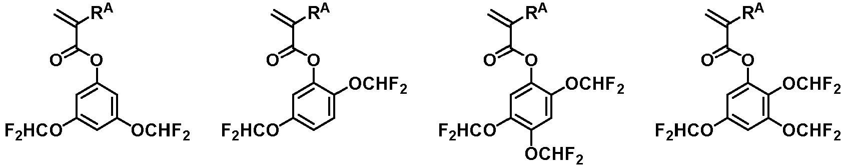

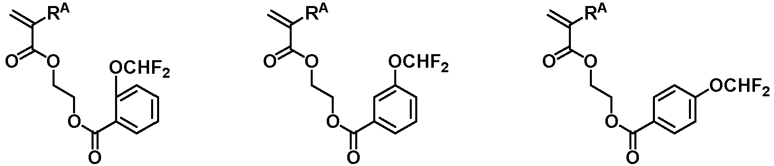

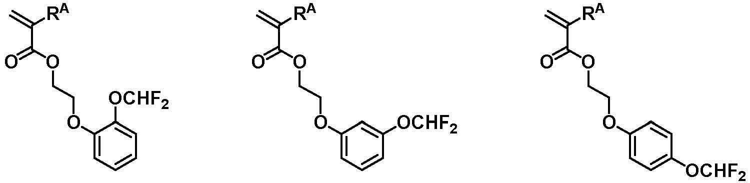

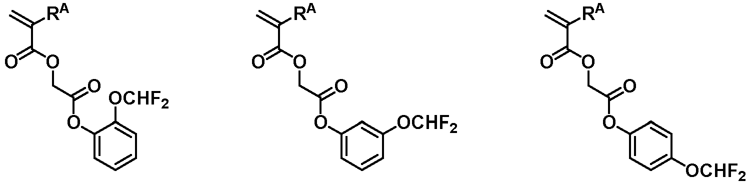

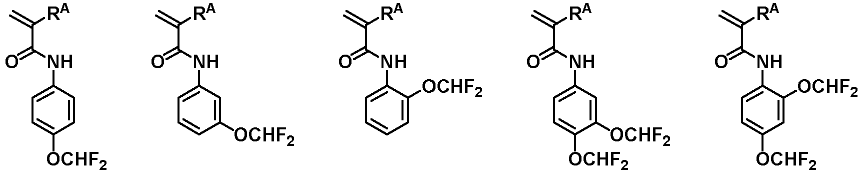

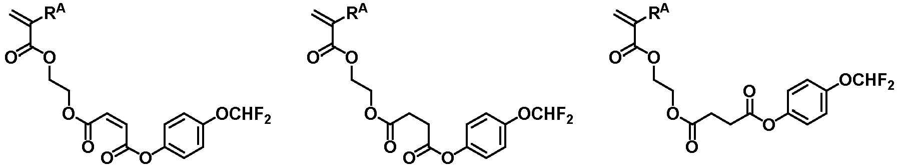

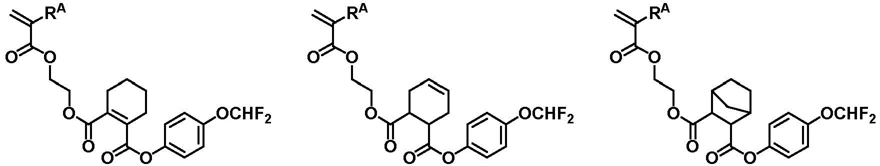

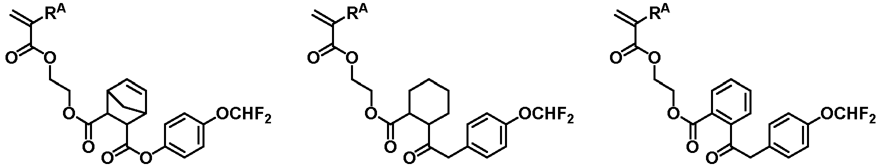

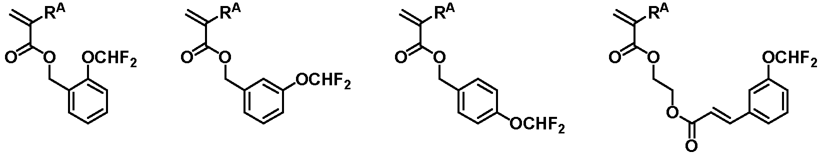

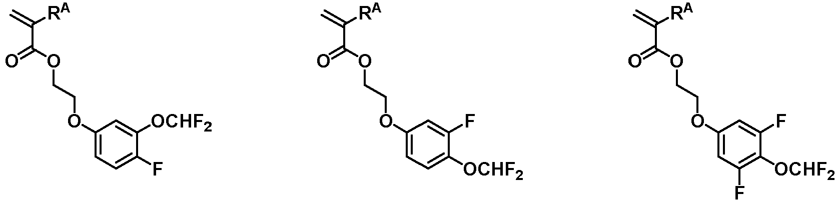

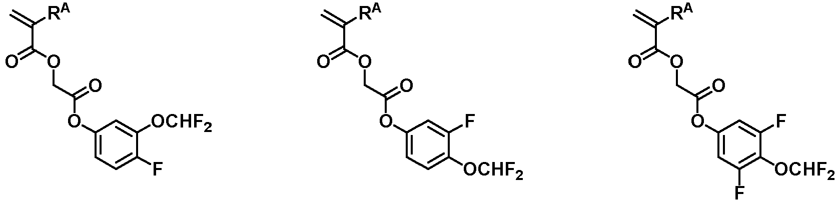

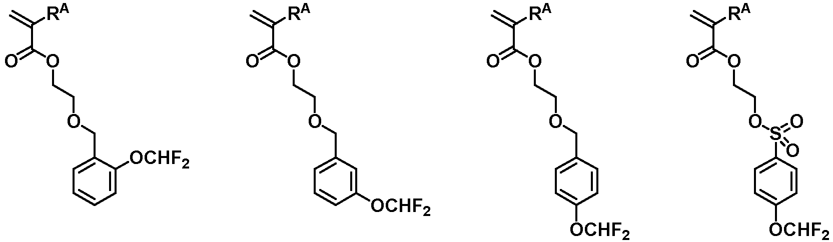

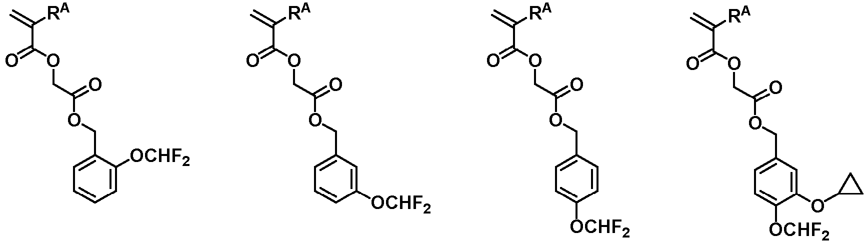

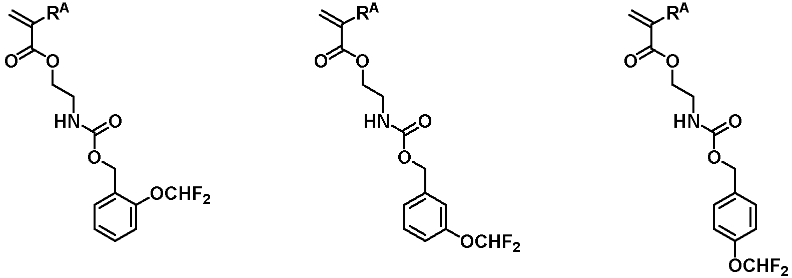

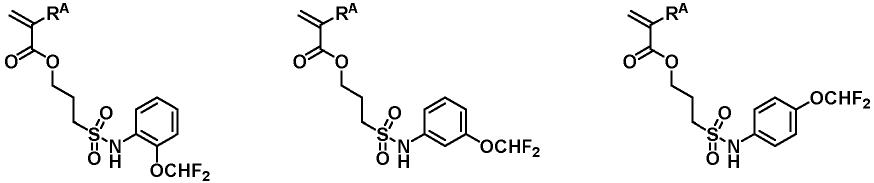

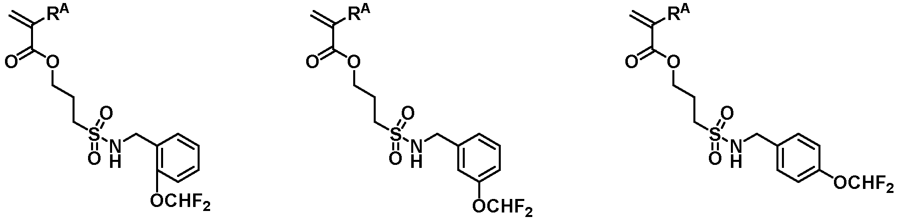

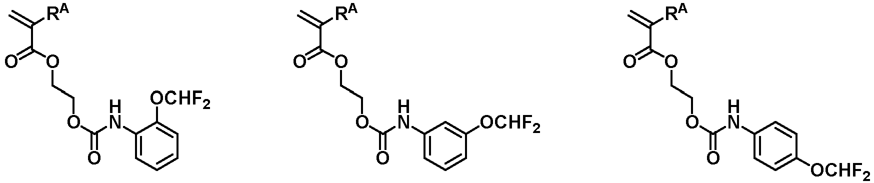

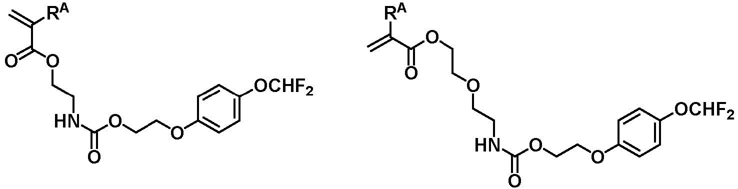

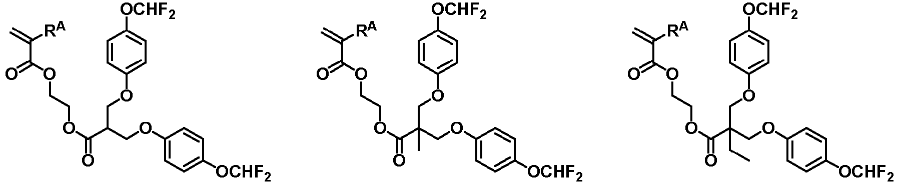

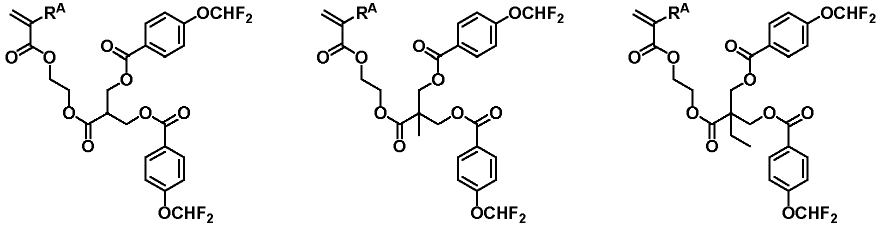

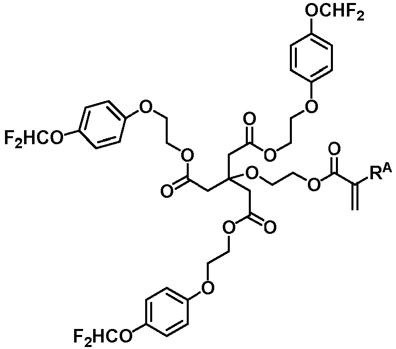

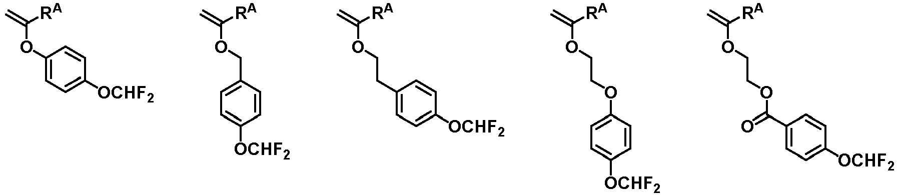

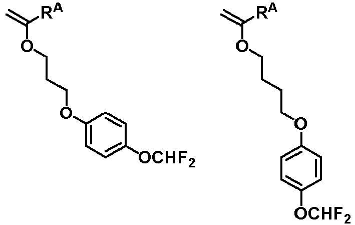

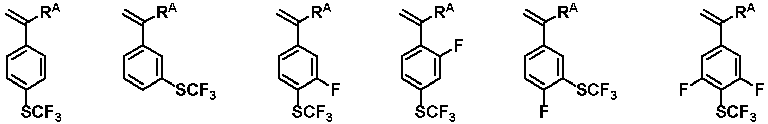

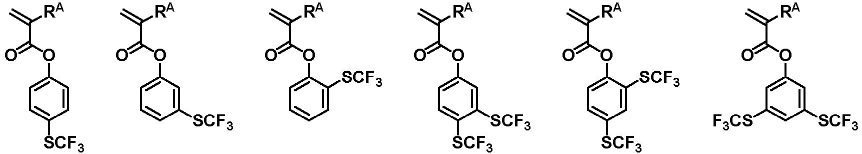

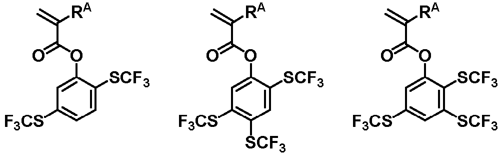

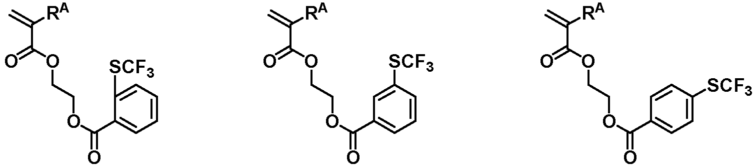

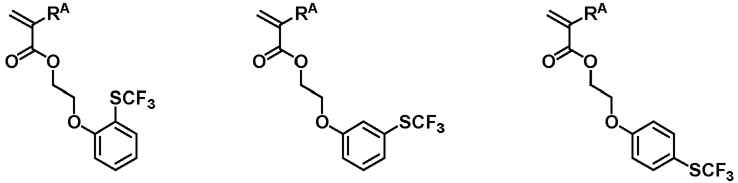

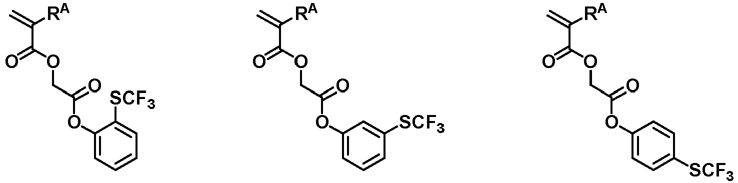

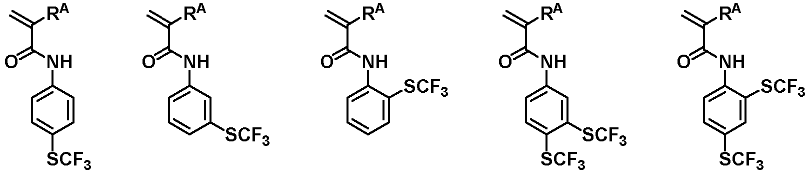

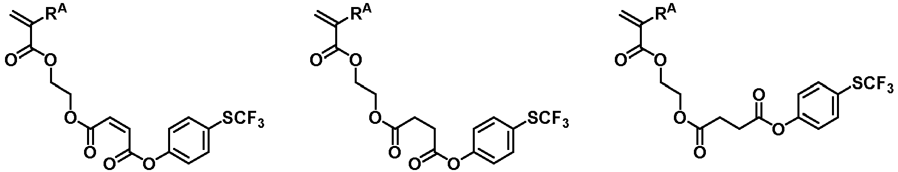

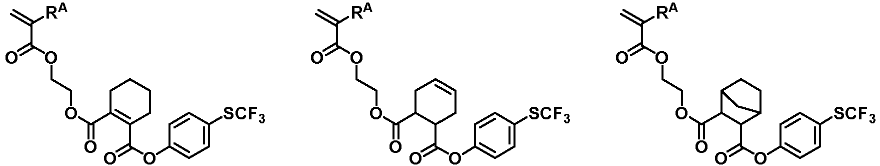

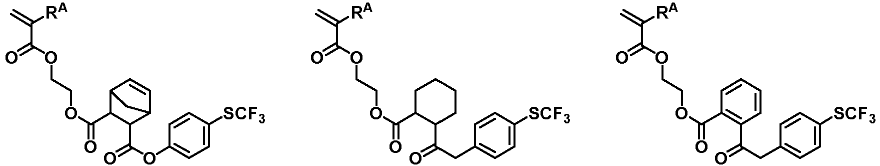

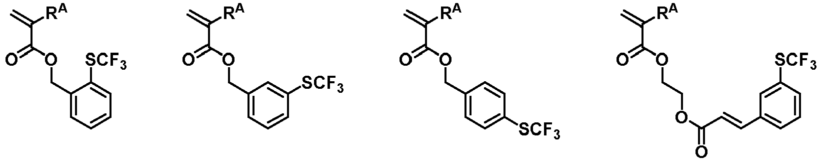

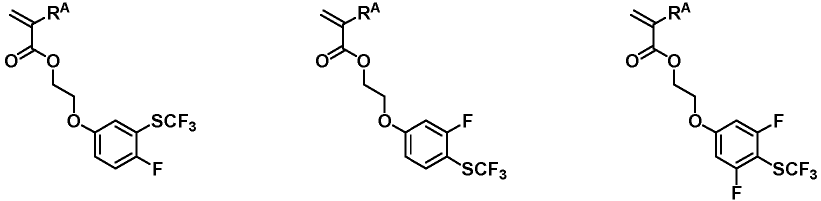

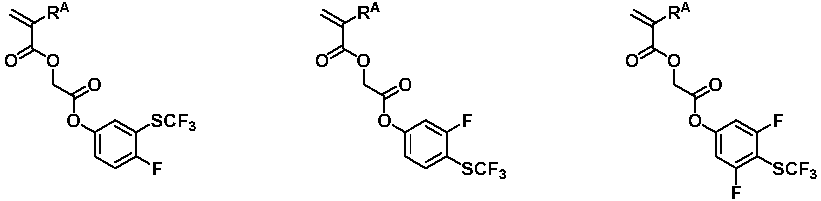

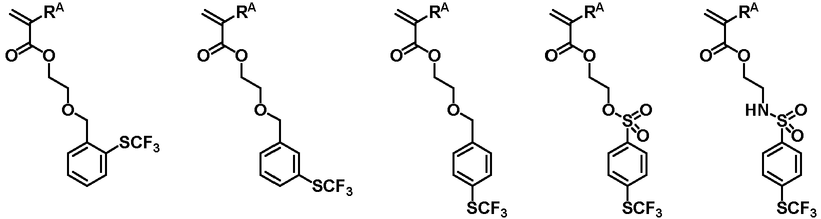

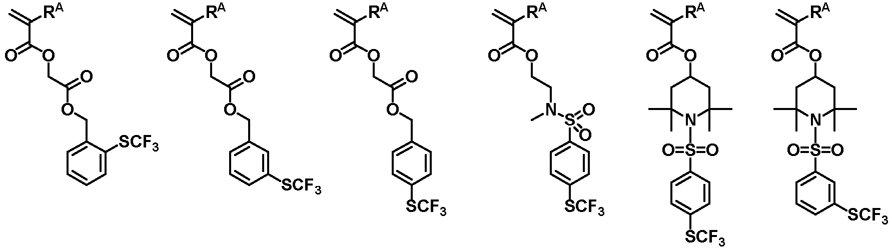

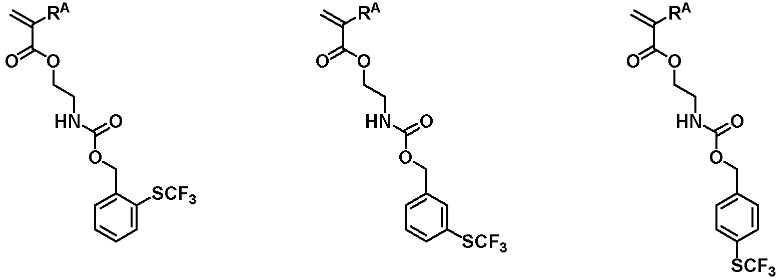

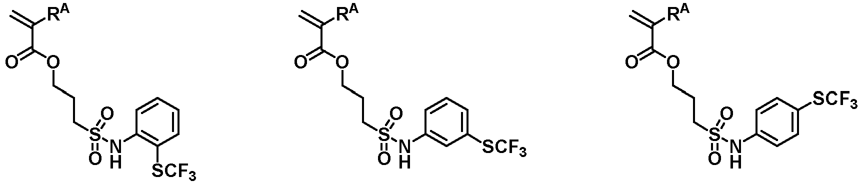

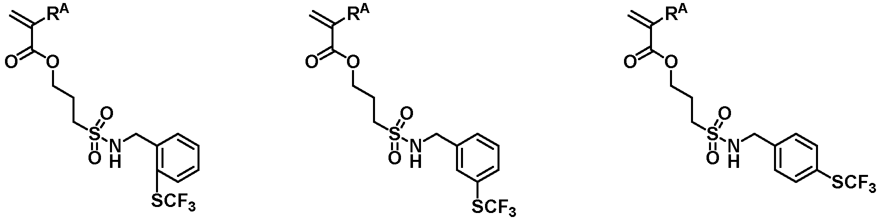

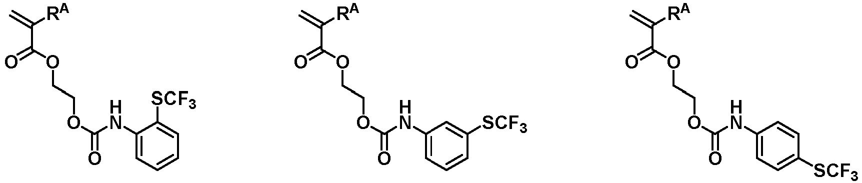

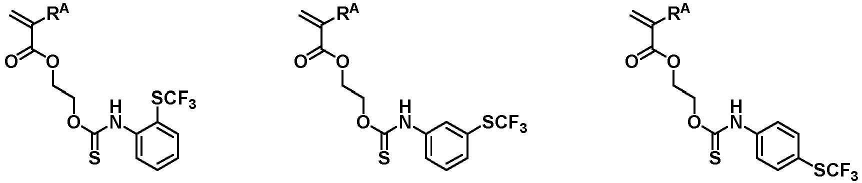

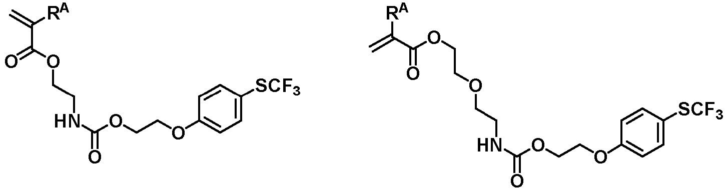

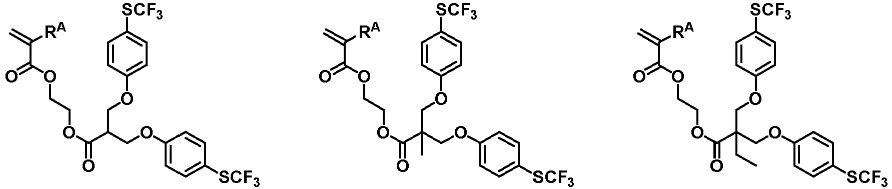

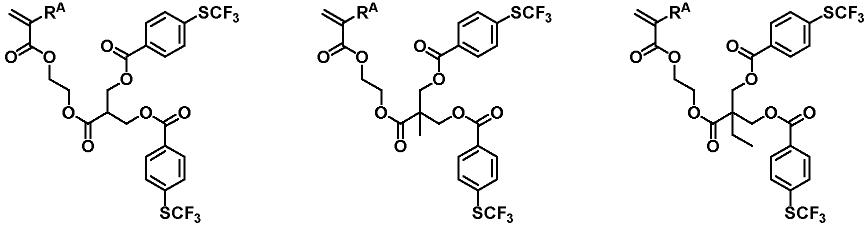

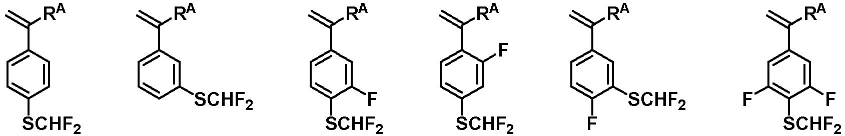

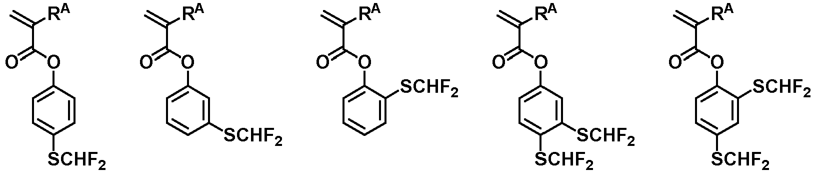

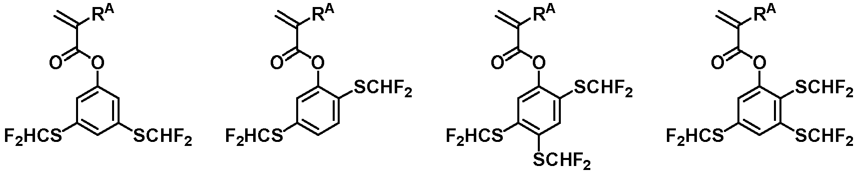

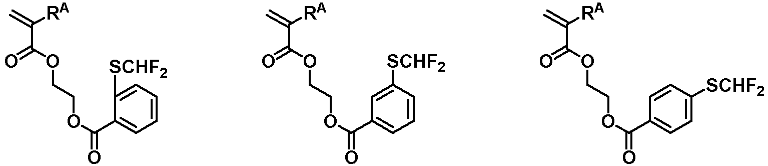

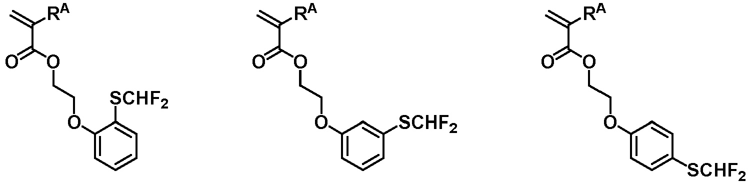

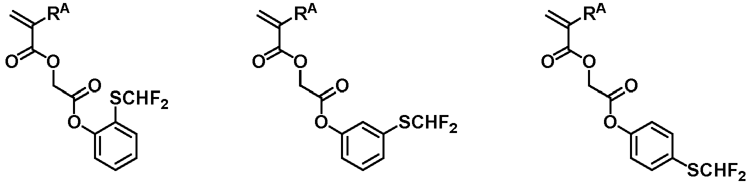

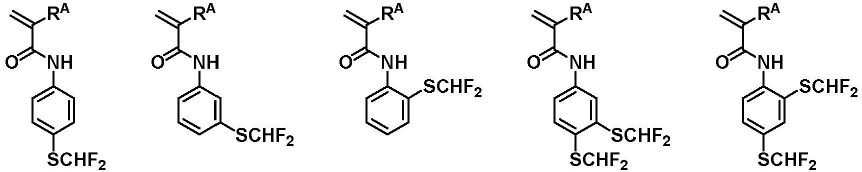

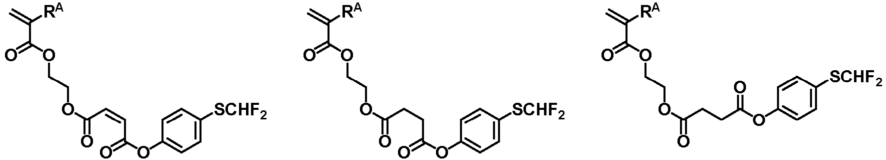

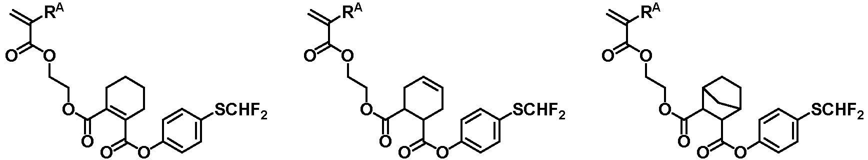

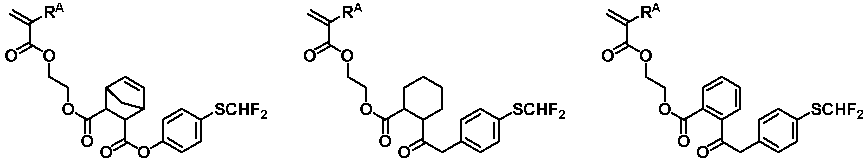

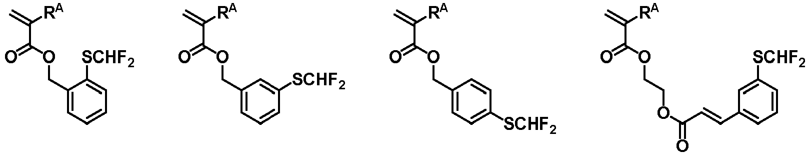

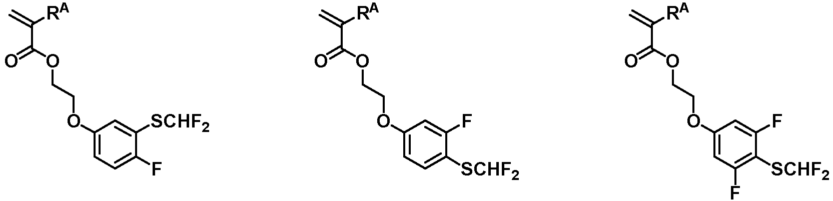

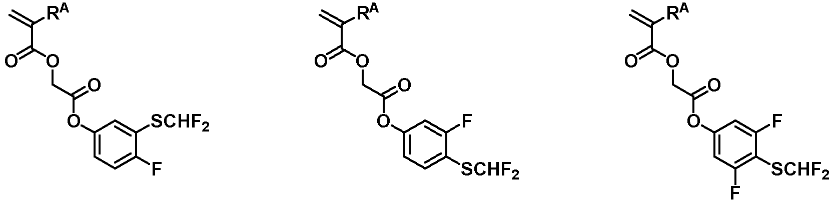

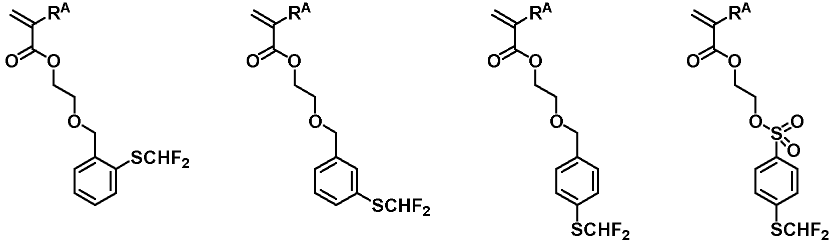

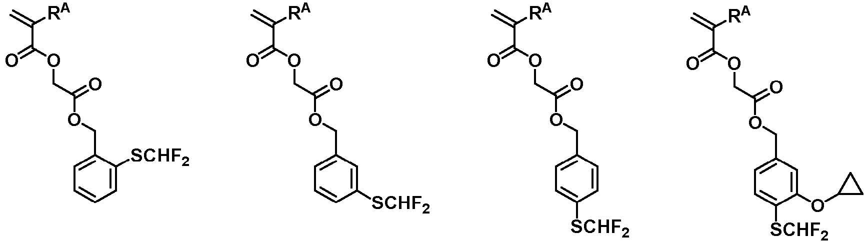

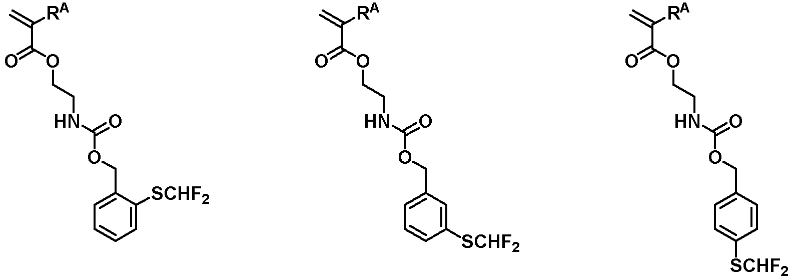

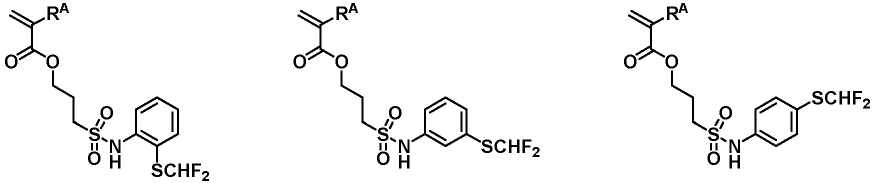

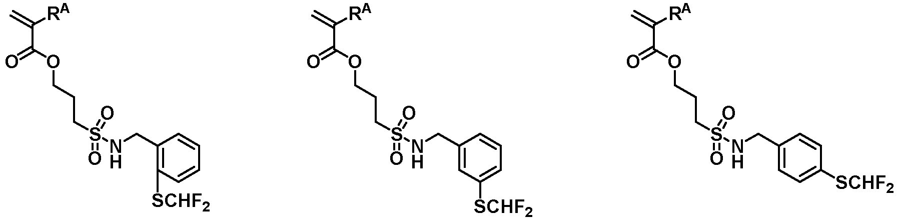

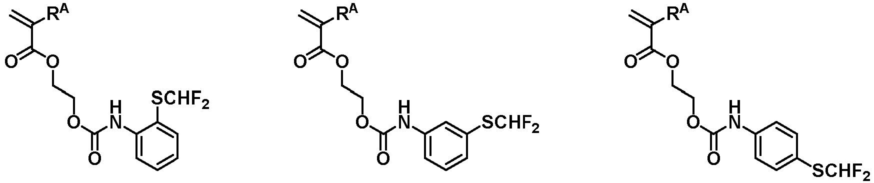

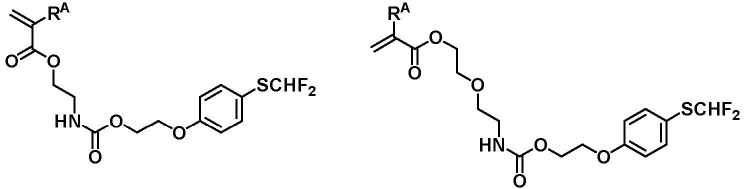

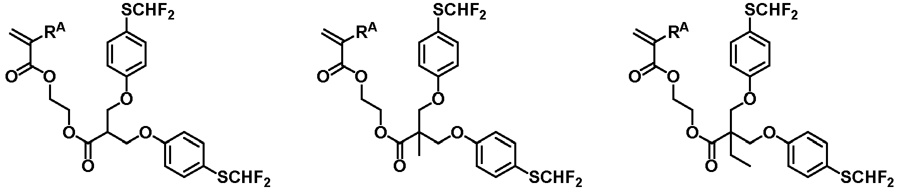

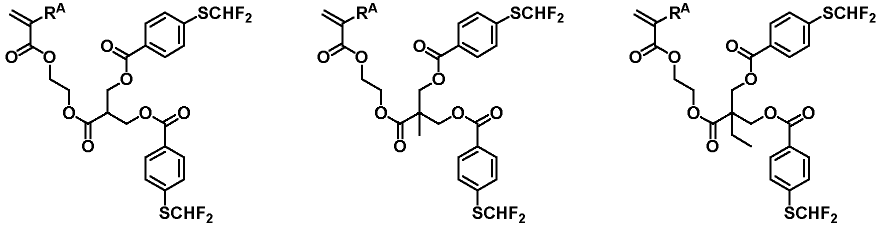

Examples of the monomer from which repeat units Sa3 are derived include those shown below, but are not limited thereto.

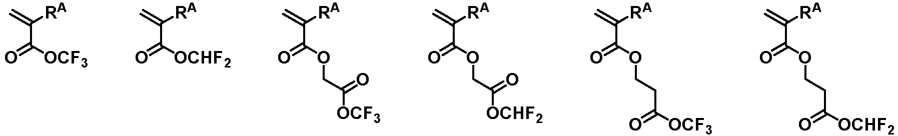

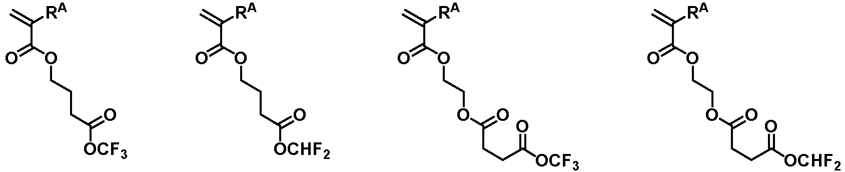

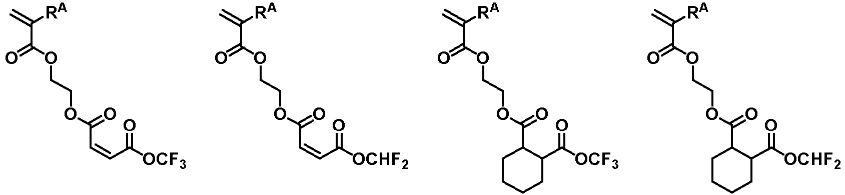

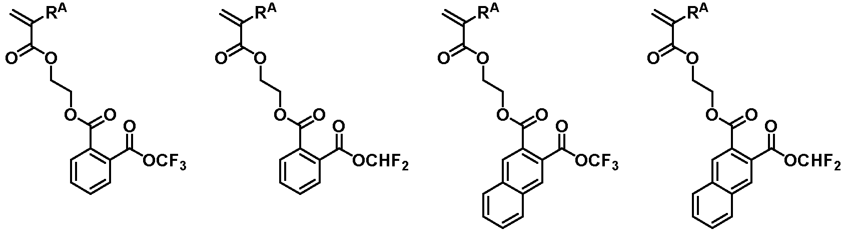

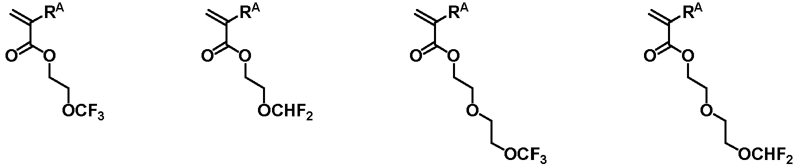

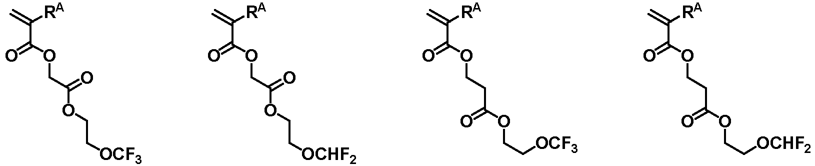

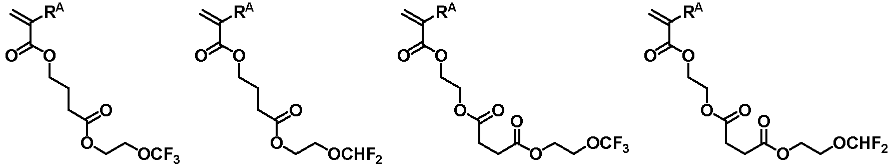

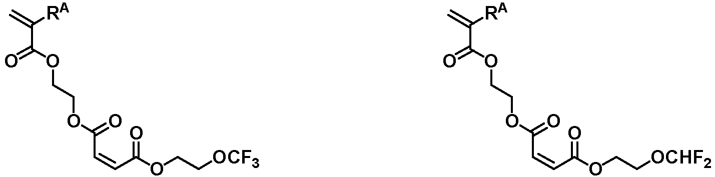

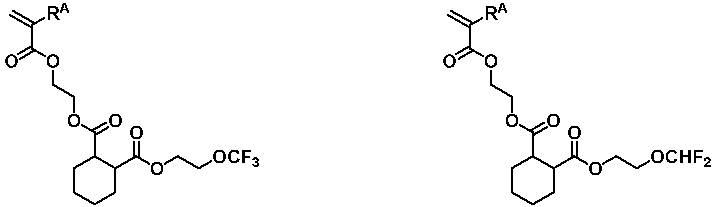

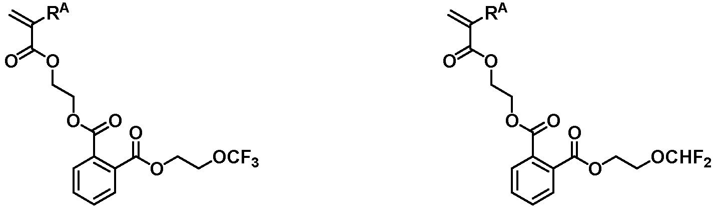

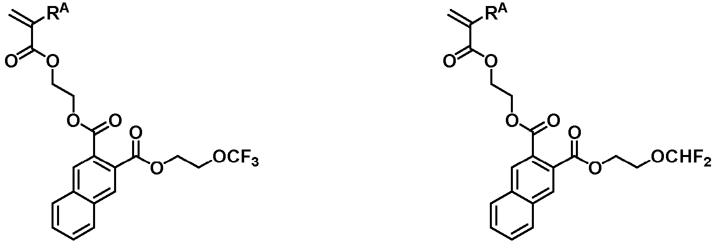

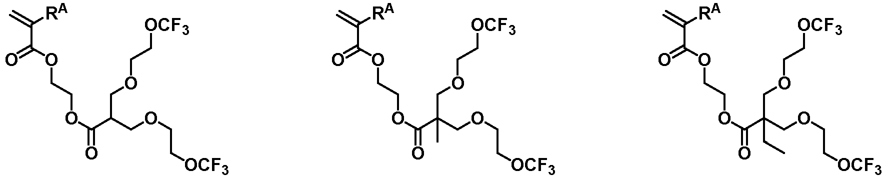

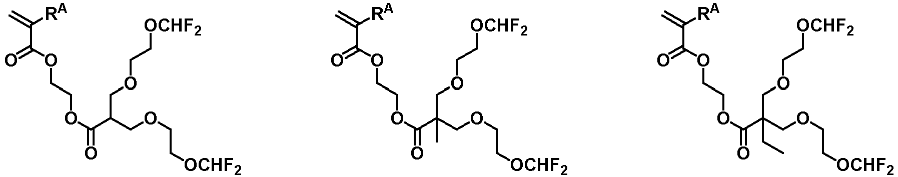

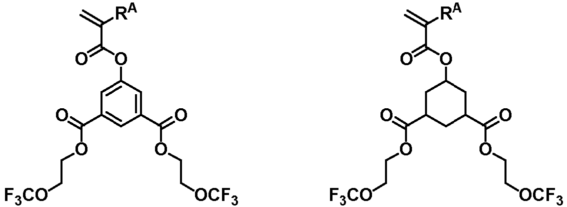

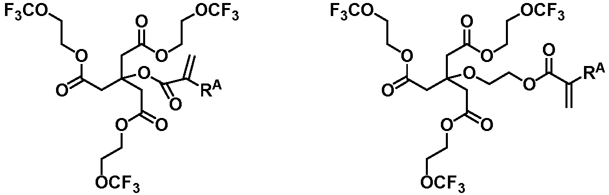

Preferably, the polymer A further contains a repeat unit having a hydrophilic group. When the polymer A contains repeat units Sa having a fluorine atom with a high water-repellent property and repeat units Sb having a hydrophilic group, a surface activating effect can be sufficiently exhibited.

The repeat units Sb have a hydrophilic group selected from an ether bond, an ester bond, a hydroxy group, a carboxy group, a sulfonamide bond, a sulfonimide bond, a sulfo group, a lactone ring, a sultone ring, a carbonate bond, a urethane bond, and an amide bond.

Specific examples of the monomer from which repeat units Sb are derived include those shown below, but are not limited thereto.

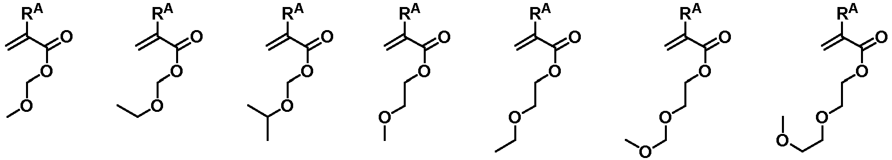

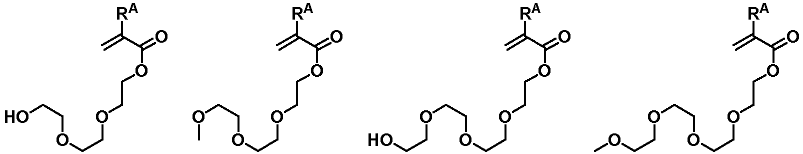

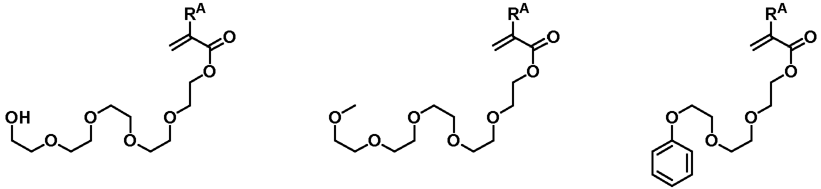

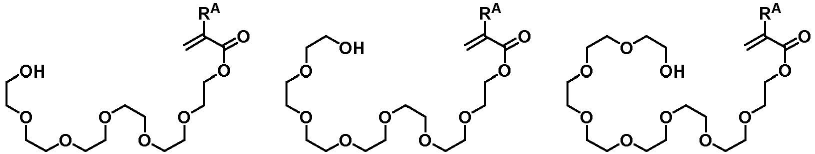

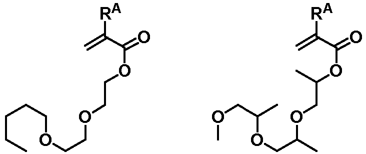

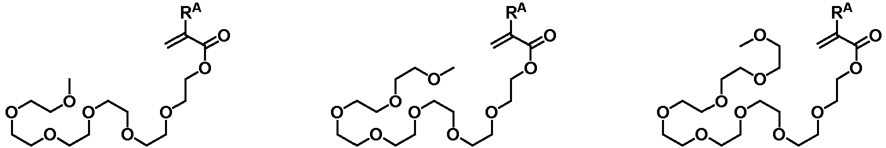

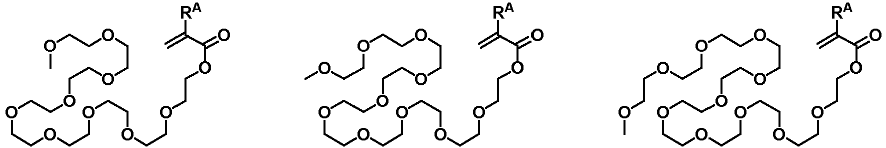

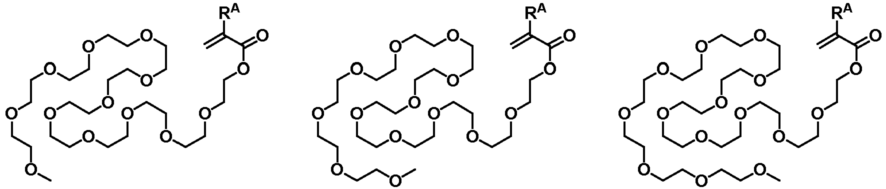

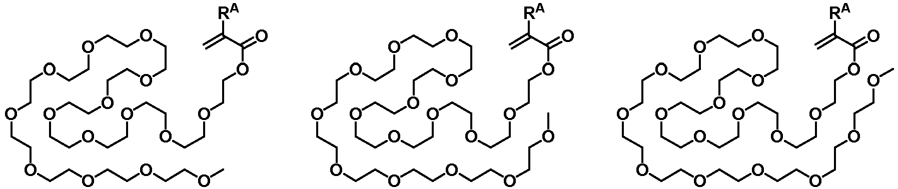

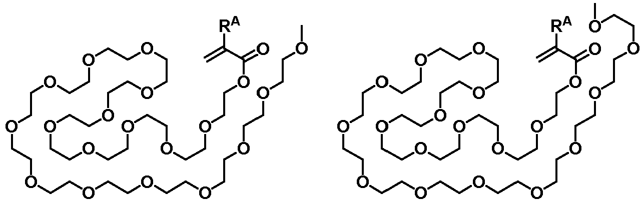

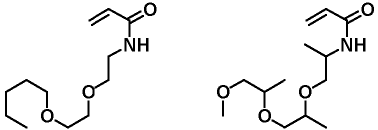

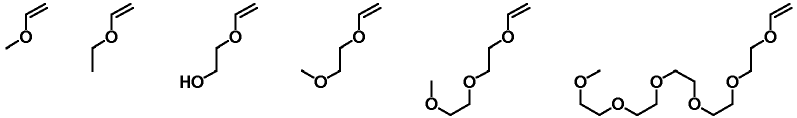

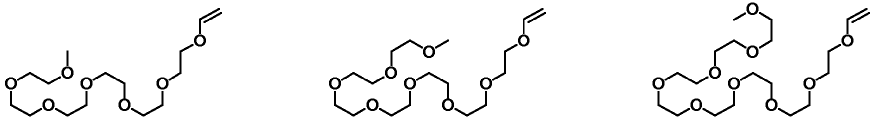

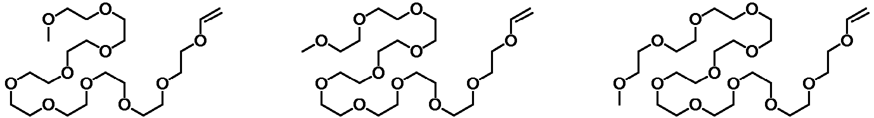

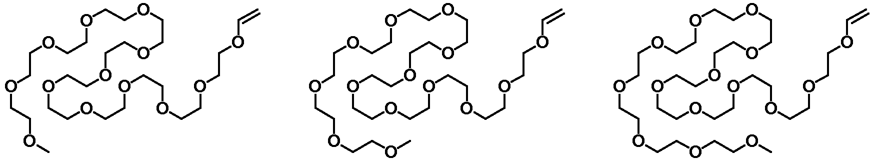

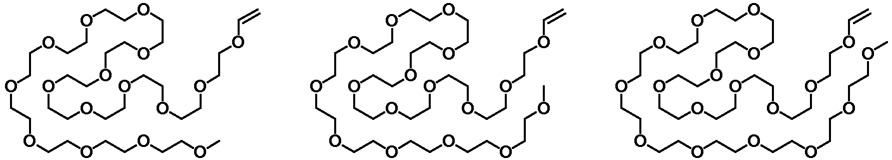

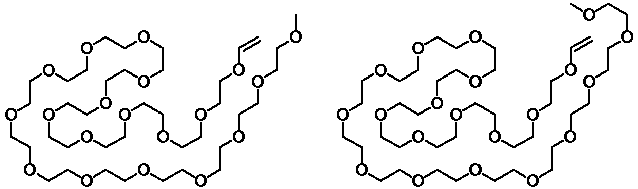

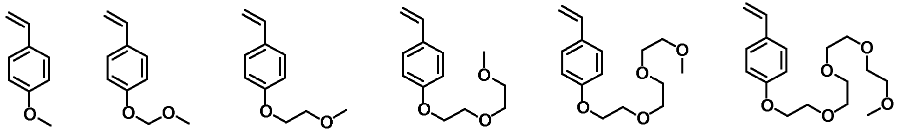

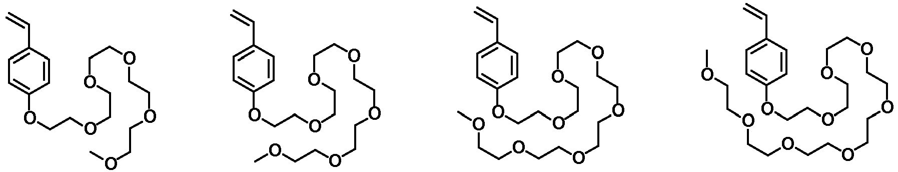

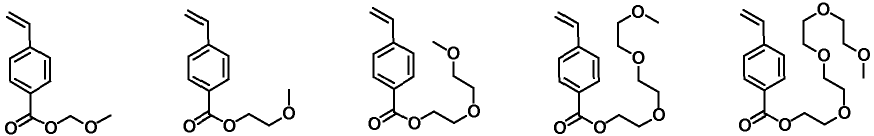

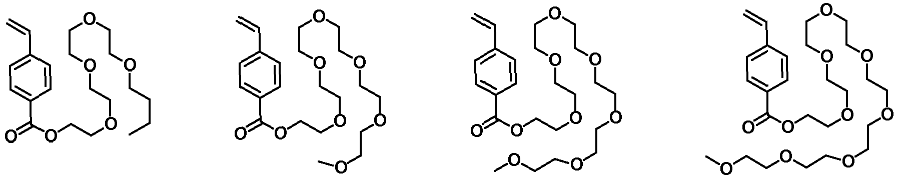

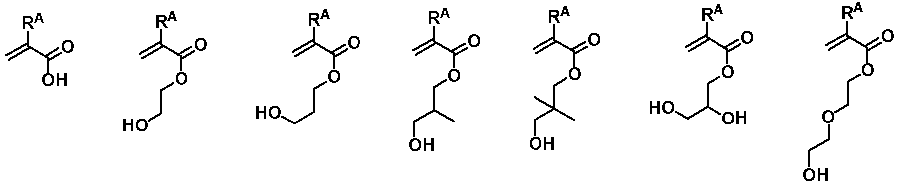

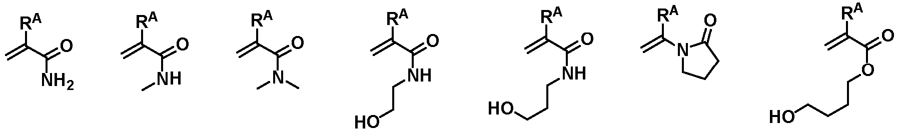

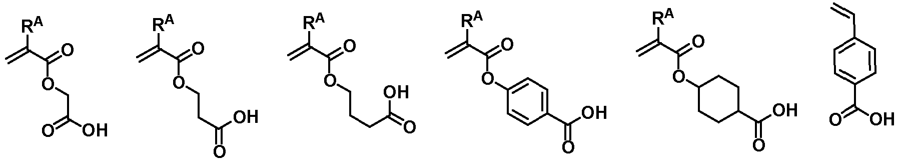

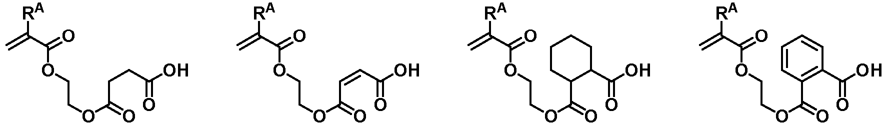

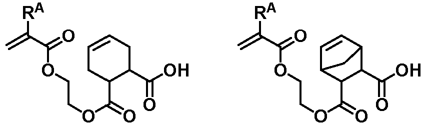

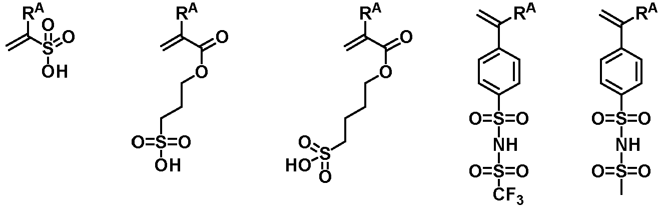

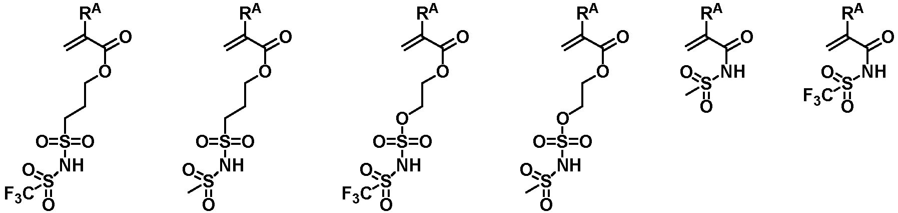

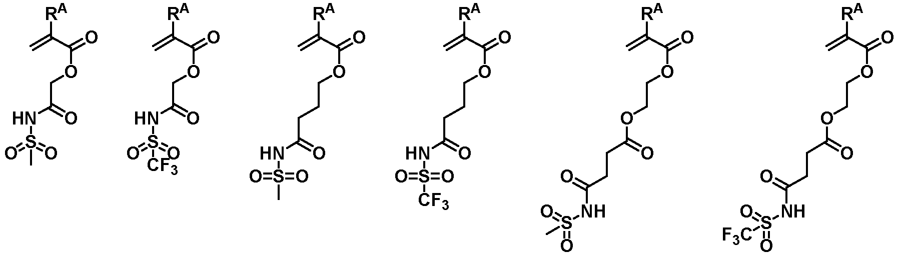

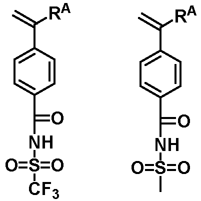

In the polymer A, the fractions of the repeat units Sa1, Sa2, Sa3 and Sb are preferably 0 ≤ Sa1 < 1.0, 0 ≤ Sa2 < 1.0, 0 ≤ Sa3 < 1.0, 0 < Sa1 + Sa2 + Sa3 < 1.0, and 0 < Sb < 1.0, more preferably 0 ≤ Sa1 ≤ 0.9, 0 ≤ Sa2 ≤ 0.9, 0 ≤ Sa3 ≤ 0.9, 0.1 ≤ Sa1 + Sa2 + Sa3 ≤ 0.9, and 0.1 ≤ Sb ≤ 0.9, and even more preferably 0 ≤ Sa1 ≤ 0.8, 0 ≤ Sa2 ≤ 0.8, 0 ≤ Sa3 ≤ 0.8, 0.2 ≤ Sa1 + Sa2 + Sa3 ≤ 0.8, and 0.2 ≤ Sb ≤ 0.8. Note that Sa1 + Sa2 + Sa3 + Sb = 1.0.

The polymer A preferably has a weight average molecular weight (Mw) in the range of 1,000 to 500,000, and more preferably 2,000 to 30,000, as measured by gel permeation chromatography (GPC) versus polystyrene standards using a THF solvent. If the polymer A has a wide molecular weight distribution or dispersity (Mw/Mn), which indicates the presence of lower and higher molecular weight polymer fractions, there is a possibility that foreign matter is left on the pattern or the pattern profile is degraded. The influences of Mw and Mw/Mn tend to be stronger as the pattern rule becomes finer. Therefore, the polymer A should preferably have a narrow dispersity (Mw/Mn) of 1.0 to 2.0, especially 1.0 to 1.5, in order to provide a resist composition suitable for micropatterning to a small feature size.

The polymer A may be a blend of two or more polymers which differ in compositional ratio, Mw or Mw/Mn. Polymers containing different repeat units Sa1, Sa2 and Sb may be blended.

The polymer A can be obtained by polymerizing a monomer from which repeat units selected from repeat units Sa1, Sa2, Sa3 and Sb by a method such as radical polymerization, anionic polymerization or cationic polymerization.

When the polymer A contains two or more types of repeat units, it may be a random copolymer or a block copolymer, but a block copolymer has a higher effect as a surfactant. In particular, the polymer A is preferably a block copolymer containing repeat units Sa and Sb. The block copolymer may be a diblock copolymer including two units, a triblock copolymer including three units, or a tetrablock copolymer including four units.

When random copolymerization is performed by radical polymerization, monomers to be copolymerized and a radical initiator are typically mixed and heated to perform polymerization. A polymer molecule obtained by initially polymerizing a first monomer in the presence of a radical initiator and then adding a second monomer has a block formed by polymerization of the first monomer on one side and a block formed by polymerization of the second monomer on the other side. However, in this case, repeat units derived from the first monomer and the second monomer coexist in the intermediate portion, and this configuration is different from that of a block copolymer. For forming a block copolymer by radical polymerization, living radical polymerization is preferably used. In a living radical polymerization method called reversible addition fragmentation chain transfer (RAFT) polymerization, radicals at polymer ends are always available, and therefore a block copolymer including first repeat units and second repeat units can be formed by initially polymerizing the first monomer, and adding the second monomer once the first monomer is consumed. When the first monomer is initially polymerized, the second monomer is added once the first monomer is consumed, and a third monomer is then added, a triblock copolymer can be formed. There is also a characteristic that a narrow-dispersity polymer having a narrow dispersity is formed when RAFT polymerization is performed.

Examples of the organic solvent used in the polymerization include toluene, benzene, tetrahydrofuran (THF), diethyl ether, and dioxane. Examples of the polymerization initiator include 2,2'-azobisisobutyronitrile (AIBN), 2,2'-azobis(2,4-dimethylvaleronitrile), dimethyl-2,2-azobis(2-methylpropionate), benzoyl peroxide, and lauroyl peroxide. The temperature during polymerization is preferably 50 to 80°C. The reaction time is preferably 2 to 100 hours, and more preferably 5 to 20 hours.

A chain transfer agent is required to perform RAFT polymerization, and specific examples thereof include 2-cyano-2-propyl benzothioate, 4-cyano-4-phenylcarbonothioylthiopentanoic acid, 2-cyano-2-propyldodecyl trithiocarbonate, 4-cyano-4-[(dodecylsulfanylthiocarbonyl)sulfanyl]pentanoic acid, 2-(dodecylthiocarbonothioylthio)-2-methylpropanoic acid, cyanomethyl dodecylthiocarbonate, cyanomethyl N-methyl-N-phenyl carbamothioate, bis(thiobenzoyl) disulfide, and bis(dodecylsulfanylthiocarbonyl) disulfide. Of these, 2-cyano-2-propyl benzothioate is most preferable.

When RAFT polymerization is performed with monomers added at a time, a polymer having a narrow dispersity can be synthesized.

When the polymer contains at least one selected from repeat units Sa4 and Sa5, the polymer is a novolak resin (hereinafter, also referred to as a polymer B). The polymer B can be obtained by a polycondensation reaction of a phenol compound and an aldehyde compound. At least one of the phenol compound and the aldehyde compound has a trifluoromethoxy group, a difluoromethoxy group, a trifluoromethylthio group, or a difluoromethylthio group.

The phenol compound is a compound having a hydroxy group bonded to an aromatic ring, and examples thereof include phenol, cresol, naphthol, dihydroxynaphthalene, 9,9-bis(4-hydroxyphenyl)fluorene, 9,9-bis(6-hydroxynaphthyl)fluorene, 1,1,1-tris(4-hydroxyphenyl)ethane, 1,1-bis(4-hydroxyphenyl)-1-phenylethane, bis(4-hydroxyphenyl)cyclohexane, 2,2-bis(4-hydroxyphenyl)adamantane, 4,4',4"-trihydroxytriphenylmethane, and 9-hydroxy-9-phenylfluorene.

Examples of the aldehyde compound include formaldehyde, trioxane, paraformaldehyde, benzaldehyde, acetaldehyde, propylaldehyde, phenylacetaldehyde, α-phenylpropylaldehyde, β-phenylpropylaldehyde, o-hydroxybenzaldehyde, m-hydroxybenzaldehyde, p-hydroxybenzaldehyde, o-chlorobenzaldehyde, m-chlorobenzaldehyde, p-chlorobenzaldehyde, o-nitrobenzaldehyde, m-nitrobenzaldehyde, p-nitrobenzaldehyde, o-methylbenzaldehyde, m-methylbenzaldehyde, p-methylbenzaldehyde, p-ethylbenzaldehyde, p-n-butylbenzaldehyde, and furfural. Of these, formaldehyde can be particularly suitably used. These aldehyde compound may be used singly or in combination of two or more kinds thereof.

At least one of the phenol compound and the aldehyde compound has a trifluoromethoxy group, a difluoromethoxy group, a trifluoromethylthio group, or a difluoromethylthio group. Examples of the phenol compound having any of the above-mentioned groups include trifluoromethoxyphenol, difluoromethoxyphenol, trifluoromethylthiophenol, difluoromethylthiophenol, 9,9-bis(4-hydroxyphenyl)fluorene monotrifluoromethoxybenzmethanol, 9,9-bis(4-hydroxyphenyl)fluorene monodifluoromethoxybenzmethanol, 9,9-bis(4-hydroxyphenyl)fluorene monotrifluoromethylthiobenzmethanol, 9,9-bis(4-hydroxyphenyl)fluorene monodifluoromethylthiobenzmethanol, 9,9-bis(6-hydroxynaphthyl)fluorene monotrifluoromethoxybenzmethanol, 9,9-bis(6-hydroxynaphthyl)fluorene monodifluoromethylthiobenzmethanol, 9,9-bis(6-hydroxynaphthyl)fluorene monotrifluoromethylthiobenzmethanol, 9,9-bis(6-hydroxynaphthyl)fluorene monodifluoromethylthiobenzmethanol, 1,1,1-tris(4-hydroxyphenyl)ethane monotrifluoromethoxybenzmethanol, 1,1,1-tris(4-hydroxyphenyl)ethane monodifluoromethoxybenzmethanol, 1,1, 1 -tris(4-hydroxyphenyl)ethane monotrifluoromethylthiobenzmethanol, 1,1,1-tris(4-hydroxyphenyl)ethane monodifluoromethylthiobenzmethanol, 2,7-dihydroxynaphthalene monotrifluoromethoxybenzmethanol, 2,7-dihydroxynaphthalene monodifluoromethoxybenzmethanol, 2,7-dihydroxynaphthalene monotrifluoromethylthiobenzmethanol, and 2,7-dihydroxynaphthalene monodifluoromethylthiobenzmethanol. Examples of the aldehyde compound having any of the above-mentioned groups include trifluoromethoxybenzaldehyde, difluoromethoxybenzaldehyde, trifluoromethylthiobenzaldehyde, and difluoromethylthiobenzaldehyde.

The phenol compound may be used singly or in combination of two or more kinds thereof, and the aldehyde compound may be used singly or in combination of two or more kinds thereof. The amount of the aldehyde compound used is preferably 0.2 to 5 mol, and more preferably 0.5 to 2 mol per 1 mol of the phenol compound.

It is also possible to use a catalyst in the polycondensation reaction of the phenol compound and the aldehyde. Examples of the catalyst include acidic catalysts such as hydrochloric acid, nitric acid, sulfuric acid, formic acid, oxalic acid, acetic acid, methanesulfonic acid, camphorsulfonic acid, tosylic acid and trifluoromethanesulfonic acid. The amount of the acidic catalyst used is preferably 1×10⁻⁵ to 5×10⁻¹ mol per 1 mol of the phenol compound.

As a reaction solvent in polycondensation, water, methanol, ethanol, propanol, butanol, tetrahydrofuran, dioxane or a mixed solvent thereof can be used. The amount of the solvent used is preferably in the range of 0 to 2,000 parts by weight per 100 parts of weight of raw materials. The reaction temperature can be appropriately selected according to the reactivity of raw materials, and is typically in the range of 10 to 200°C.

The polycondensation reaction is carried out by a method in which a phenol compound, an aldehyde compound and a catalyst are added at a time, or a method in which a phenol compound and an aldehyde compound are added dropwise in the presence of a catalyst. After completion of the polycondensation reaction, volatile components can be removed at about 1 to 50 mmHg by raising the temperature of the reactor to 130 to 230°C for removing unreacted raw materials, the catalyst and the like that are present in the system.

The polymer B preferably has a weight average molecular weight (Mw) in the range of 1,000 to 500,000, and more preferably 1,500 to 30,000, as measured by gel permeation chromatography (GPC) versus polystyrene standards using a THF solvent. If the polymer B has a wide molecular weight distribution or dispersity (Mw/Mn), which indicates the presence of lower and higher molecular weight polymer fractions, there is a possibility that foreign matter is left on the pattern or the pattern profile is degraded. The influences of Mw and Mw/Mn tend to be stronger as the pattern rule becomes finer. Therefore, the polymer A should preferably have a narrow dispersity (Mw/Mn) of 1.0 to 5.0, especially 1.5 to 3.5, in order to provide a resist composition suitable for micropatterning to a small feature size.

The polymer B may be a blend of two or more polymers which differ in compositional ratio, Mw or Mw/Mn.

Materials for use in photolithography of semiconductors, including the surfactant, are required to have a reduced amount of metal impurities. This is because the presence of metal impurities has a negative impact on the operation of devices produced using the materials. For reducing the amount of metal, washing is performed with pure water, or an ion exchange resin is used. In the case of a resist composition, the amount of metal impurities is preferably 100ppm or less, and more preferably 100ppb or less.

The coating material for photolithography according to the present invention contains 0.0001 to 3 wt% of the surfactant. The content of the surfactant is preferably 0.0001 to 2 wt%, and more preferably 0.0002 to 1 wt%.

The coating material for photolithography can be used as a component of a photosensitive or non-photosensitive resist composition, a material for formation of a top coat on a resist film, a material for formation of a resist underlying film, or the like. Examples of the underlying film material include hydrocarbon-based materials and silicon-containing materials. The resist composition may be a chemically amplified or non-chemically amplified resist composition, and may be a hydrocarbon-based resist composition, or a metal-based resist composition containing silicon, titanium, zirconium, hafnium, selenium, germanium, zinc, iron, cobalt, nickel, copper, tin, antimony, molybdenum, tungsten, indium or the like.

### Resist composition

The resist composition of the present invention contains the coating material for photolithography. The resist composition of the present invention may further contain a conventional surfactant. Examples of the conventional surfactant include those described in paragraphs [0165] to [0166] of JP-A 2008-111103. When the resist composition of the present invention contains a conventional surfactant, the content of the surfactant is not limited as long as the effect of the present invention is not impaired.

The resist composition of the present invention may further contain a base polymer. The base polymer is not limited as long as it is used for a resist composition.

Specifically, when the resist composition is of chemically amplified positive tone, the base polymer contains repeat units containing an acid labile group. The repeat units containing an acid labile group are preferably repeat units having following formula (a1) (hereinafter, the repeat units are also referred to as repeat units a1) or repeat units having following formula (a2) (hereinafter, the repeat units are also referred to as repeat units a2).

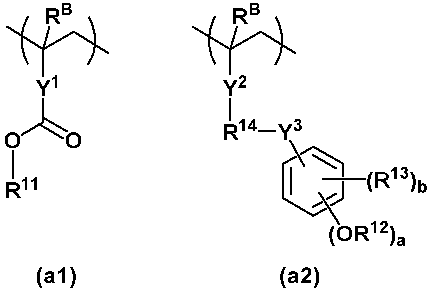

In formulae (a1) and (a2), R^{B} is each independently a hydrogen atom or a methyl group. Y¹ is a single bond, a phenylene group, a naphthylene group, or a C₁-C₁₂ linking group containing at least one moiety selected from an ester bond, an ether bond and a lactone ring. Y² is a single bond or an ester bond. Y³ is a single bond, an ether bond, or an ester bond. R¹¹ and R¹² are each independently an acid labile group. When the base polymer contains both the repeat units a1 and the repeat units a2, R¹¹ and R¹² may be identical or different from each other. R¹³ is a fluorine atom, a trifluoromethyl group, a cyano group, or a C₁-C₆ saturated hydrocarbyl group. R¹⁴ is a single bond or a C₁-C₆ alkanediyl group in which some constituent -CH₂- may be substituted with an ether bond or an ester bond. a is 1 or 2. b is an integer of 0 to 4. Note that 1 ≤ a + b ≤ 5.

Specific examples of the monomer from which repeat units a1 are derived are shown below, but not limited thereto. In the following formulae, R^{B} and R¹¹ are as defined above.

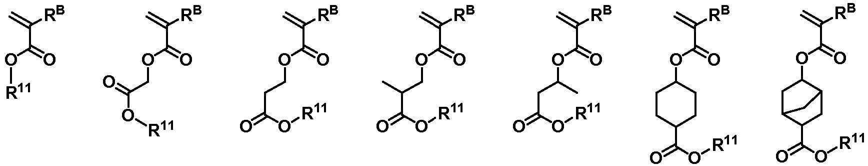

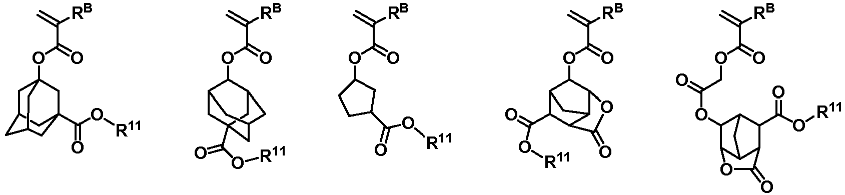

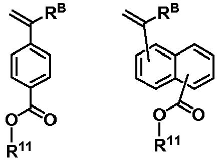

Specific examples of the monomer from which repeat units a2 are derived are shown below, but not limited thereto. In the following formulae, R^{B} and R¹² are as defined above.

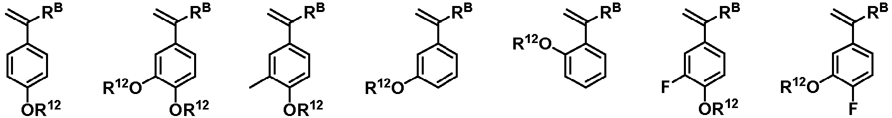

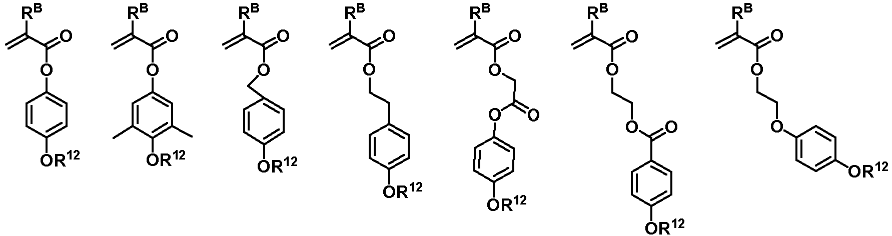

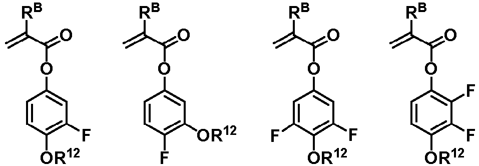

Examples of the acid labile groups represented by R¹¹ and R¹² include those described in JP-A 2013-80033 and JP-A 2013-83821.

Specific examples of the acid labile groups include those having any of following formulae (AL-1) to (AL-3).

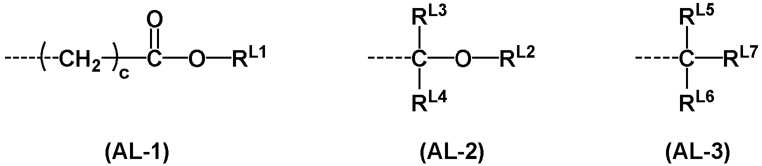

Herein the broken line designates a bond.

In formulae (AL-1) and (AL-2), R^{L1} and R^{L2} are each independently a C₁-C₄₀ hydrocarbyl group which may contain a heteroatom such as an oxygen atom, a sulfur atom, a nitrogen atom, or a fluorine atom. The hydrocarbyl group may be saturated or unsaturated, and may be linear, branched, or cyclic. Preferred are C₁-C₄₀ saturated hydrocarbyl groups, especially C₁-C₂₀ saturated hydrocarbyl groups.

In formula (AL-1), c is an integer of 0 to 10, preferably an integer of 1 to 5.

In formula (AL-2), R^{L3} and R^{L4} are each independently a hydrogen atom or a C₁-C₂₀ hydrocarbyl group which may contain a heteroatom such as an oxygen atom, a sulfur atom, a nitrogen atom, or a fluorine atom. The hydrocarbyl group may be saturated or unsaturated, and may be linear, branched, or cyclic. Preferred are C₁-C₂₀ saturated hydrocarbyl groups. Any two of R^{L2}, R^{L3}, and R^{L4} may bond together to form a ring, typically an alicyclic ring, with a carbon atom or carbon and oxygen atoms to which they are bonded, the ring containing 3 to 20 carbon atoms. The ring is preferably a ring containing 4 to 16 carbon atoms, and particularly preferably an alicyclic ring.

In formula (AL-3), R^{L5}, R^{L6}, and R^{L7} are each independently a C₁-C₂₀ hydrocarbyl group which may contain a heteroatom such as an oxygen atom, a sulfur atom, a nitrogen atom, or a fluorine atom. The hydrocarbyl group may be saturated or unsaturated, and may be linear, branched, or cyclic. Preferred are C₁-C₂₀ saturated hydrocarbyl groups. Any two of R^{L5}, R^{L6}, and R^{L7} may bond together to form a ring, typically an alicyclic ring, with a carbon atom to which they are bonded, the ring containing 3 to 20 carbon atoms. The ring is preferably a ring containing 4 to 16 carbon atoms, and particularly preferably an alicyclic ring.

The base polymer may contain repeat units b having a phenolic hydroxy group as an adhesive group. Specific examples of the monomer from which repeat units b are derived are shown below, but not limited thereto. Herein R^{B} is as defined above.

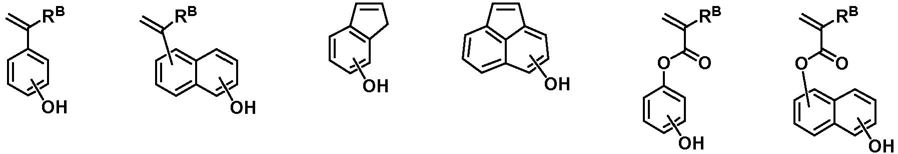

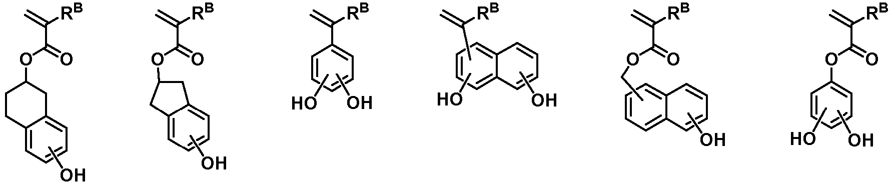

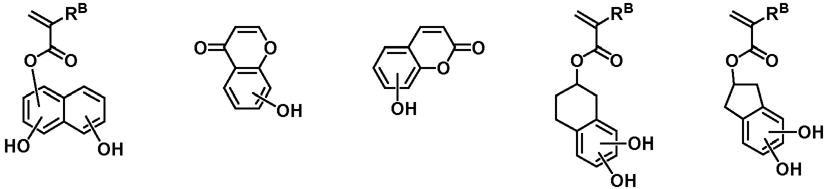

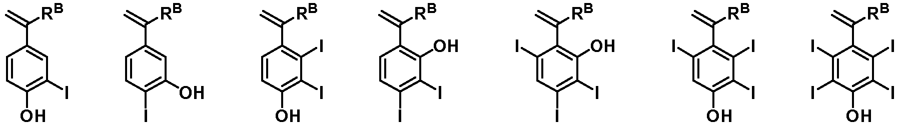

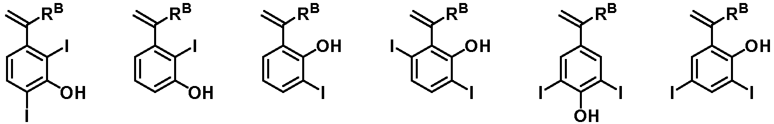

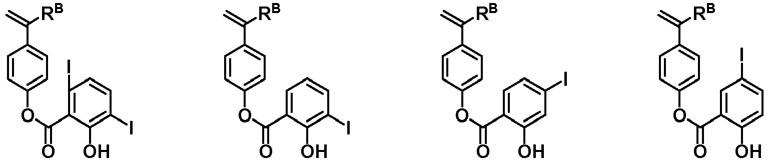

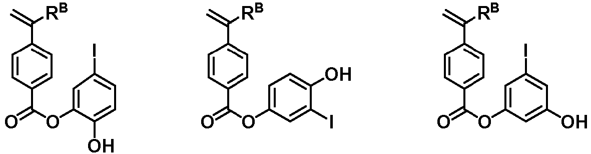

The base polymer may contain repeat units c having another adhesive group selected from a hydroxy group other than the phenolic hydroxy group, a lactone ring, a sultone ring, an ether bond, an ester bond, a sulfonic acid ester bond, a carbonyl group, a sulfonyl group, a cyano group, and a carboxy group. Specific examples of the monomer from which repeat units c are derived are shown below, but not limited thereto. Herein R^{B} is as defined above.

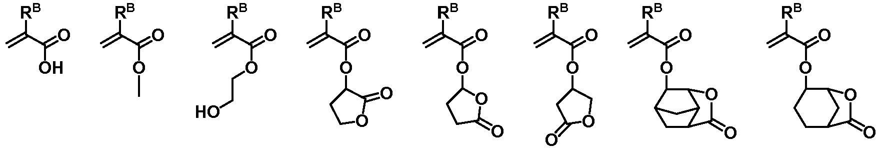

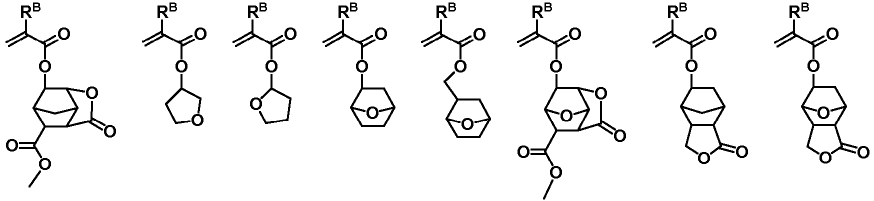

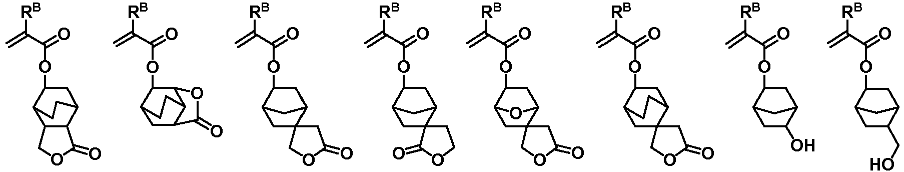

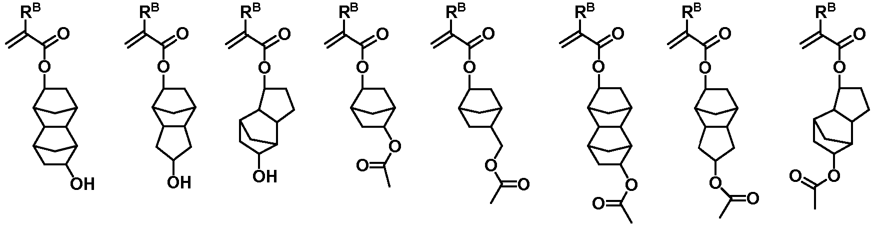

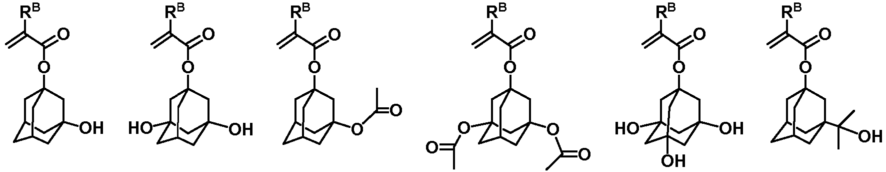

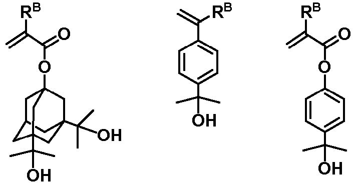

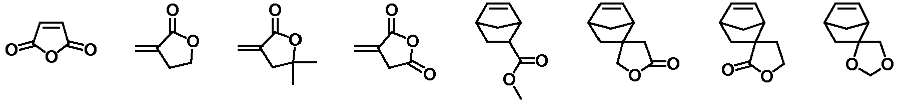

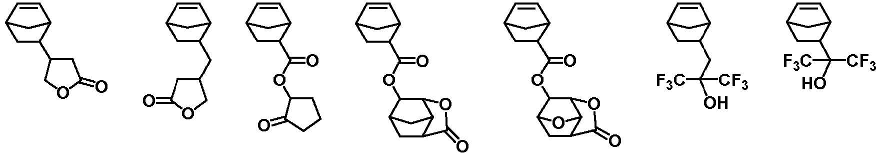

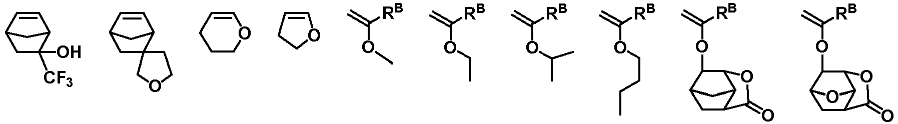

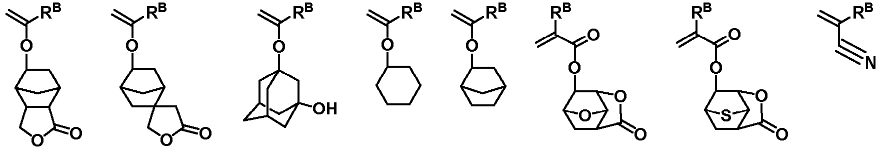

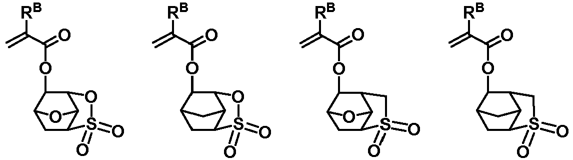

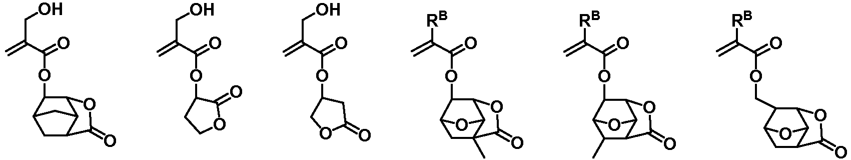

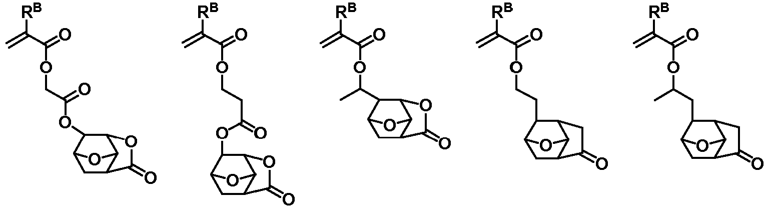

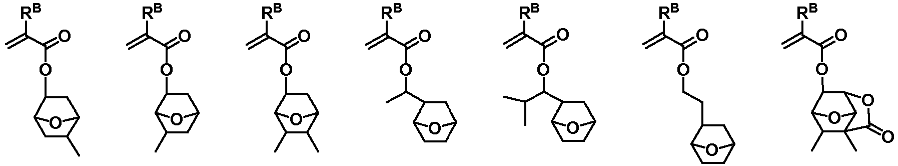

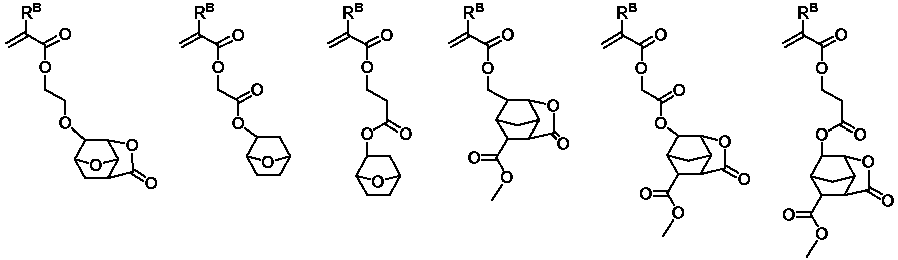

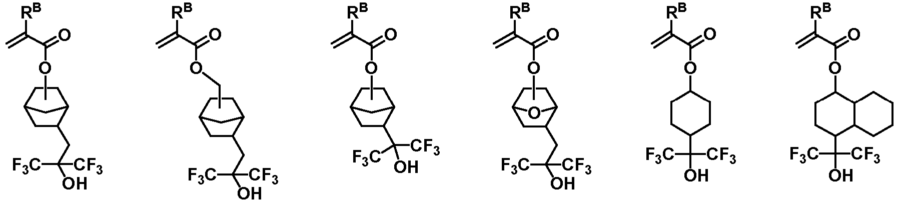

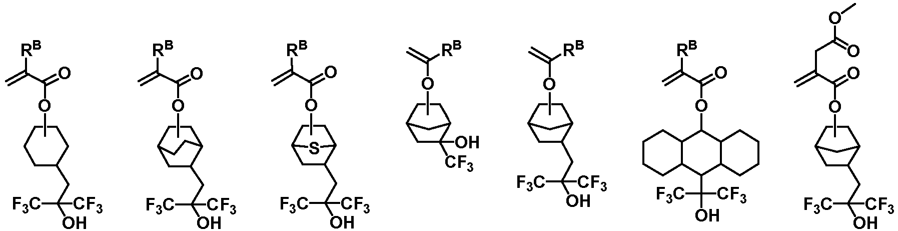

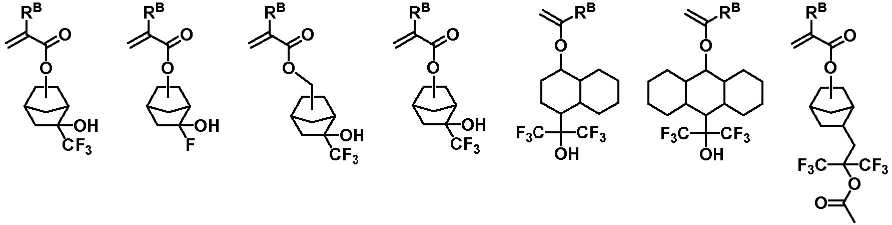

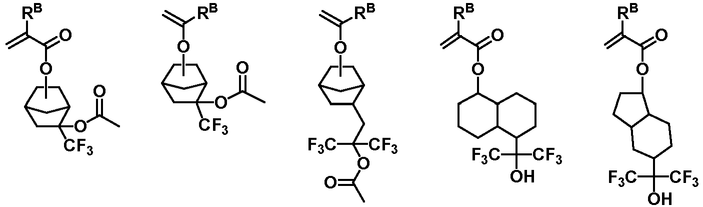

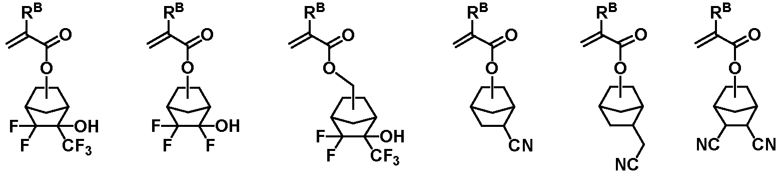

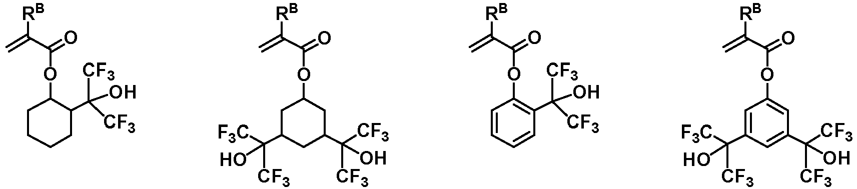

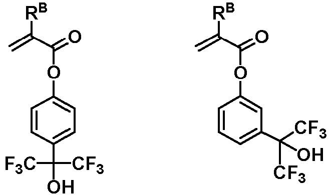

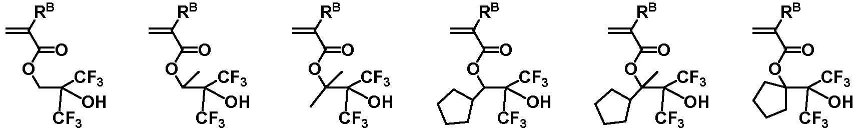

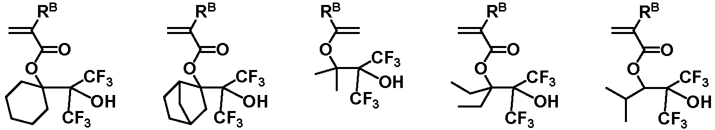

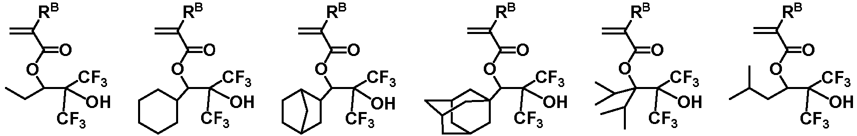

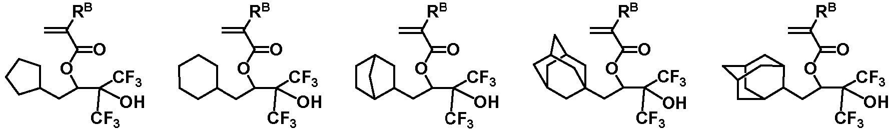

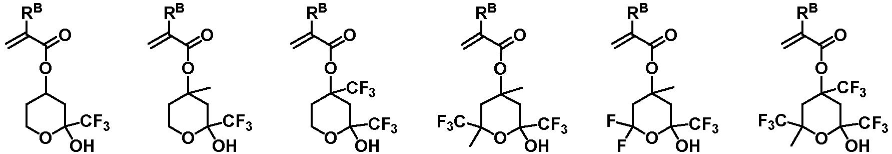

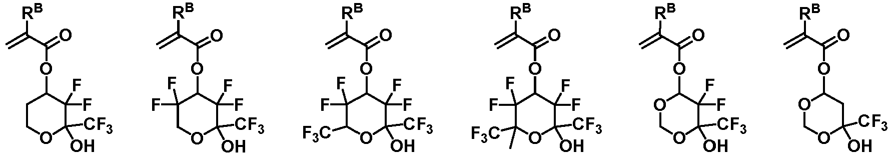

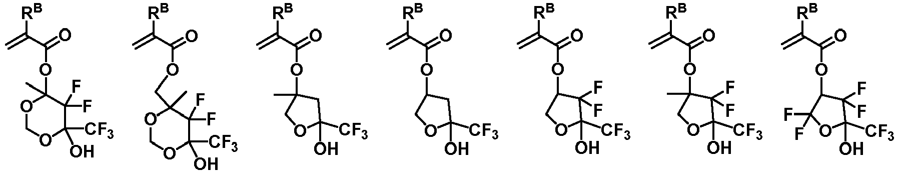

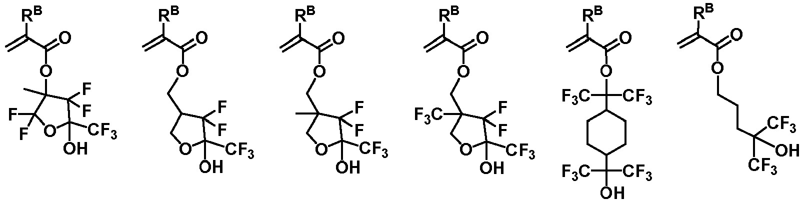

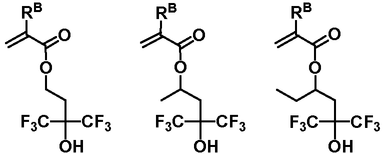

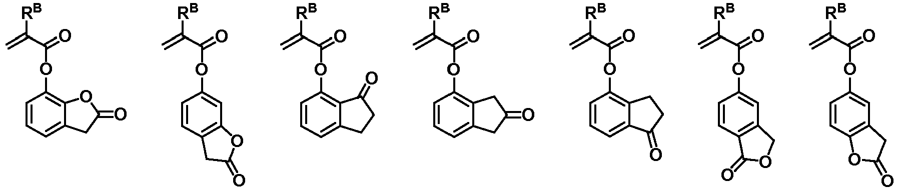

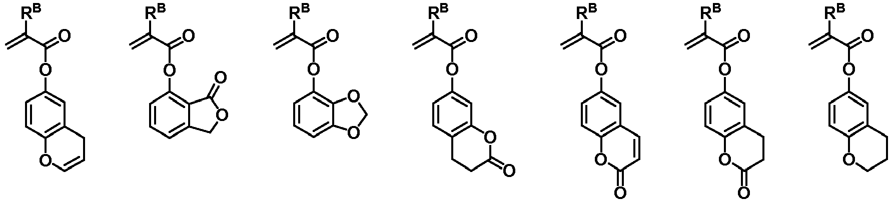

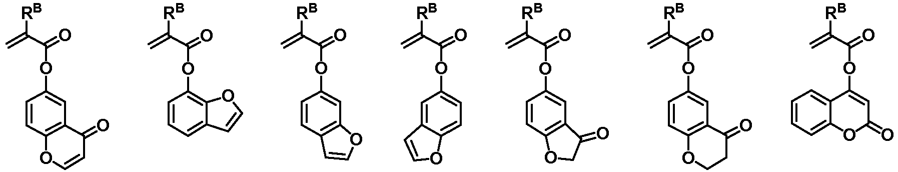

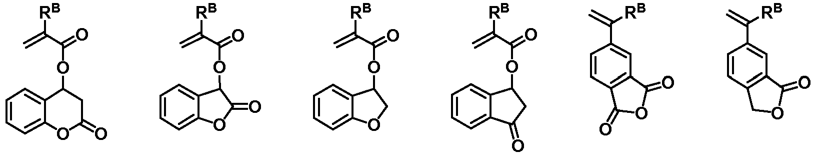

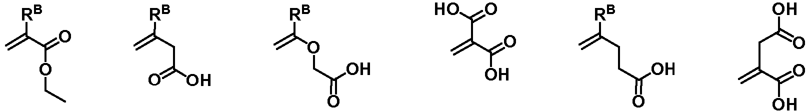

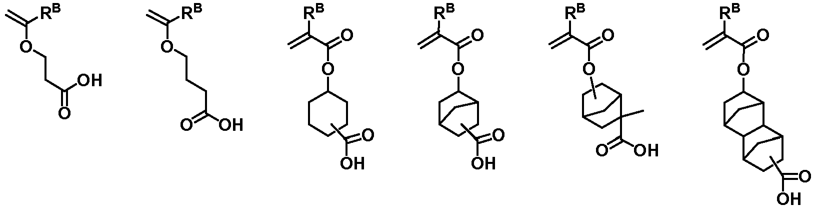

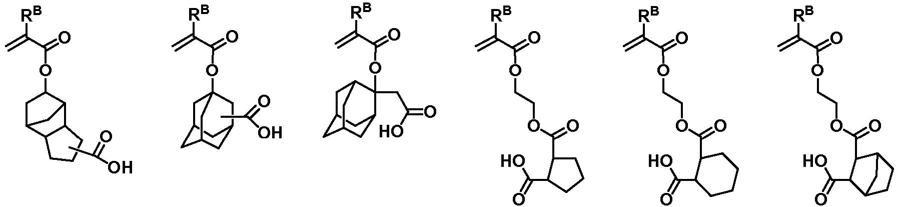

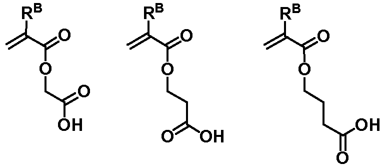

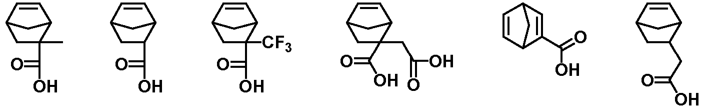

The base polymer may contain repeat units d derived from indene, benzofuran, benzothiophene, acenaphthylene, chromone, coumarin, norbornadiene, or a derivative thereof. Specific examples of the monomer from which the repeat units d are derived are shown below, but not limited thereto.

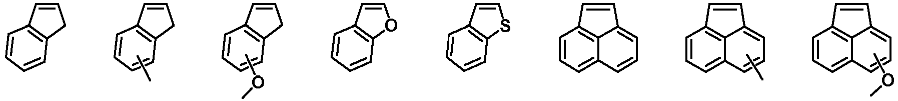

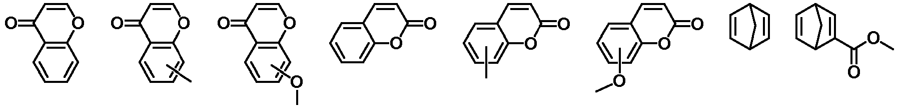

The base polymer may contain repeat units e derived from styrene, vinylnaphthalene, vinylanthracene, vinylpyrene, methyleneindane, vinylpyridine, or vinylcarbazole.

The base polymer may contain repeat units f derived from an onium salt containing a polymerizable unsaturated bond. Specific examples of the preferred repeat units f include repeat units having following formula (f1) (hereinafter, the repeat units are also referred to as repeat units f1), repeat units having following formula (f2) (hereinafter, the repeat units are also referred to as repeat units f2), and repeat units having following formula (f3) (hereinafter, the repeat units are also referred to as repeat units f3). The repeat units f1 to f3 may each be used singly or in combination of two or more kinds thereof.

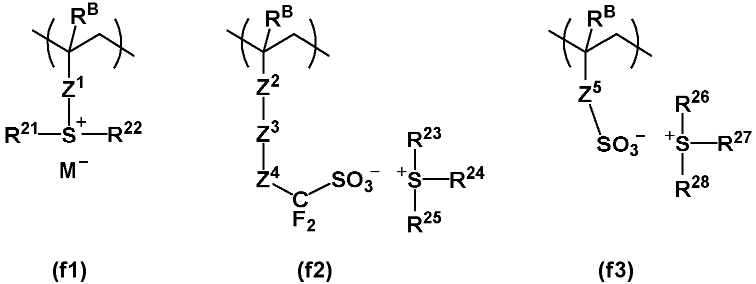

In formulae (f1) to (f3), R^{B} is each independently a hydrogen atom or a methyl group. Z¹ is a single bond, a C₁-C₆ aliphatic hydrocarbylene group, a phenylene group, a naphthylene group, a C₇-C₁₈ group obtained by combining the foregoing, -O-Z¹¹-, -C(=O)-O-Z¹¹-, or -C(=O)-NH-Z¹¹-. Z¹¹ is a C₁-C₆ aliphatic hydrocarbylene group, a phenylene group, a naphthylene group, or a C₇-C₁₈ group obtained by combining the foregoing, which may contain a carbonyl group, an ester bond, an ether bond, or a hydroxy group. Z² is a single bond or an ester bond. Z³ is a single bond, -Z³¹-C(=O)-O-, -Z³¹-O-, or -Z³¹-O-C(=O)-. Z³¹ is a C₁-C₁₂ aliphatic hydrocarbylene group, a phenylene group, or a C₇-C₁₈ group obtained by combining the foregoing, which may contain a carbonyl group, an ester bond, an ether bond, an iodine atom, or a bromine atom. Z⁴ is a methylene group, a 2,2,2-trifluoro-1,1-ethanediyl group, or a carbonyl group. Z⁵ is a single bond, a methylene group, an ethylene group, a phenylene group, a fluorinated phenylene group, a trifluoromethyl-substituted phenylene group, -O-Z⁵¹-, -C(=O)-O-Z⁵¹-, or -C(=O)-NH-Z⁵¹-. Z⁵¹ is a C₁-C₆ aliphatic hydrocarbylene group, a phenylene group, a fluorinated phenylene group, or a trifluoromethyl-substituted phenylene group, which may contain a carbonyl group, an ester bond, an ether bond, a halogen atom, or a hydroxy group.

In formulae (f1) to (f3), R²¹ to R²⁸ are each independently a halogen atom or a C₁-C₂₀ hydrocarbyl group which may contain a heteroatom.

Specific examples of the halogen atom represented by R²¹ to R²⁸ include a fluorine atom, a chlorine atom, a bromine atom, and an iodine atom.

The hydrocarbyl group represented by R²¹ and R²⁸ may be saturated or unsaturated, and may be linear, branched, or cyclic. Specific examples thereof include C₁-C₂₀ alkyl groups such as a methyl group, an ethyl group, a n-propyl group, an isopropyl group, a n-butyl group, an isobutyl group, a sec-butyl group, a tert-butyl group, a n-pentyl group, a n-hexyl group, a n-octyl group, a n-nonyl group, a n-decyl group, an undecyl group, a dodecyl group, a tridecyl group, a tetradecyl group, a pentadecyl group, a heptadecyl group, an octadecyl group, a nonadecyl group, and an icosyl group; C₃-C₂₀ cyclic saturated hydrocarbyl groups such as a cyclopropyl group, a cyclopentyl group, a cyclohexyl group, a cyclopropylmethyl group, a 4-methylcyclohexyl group, a cyclohexylmethyl group, a norbornyl group, and an adamantyl group; C₂-C₂₀ alkenyl groups such as a vinyl group, a propenyl group, a butenyl group, and a hexenyl group; C₂-C₂₀ alkynyl groups such as an ethynyl group, a propynyl group, and a butynyl group; C₃-C₂₀ cyclic unsaturated aliphatic hydrocarbyl groups such as a cyclohexenyl group and a norbornenyl group; C₆-C₂₀ aryl groups such as a phenyl group, a methylphenyl group, an ethylphenyl group, a n-propylphenyl group, an isopropylphenyl group, a n-butylphenyl group, an isobutylphenyl group, a sec-butylphenyl group, a tert-butylphenyl group, a naphthyl group, a methylnaphthyl group, an ethylnaphthyl group, a n-propylnaphthyl group, an isopropylnaphthyl group, a n-butylnaphthyl group, an isobutylnaphthyl group, a sec-butylnaphthyl group, and a tert-butylnaphthyl group; C₇-C₂₀ aralkyl groups such as a benzyl group and a phenethyl group; and groups obtained by combining the foregoing.

Some or all of hydrogen atoms of the hydrocarbyl group may be substituted with a group containing a heteroatom such as an oxygen atom, a sulfur atom, a nitrogen atom, or a halogen atom, and some of -CH₂- of the hydrocarbyl group may be substituted with a group containing a heteroatom such as an oxygen atom, a sulfur atom, or a nitrogen atom, so that the group may contain a hydroxy group, a fluorine atom, a chlorine atom, a bromine atom, an iodine atom, a cyano group, a nitro group, a carbonyl group, an ether bond, an ester bond, a sulfonic acid ester bond, a carbonate bond, a lactone ring, a sultone ring, a carboxylic anhydride (-C(=O)-O-C(=O)-), or a haloalkyl group.

R²³ and R²⁴ or R²⁶ and R²⁷ may bond together to form a ring with a sulfur atom to which they are bonded. The ring preferably has the following structure.

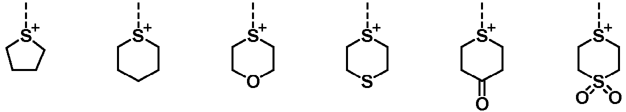

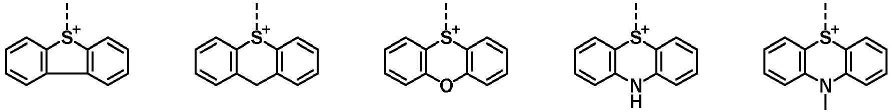

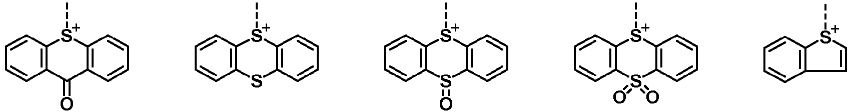

Herein the broken line designates a bond.

In formula (f1), M⁻ is a non-nucleophilic counter ion. Specific examples of the non-nucleophilic counter ion include halide ions such as chloride ions and bromide ions; fluoroalkyl sulfonate ions such as triflate ions, 1,1,1-trifluoroethane sulfonate ions and nonafluorobutane sulfonate ions; aryl sulfonate ions such as tosylate ions, benzene sulfonate ions, 4-fluorobenzenesulfonate ions and 1,2,3,4,5-pentafluorobenzenesulfonate ions; alkyl sulfonate ions such as mesylate ions and butanesulfonate ions; imide ions such as bis(trifluoromethylsulfonyl)imide ions, bisperfluoroethylsulfonyl)imide ions, and bis(perfluorobutylsulfonyl)imide ions; and tris(trifluoromethylsulfonyl)methide ions and trisperfluoroethylsulfonyl)methide ions.

Specific examples of the non-nucleophilic counter ion include sulfonate ions having a fluorine atom substituted at the α-position as represented by following formula (f1-1) and sulfonate ions having a fluorine atom substituted at the α-position and a trifluoromethyl group substituted at the β-position as represented by following formula (f1-2).

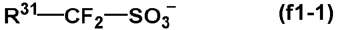

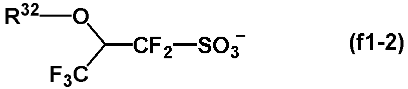

In formula (f1-1), R³¹ is a hydrogen atom or a C₁-C₂₀ hydrocarbyl group which may contain at least one selected from an ether bond, an ester bond, a carbonyl group, a lactone ring and a fluorine atom. The hydrocarbyl group may be saturated or unsaturated, and may be linear, branched, or cyclic.

In formula (f1-2), R³² is a hydrogen atom, a C₁-C₃₀ hydrocarbyl group, or a C₆-C₂₀ hydrocarbylcarbonyl group, and the hydrocarbyl group and the hydrocarbylcarbonyl group may contain an ether bond, an ester bond, a carbonyl group, or a lactone ring. The hydrocarbyl group and the hydrocarbyl moiety in the hydrocarbylcarbonyl group may be saturated or unsaturated, and may be linear, branched, or cyclic.

Specific examples of the cation in the monomer from which the repeat units f1 are derived include those shown below, but are not limited thereto. Herein R^{B} is as defined above.

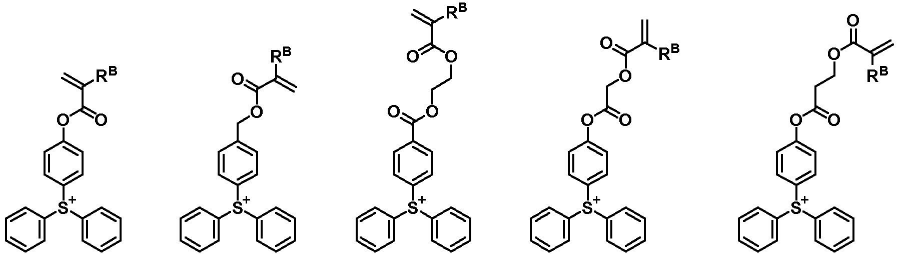

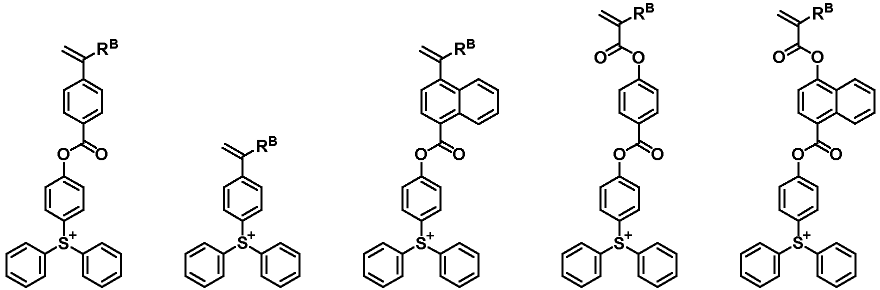

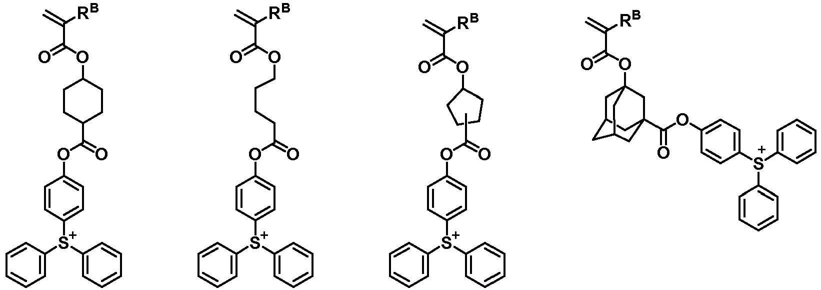

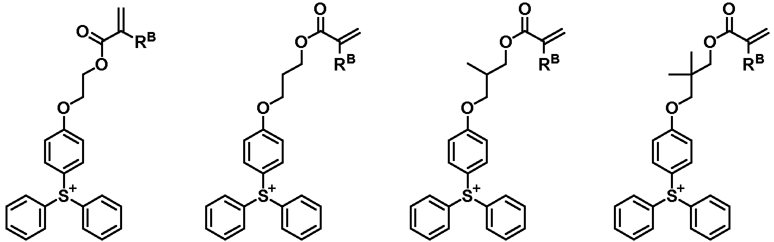

Examples of the anion in the monomer from which the repeat units f2 are derived include those shown below, but are not limited thereto. Herein R^{B} is as defined above.

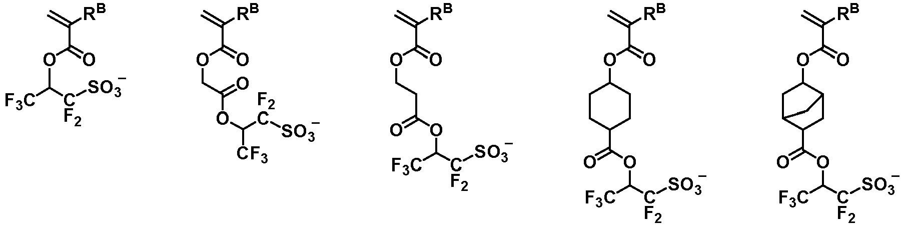

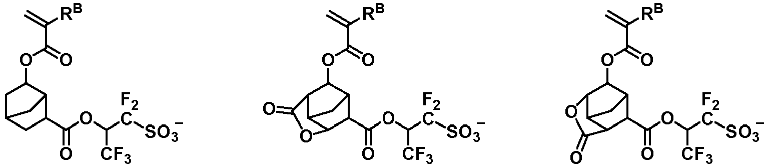

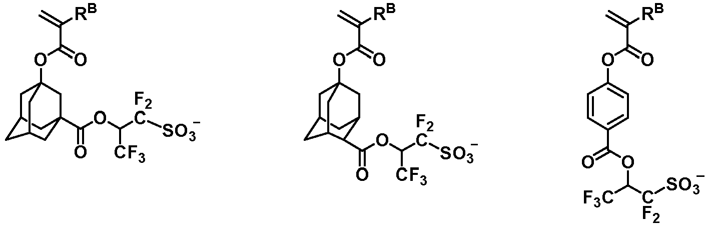

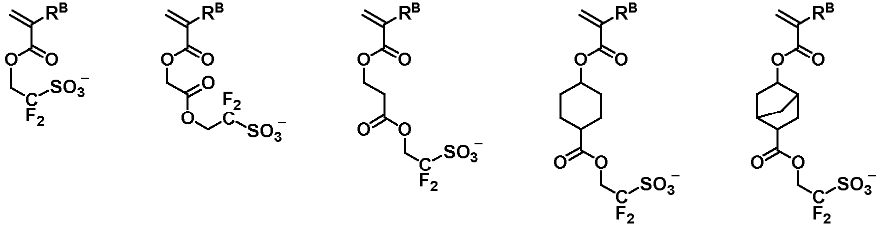

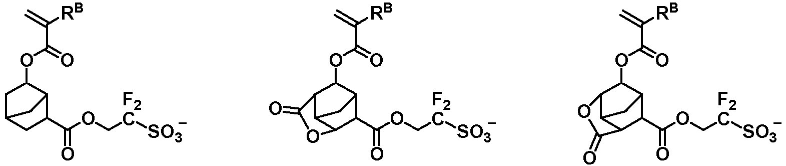

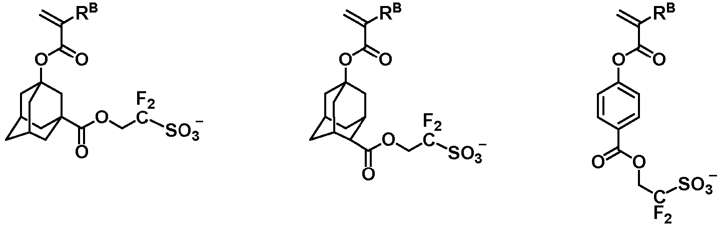

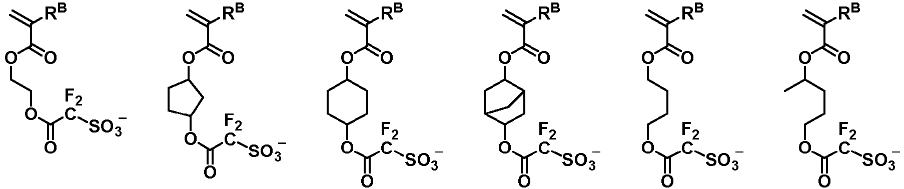

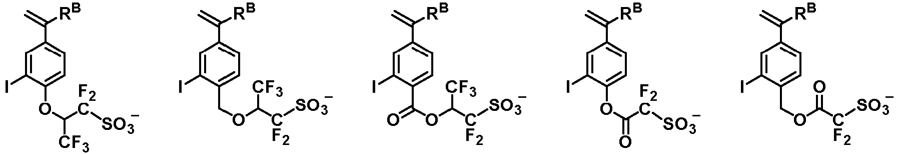

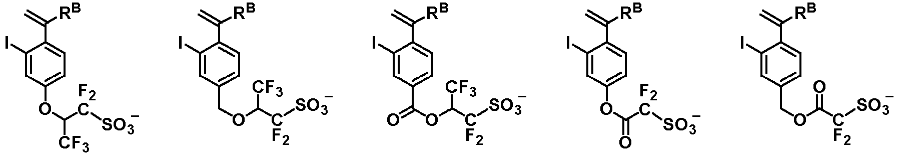

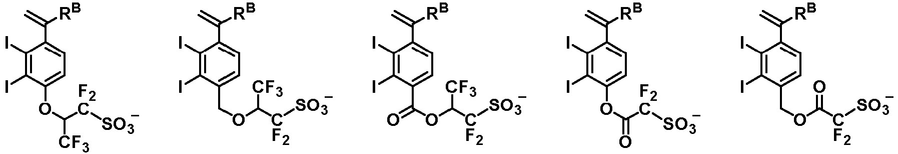

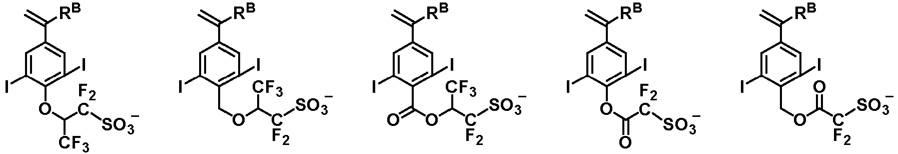

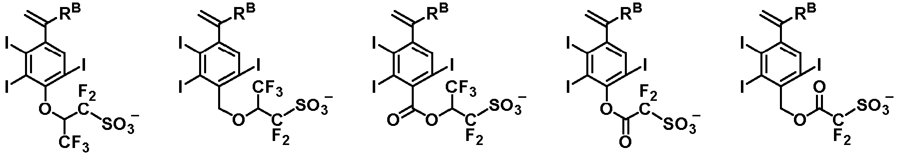

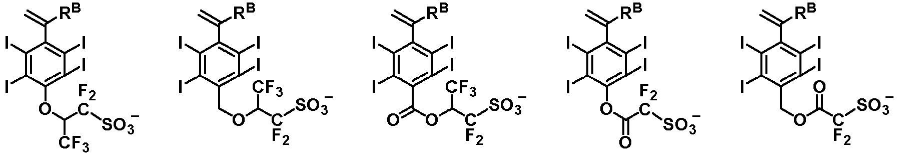

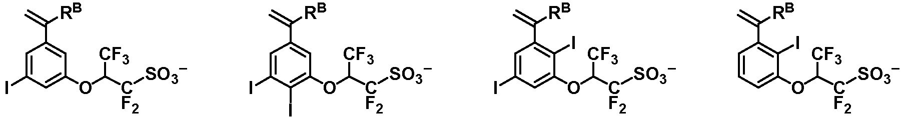

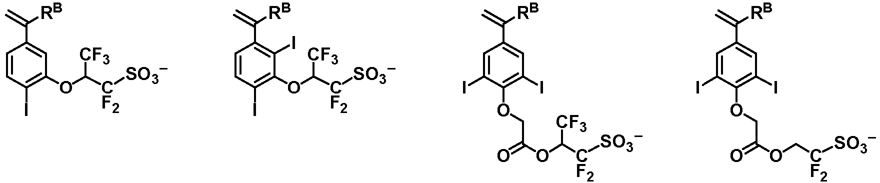

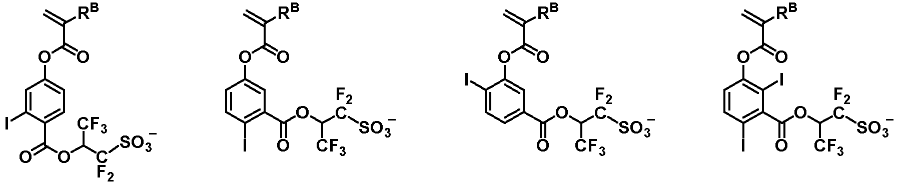

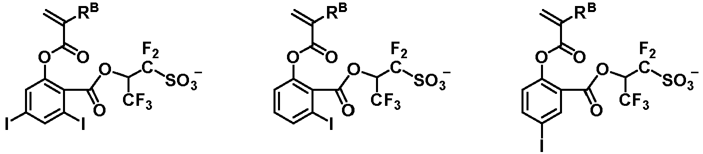

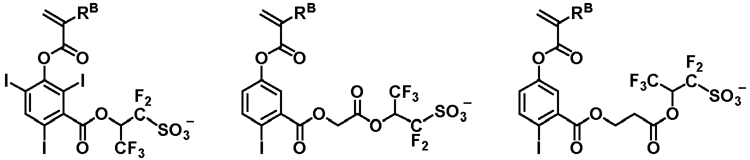

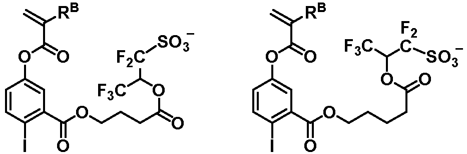

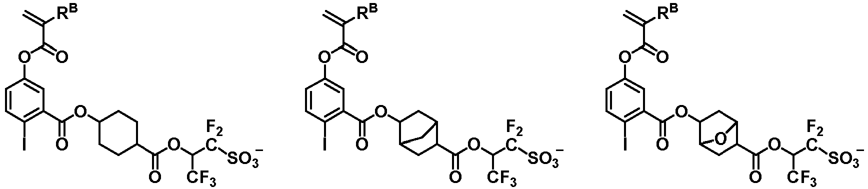

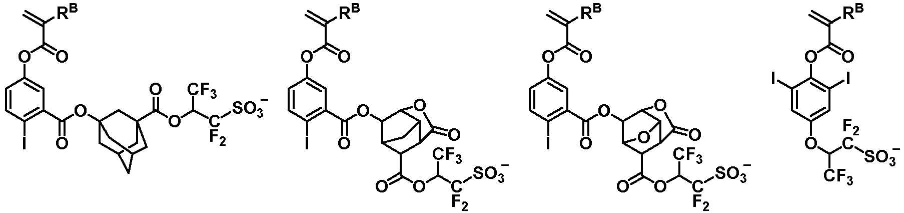

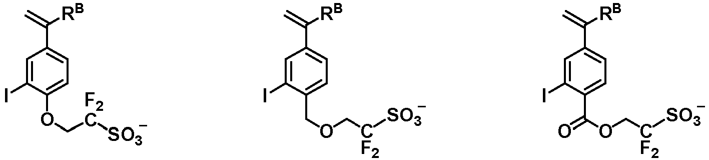

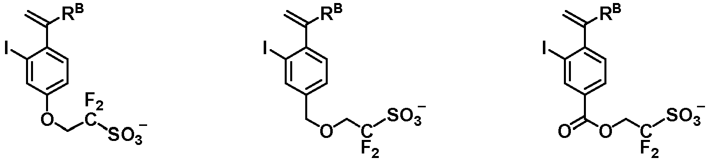

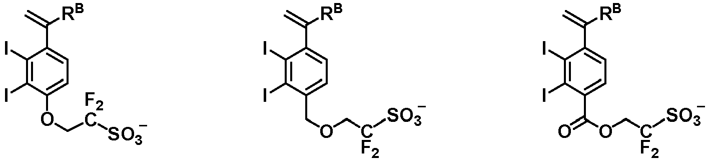

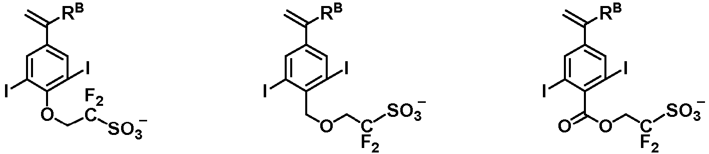

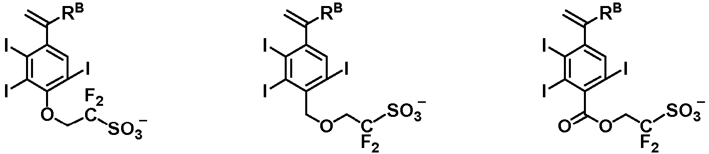

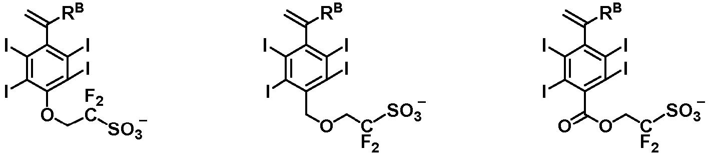

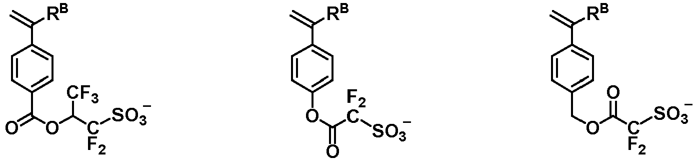

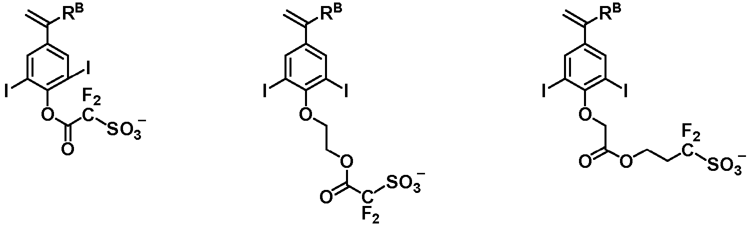

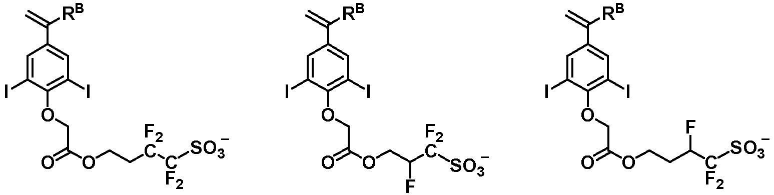

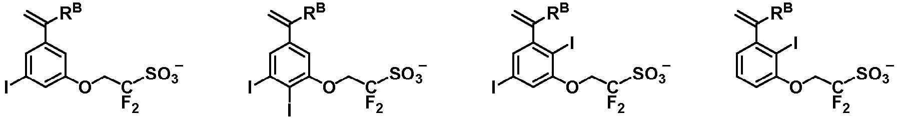

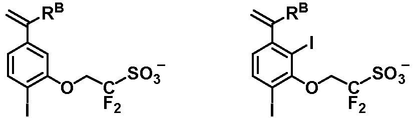

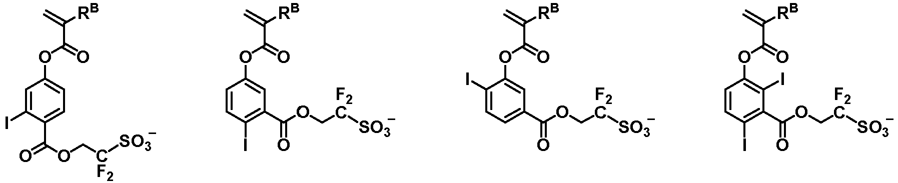

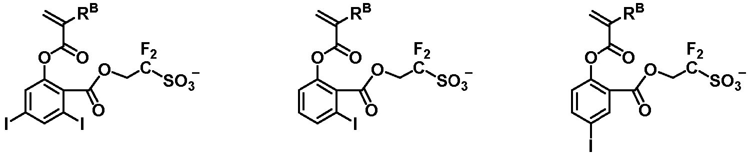

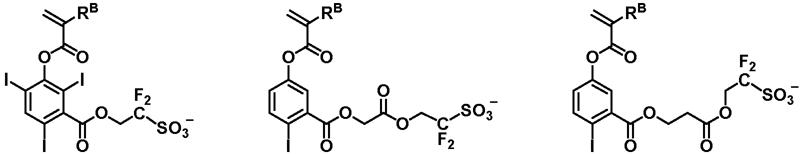

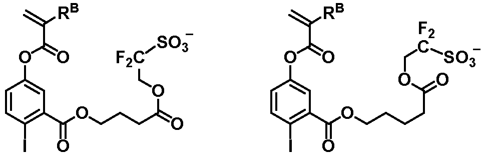

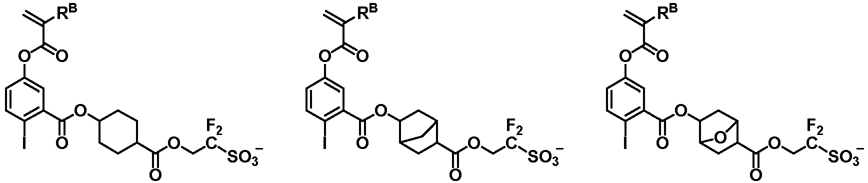

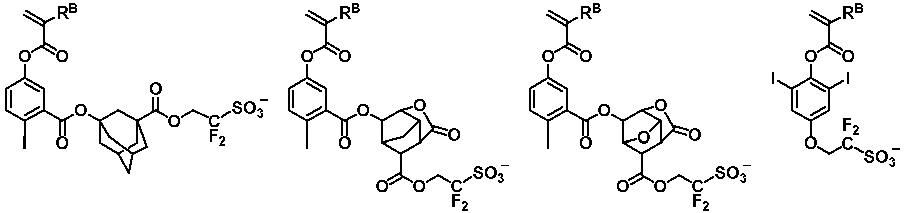

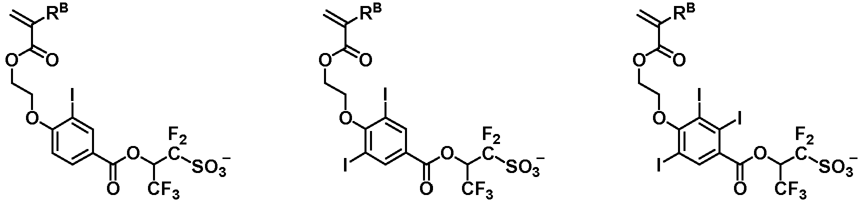

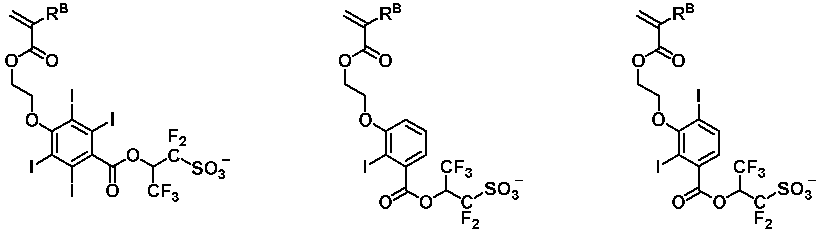

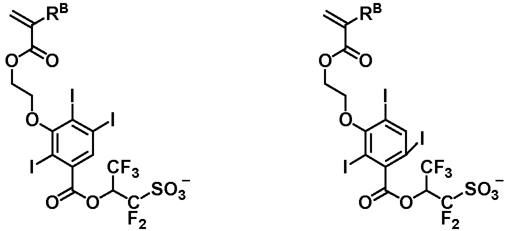

Examples of the anion in the monomer from which the repeat units f3 are derived include those shown below, but are not limited thereto. Herein R^{B} is as defined above.

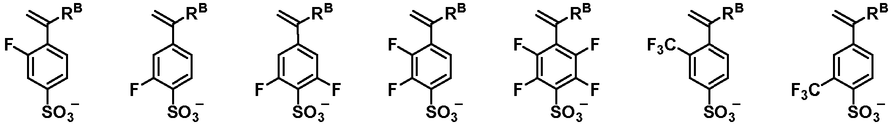

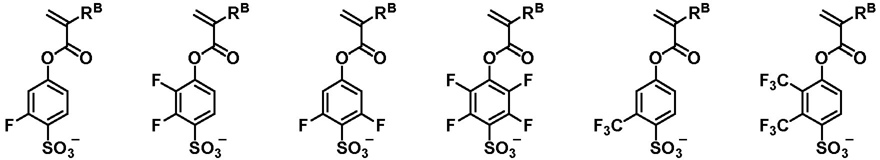

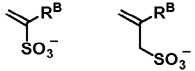

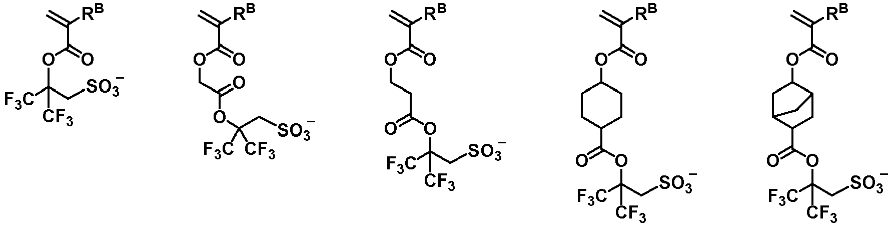

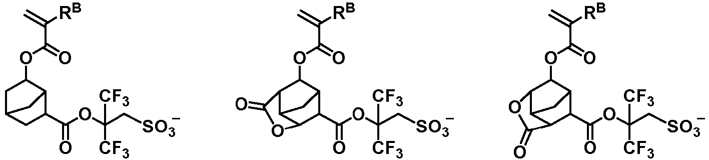

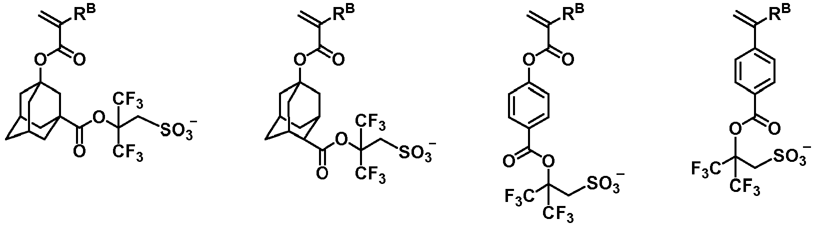

Specific examples of the cation in repeat units f2 or f3 include those similar to sulfonium salts described in JP-A 2023-3926, paragraphs [0063] to [0080] and iodonium salts described in JP-A 2023-3926, paragraph [0082].

The repeat units f1 to f3 have a function of an acid generator. Bonding an acid generator to the polymer backbone is effective in reducing acid diffusion, thereby preventing a reduction of resolution due to blur by acid diffusion. In addition, the LWR and CDU are improved since the acid generator is uniformly distributed. Use of a base polymer containing the repeat units f may avoid the necessity for an acid generator of addition type described later.

In the case of a resist composition of negative tone or a non-chemically amplified resist composition, the base polymer does not necessarily contain repeat units a1 and a2.

As the base polymer, not only the above-described polymers but also resins such as novolak resin, polyimide, polyamide, polyvinylpyrrolidone, polyvinyl alcohol, polythiophene and polyaniline can be used.

### Organic solvent

The coating material for photolithography and resist composition according to the present invention may contain an organic solvent. The organic solvent is not particularly limited as long as the components described above and below are soluble therein.
Specific examples of the organic solvent are described in paragraphs [0144] to [0145] of JP-A 2008-111103, and include ketones such as cyclohexanone, cyclopentanone, methyl-2-n-pentyl ketone, and 2-heptanone; alcohols such as 3-methoxybutanol, 3-methyl-3-methoxybutanol, 1-methoxy-2-propanol, 1-ethoxy-2-propanol, and diacetone alcohol (DAA); ethers such as propylene glycol monomethyl ether (PGME), ethylene glycol monomethyl ether, propylene glycol monoethyl ether, ethylene glycol monoethyl ether, propylene glycol dimethyl ether, diethylene glycol dimethyl ether, and anisole; esters such as propylene glycol monomethyl ether acetate (PGMEA), propylene glycol monoethyl ether acetate, ethyl lactate, ethyl pyruvate, butyl acetate, methyl 3-methoxypropionate, ethyl 3-ethoxypropionate, tert-butyl acetate, tert-butyl propionate, and propylene glycol mono-tert-butyl ether acetate; lactones such as γ-butyrolactone; lactams such as pyrrolidone, N-methylpyrrolidone, N-ethylpyrrolidone, and N-hydroxyethyl-2-pyrrolidone; water; and dimethylsulfoxide.

The organic solvent is preferably added to the resist composition of the present invention in an amount of 100 to 10,000 parts by weight, and more preferably 200 to 8,000 parts by weight per 100 parts by weight of the base polymer. The organic solvent may be used singly or as a mixture of two or more kinds thereof.

The resist composition of the present invention may contain an acid generator of addition type. Examples of the acid generator of addition type include sulfonium salts or iodonium salts described in JP-A 2008-111103, paragraphs [0122] to [0142] and JP-A 2023-62677, paragraphs [0077] to [0148], sulfonyldiazomethane, N-sulfonyloxyimide, and oxime-O-sulfonate. The acid generator of addition type is preferably added to the resist composition of the present invention in an amount of 0.1 to 50 parts by weight, and more preferably 1 to 40 parts by weight per 100 parts by weight of the base polymer. The acid generators of addition type may be used singly or in combination of two or more thereof.

The resist composition of the present invention may contain a quencher. The quencher means a compound capable of trapping the acid, which is generated by the acid generator in the resist composition, to prevent the acid from diffusing to the unexposed region.

Examples of the quencher include conventional basic compounds. Examples of the conventional basic compounds include primary, secondary, and tertiary aliphatic amines, mixed amines, aromatic amines, heterocyclic amines, nitrogen-containing compounds having a carboxy group, nitrogen-containing compounds having a sulfonyl group, nitrogen-containing compounds having a hydroxy group, nitrogen-containing compounds having a hydroxyphenyl group, alcoholic nitrogen-containing compounds, amide derivatives, imide derivatives, and carbamate derivatives. In particular, primary, secondary, and tertiary amine compounds described in paragraphs [0146] to [0164] of JP-A 2008-111103, particularly amine compounds having a hydroxy group, an ether bond, an ester bond, a lactone ring, a cyano group, or a sulfonic acid ester bond, and compounds having a carbamate group described in JP 3790649 are preferred. Addition of a basic compound may be effective for further reducing the diffusion rate of the acid in the resist film or correcting the pattern profile.

Examples of the quencher also include onium salts such as sulfonium salts, iodonium salts, and ammonium salts of sulfonic acids which are not fluorinated at the α-position, or carboxylic acids, as described in JP-A 2008-158339. While a sulfonic acid which is fluorinated at the α-position, an imide acid, or a methide acid is necessary for deprotecting the acid labile group of a carboxylic acid ester, an α-non-fluorinated sulfonic acid or a carboxylic acid is released by salt exchange with an α-non-fluorinated onium salt. The α-non-fluorinated sulfonic acid and carboxylic acid function as a quencher because they do not induce a deprotection reaction.

Examples of the quencher further include a polymeric quencher described in JP-A 2008-239918. The polymeric quencher segregates at the resist film surface and thus enhances the rectangularity of the resist pattern. When a protective film is applied as is often the case in immersion lithography, the polymeric quencher is also effective for preventing a film thickness loss of the resist pattern or rounding of the pattern top.

The quencher is preferably added to the resist composition of the present invention in an amount of 0 to 5 parts by weight, and more preferably 0 to 4 parts by weight per 100 parts by weight of the base polymer. The quencher may be used singly or in combination of two or more kinds thereof.

When the resist composition of the present invention is of negative tone, the resist composition may contain a crosslinker. The addition of a crosslinker may lead to an increased difference in dissolution rate between the exposed region and the unexposed region, and may cause expansion of swelling in the developer. Examples of the crosslinker include those described in JP-A 2020-027297, paragraphs [0170] to [0177]. The crosslinker is preferably added to the resist composition of the present invention in an amount of 0 to 30 parts by weight, and more preferably 0 to 20 parts by weight per 100 parts by weight of the base polymer.

The coating material for photolithography and resist composition according to the present invention may contain a water repellency improver for improving the water repellency of the surface of the resist film. The water repellency improver may be used in the topcoatless immersion lithography. Suitable water repellency improvers include polymers having a fluoroalkyl group and polymers having a specific structure with a 1,1,1,3,3,3-hexafluoro-2-propanol residue and are described in JP-A 2007-297590 and JP-A 2008-111103, for example. The water repellency improver should be soluble in alkaline developers and organic solvent developers. The water repellency improver having a specific structure with a 1, 1,1,3,3,3-hexafluoro-2-propanol residue described above is well soluble in the developer. A polymer having an amino group or amine salt copolymerized as repeat units may serve as the water repellency improver and is effective for preventing evaporation of the acid during post exposure bake (PEB), thus preventing any hole pattern opening failure after development. The water repellency improver is preferably added to the coating material for photolithography or resist composition according to the present invention in an amount of 0 to 20 parts by weight, and more preferably 0.5 to 10 parts by weight per 100 parts by weight of the base polymer. The water repellency improver may be used singly or in combination of two or more kinds thereof.

The surfactant contained in the coating material for photolithography according to the present invention can also be used as the water repellency improver. In this case, it is also possible to combine a surfactant having a high surface activating effect in addition to a surfactant having a high water repellency improving function.

The resist composition of the present invention may contain an acetylene alcohol. Specific examples of the acetylene alcohol include those described in paragraphs [0179] to [0182] of JP-A 2008-122932. The acetylene alcohol is preferably added to the resist composition of the present invention in an amount of 0 to 5 parts by weight per 100 parts by weight of the base polymer. The acetylene alcohol may be used singly or in combination of two or more kinds thereof.

### Pattern forming process

The resist composition of the present invention is used in the fabrication of various integrated circuits by a well-known lithography technique. Examples of the pattern forming process include a process including the steps of: applying the above-described resist composition onto a substrate to form a resist film on the substrate, exposing the resist film to high-energy radiation, and developing the exposed resist film in a developer.

The resist composition of the present invention is first applied onto a substrate on which an integrated circuit is to be formed (e.g., Si, SiO₂, SiN, SiON, TiN, WSi, BPSG, SOG, or organic antireflective coating) or a substrate on which a mask circuit is to be formed (e.g., Cr, CrO, CrON, CrN, MoSi₂, or SiO₂, Ta, MoSi laminated film, Ru, Ni, Co, W, Mo, V and alloys thereof) by a suitable coating technique such as spin coating, roll coating, flow coating, dipping, spraying, or doctor coating. The coating is prebaked on a hotplate preferably at a temperature of 60 to 150°C for 10 seconds to 30 minutes, and more preferably at 80 to 150°C for 30 seconds to 20 minutes to form a resist film.

The substrate can also be treated by irradiation with light, EB, plasma or the like or treated by CVD or with ozone, hexamethyldisilazane (HMDS) or the like before being coated with the resist composition of the present invention.

The resist film should preferably have a thickness of 1 nm to 200 µm, and more preferably 2 nm to 100 µm.

A protective film can also be formed on the resist film. The protective film preferably has functions such as environmental protection, light absorption, prevention of static charge, reduction of resist pattern defects, and correction of resist pattern shape.

The resist film is then exposed to high-energy radiation. Specific examples of the high-energy radiation include UV, deep-UV, EB, EUV of wavelength 3-15 nm, i-line, x-ray, soft x-ray, excimer laser light, γ-ray or synchrotron radiation. When UV, deep-UV, EUV, X-rays, soft X-rays, excimer laser, γ-rays, or synchrotron radiation is used as the high-energy radiation, the resist film is exposed thereto directly or through a mask having a desired pattern preferably at a dose of about 1 to 200 mJ/cm², and more preferably about 10 to 100 mJ/cm². When EB is used as the high-energy radiation, the resist film is exposed thereto directly or through a mask having a desired pattern preferably at a dose of about 0.1 to 1,000 µC/cm², and more preferably about 0.5 to 900 µC/cm². It is appreciated that the resist composition of the present invention is suitable for micropatterning using high-energy radiation such as g-rays, i-rays, KrF excimer laser, ArF excimer laser, EB, EUV, X-rays, soft X-rays, γ-rays, or synchrotron radiation.

After the exposure, the resist film may be baked (PEB) on a hotplate preferably at 40 to 150°C for 10 seconds to 30 minutes, more preferably at 50 to 120°C for 30 seconds to 20 minutes.

After the exposure of after PEB, the resist film is developed with a developer for 3 seconds to 3 minutes, preferably 5 seconds to 2 minutes by conventional techniques such as dip, puddle and spray techniques to form a desired pattern on the substrate.

The developer may be an organic solvent developer or an alkaline aqueous solution developer. Examples of the organic solvent developer include 2-octanone, 2-nonanone, 2-heptanone, 3-heptanone, 4-heptanone, 2-hexanone, 3-hexanone, diethyl ketone, methyl ethyl ketone, methyl isobutyl ketone, cyclopentanone, cyclohexanone, diisobutyl ketone, methylcyclohexanone, acetophenone, methylacetophenone, propyl acetate, butyl acetate, isobutyl acetate, pentyl acetate, butenyl acetate, isopentyl acetate, propyl formate, butyl formate, isobutyl formate, pentyl formate, isopentyl formate, methyl valerate, methyl pentenoate, methyl crotonate, ethyl crotonate, methyl propionate, ethyl propionate, ethyl 3-ethoxypropionate, methyl lactate, ethyl lactate, propyl lactate, butyl lactate, isobutyl lactate, pentyl lactate, isopentyl lactate, methyl 2-hydroxyisobutyrate, ethyl 2-hydroxyisobutyrate, methyl benzoate, ethyl benzoate, phenyl acetate, benzyl acetate, methyl phenylacetate, benzyl formate, phenylethyl formate, methyl 3-phenylpropionate, benzyl propionate, ethyl phenylacetate, 2-phenylethyl acetate, diethylene glycol dimethyl ether, ethylene glycol dimethyl ether, xylene, toluene, anisole, anisole, methanol, ethanol, isopropanol, n-butyl alcohol, isobutyl alcohol, acetic anhydride, and acetic acid. Specific examples of the alkaline aqueous solution developer include aqueous solutions of potassium hydroxide, sodium hydroxide or the like, and aqueous solutions of tetramethylammonium hydroxide, tetraethylammonium hydroxide, tetrapropylammonium hydroxide, tetrabutylammonium hydroxide, choline hydroxide or the like. The developer may be used singly or as a mixture of two or more kinds thereof.

At the end of development, the resist film is rinsed. The rinsing liquid is preferably a solvent which is miscible with the developer and does not dissolve the resist film. Examples of preferred solvents include alcohols having 3 to 10 carbon atoms, ether compounds having 8 to 12 carbon atoms, alkanes, alkenes, and alkynes each having 6 to 12 carbon atoms, aromatic solvents, and pure water.

Specific examples of the alcohols having 3 to 10 carbon atoms include n-propyl alcohol, isopropyl alcohol, 1-butyl alcohol, 2-butyl alcohol, isobutyl alcohol, tert-butyl alcohol, 1-pentanol, 2-pentanol, 3-pentanol, tert-pentyl alcohol, neopentyl alcohol, 2-methyl-1-butanol, 3-methyl-1-butanol, 3-methyl-3-pentanol, cyclopentanol, 1-hexanol, 2-hexanol, 3-hexanol, 2,3-dimethyl-2-butanol, 3,3-dimethyl-1-butanol, 3,3-dimethyl-2-butanol, 2-ethyl-1-butanol, 2-methyl-1-pentanol, 2-methyl-2-pentanol, 2-methyl-3-pentanol, 3-methyl-1-pentanol, 3-methyl-2-pentanol, 3-methyl-3-pentanol, 4-methyl-1-pentanol, 4-methyl-2-pentanol, 4-methyl-3-pentanol, cyclohexanol, and 1-octanol.

Specific examples of the ether compounds having 8 to 12 carbon atoms include di-n-butyl ether, diisobutyl ether, di-sec-butyl ether, di-n-pentyl ether, diisopentyl ether, di-sec-pentyl ether, di-tert-pentyl ether, and di-n-hexyl ether.

Specific examples of the alkanes having 6 to 12 carbon atoms include hexane, heptane, octane, nonane, decane, undecane, dodecane, methylcyclopentane, dimethylcyclopentane, cyclohexane, methylcyclohexane, dimethylcyclohexane, cycloheptane, cyclooctane, and cyclononane. Specific examples of the C₆-C₁₂ alkene include hexene, heptene, octene, cyclohexene, methylcyclohexene, dimethylcyclohexene, cycloheptene, and cyclooctene. Specific examples of the C₆-C₁₂ alkyne include hexyne, heptyne, and octyne.

Examples of the aromatic solvents include toluene, xylene, ethylbenzene, isopropylbenzene, tert-butylbenzene, and mesitylene.

Rinsing is effective for reducing the resist pattern collapse and defect formation. However, rinsing is not essential. If rinsing is omitted, the amount of solvent used may be reduced.

A hole or trench pattern after development may be shrunk by the thermal flow, RELACS^{®}, or DSA process. A hole pattern is shrunk by applying a shrink agent thereto, and baking the resist composition such that the shrink agent may undergo crosslinking at the resist film surface due to diffusion of the acid catalyst from the resist film during baking, and the shrink agent may attach to the sidewall of the hole pattern. The baking temperature is preferably 70 to 180°C, more preferably 80 to 170°C, and the baking time is preferably 10 to 300 seconds to remove the excess shrink agent and shrink the hole pattern.

### EXAMPLES

Hereinafter, the present invention is specifically described with reference to a Synthesis Example, Examples, and Comparative Examples, but the present invention is not limited to the following Examples.

### [1] Synthesis of surfactant polymer

Monomers Sa-1 to Sa-33 and Sb-1 and Sb-5 shown below were used in the synthesis of surfactant polymers. Mw of the polymer is as measured by GPC versus polystyrene standards using THF solvent.

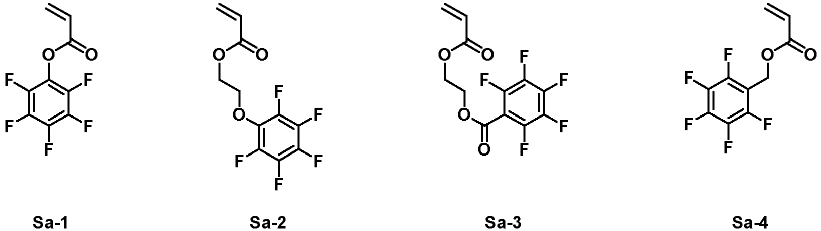

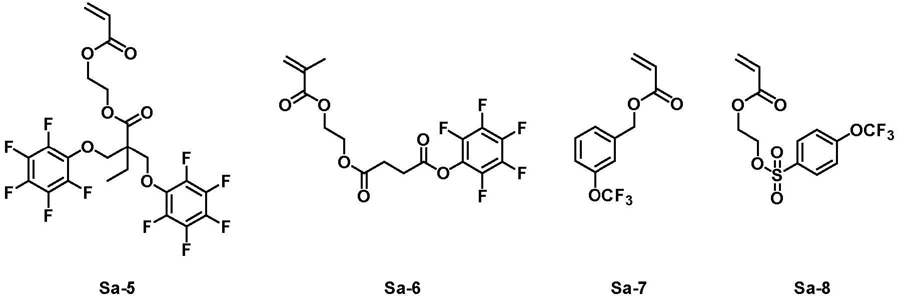

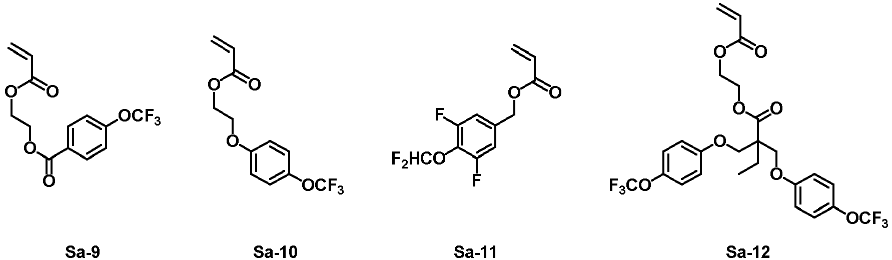

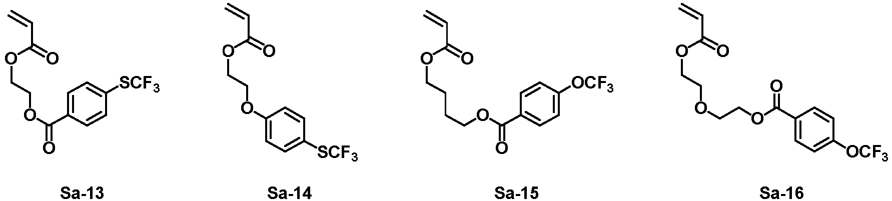

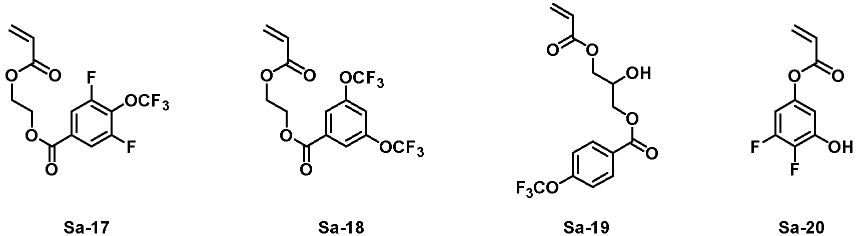

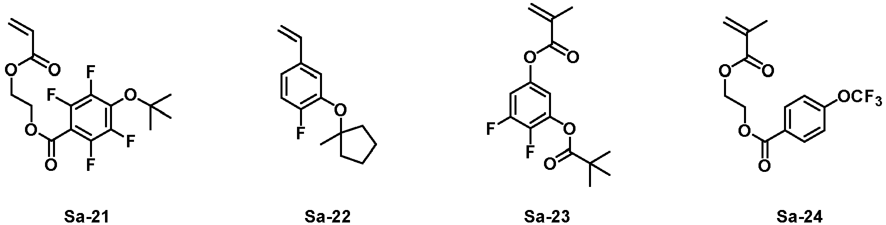

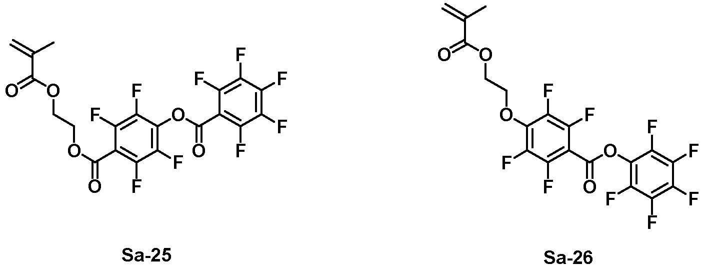

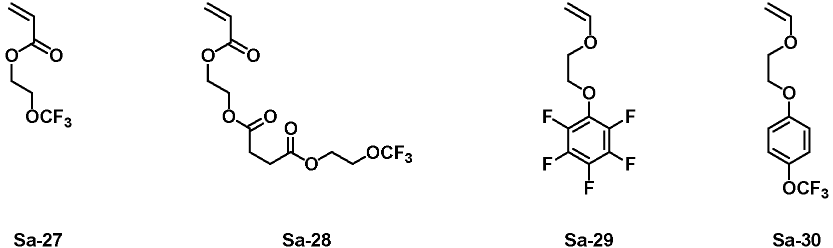

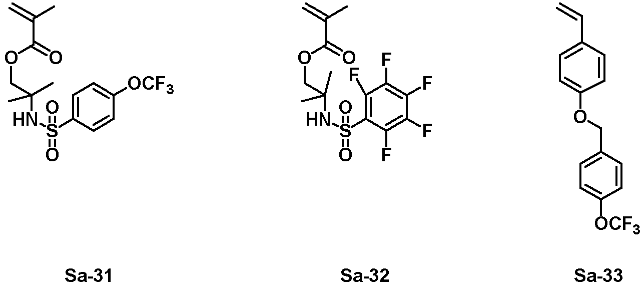

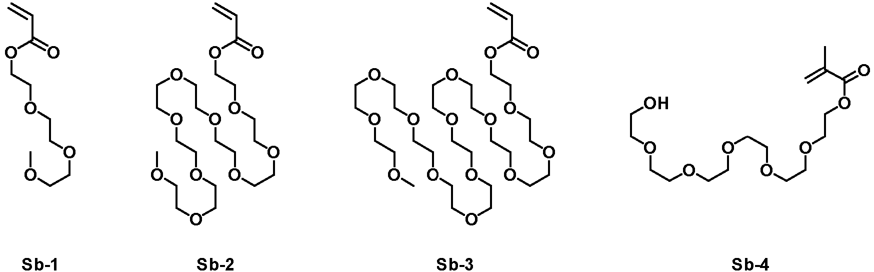

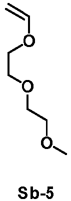

### Synthesis Example 1

### Synthesis of polymer SP-1

In a nitrogen atmosphere, 0.42 g of 2-cyano-2-propyl benzodithioate and 0.10 g of 2,2'-azobisisobutyronitrile (AIBN) were dissolved in 37.5 g of methanol, and the resulting solution was stirred at 64°C for 3 hours in a nitrogen atmosphere. To the solution, a solution obtained by dissolving 9.5 g of the monomer Sa-1 in 32.2 g of methanol was added dropwise over 2 hours. Subsequently, to the solution, a solution obtained by dissolving 13.1 g of the monomer Sb-1 in 48.2 g of methanol was added dropwise over 2 hours. After completion of the dropwise addition, the mixture was stirred at 64°C for 4 hours. The reaction liquid was allowed to cool to room temperature, and then added dropwise to 1,000 g of hexane with vigorous stirring. The resulting solid was separated by filtration, and dried under vacuum at 50°C for 15 hours to obtain a polymer SP-1 as a red solid diblock copolymer. The polymer SP-1 was analyzed for composition by ¹⁹F-NMR and ¹H-NMR spectroscopy and for Mw and Mw/Mn by GPC.

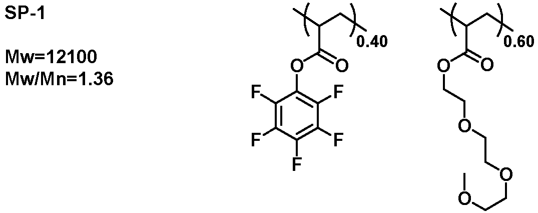

### Synthesis Example 2

### Synthesis of polymer SP-2

In a nitrogen atmosphere, 0.42 g of 2-cyano-2-propyl benzodithioate and 0.10 g of AIBN were dissolved in 37.5 g of methanol, and the solution was stirred at 64°C for 3 hours in a nitrogen atmosphere. To the solution, a solution obtained by dissolving 4.3 g of the monomer Sa-1 in 16.1 g of methanol was added dropwise over 2 hours. Subsequently, to the solution, a solution obtained by dissolving 13.1 g of the monomer Sb-1 in 48.2 g of methanol was added dropwise over 2 hours. After completion of the dropwise addition, the mixture was stirred at 64°C for 4 hours. Thereafter, to the solution, a solution obtained by dissolving 4.3 g of the monomer Sa-1 in 16.1 g of methanol was added dropwise over 2 hours. After completion of the dropwise addition, the mixture was stirred at 64°C for 4 hours. The reaction liquid was allowed to cool to room temperature, and then added dropwise to 1,000 g of hexane with vigorous stirring. The resulting solid was separated by filtration, and dried under vacuum at 50°C for 15 hours to obtain a polymer SP-2 as a red solid triblock copolymer having a polymerized product of the monomer Sb-1 at the center and a polymerized product of the monomer Sa-1 on both sides. The polymer SP-2 was analyzed for composition by ¹⁹F-NMR and ¹H-NMR spectroscopy and for Mw and Mw/Mn by GPC.

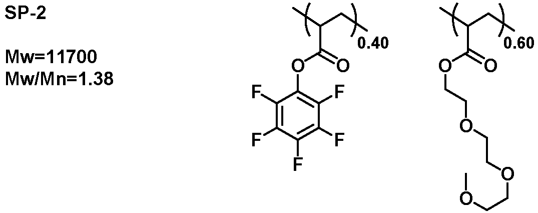

### Synthesis Example 3

### Synthesis of polymer SP-3

A reactor was charged with 11.2 g of the monomer Sa-2, 28.9 g of the monomer Sb-2 and 60 g of THF as a solvent. In a nitrogen atmosphere, the reactor was cooled to -70°C, degassed under reduced pressure, and purged with nitrogen three times. The temperature was raised to room temperature, 0.1 g of AIBN was then added as a polymerization initiator, the temperature was raised to 60°C, and the mixture was reacted for 15 hours. The reaction solution was added to 1 L of hexane, and the precipitated white solid was separated by filtration. The resulting white solid was dried under reduced pressure at 60°C to obtain a polymer SP-3 as a random copolymer. The polymer SP-3 was analyzed for composition by ¹⁹F-NMR and ¹H-NMR spectroscopy and for Mw and Mw/Mn by GPC.

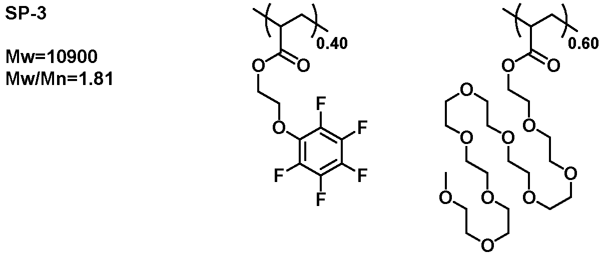

### Synthesis Example 4

### Synthesis of polymer SP-4

A reactor was charged with 12.4 g of the monomer Sa-3, 28.9 g of the monomer Sb-2 and 60 g of THF as a solvent. In a nitrogen atmosphere, the reactor was cooled to -70°C, degassed under reduced pressure, and purged with nitrogen three times. The temperature was raised to room temperature, 0.1 g of AIBN was then added as a polymerization initiator, the temperature was raised to 60°C, and the mixture was reacted for 15 hours. The reaction solution was added to 1 L of hexane, and the precipitated white solid was separated by filtration. The resulting white solid was dried under reduced pressure at 60°C to obtain a polymer SP-4 as a random copolymer. The polymer SP-4 was analyzed for composition by ¹⁹F-NMR and ¹H-NMR spectroscopy and for Mw and Mw/Mn by GPC.

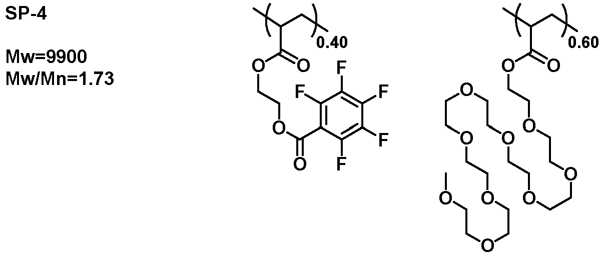

### Synthesis Example 5

### Synthesis of polymer SP-5

A reactor was charged with 10.0 g of the monomer Sa-4, 28.9 g of the monomer Sb-2 and 60 g of THF as a solvent. In a nitrogen atmosphere, the reactor was cooled to -70°C, degassed under reduced pressure, and purged with nitrogen three times. The temperature was raised to room temperature, 0.1 g of AIBN was then added as a polymerization initiator, the temperature was raised to 60°C, and the mixture was reacted for 15 hours. The reaction solution was added to 1 L of hexane, and the precipitated white solid was separated by filtration. The resulting white solid was dried under reduced pressure at 60°C to obtain a polymer SP-5 as a random copolymer. The polymer SP-5 was analyzed for composition by ¹⁹F-NMR and ¹H-NMR spectroscopy and for Mw and Mw/Mn by GPC.

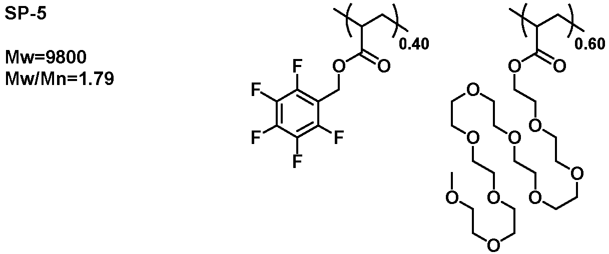

### Synthesis Example 6

### Synthesis of polymer SP-6

A reactor was charged with 23.1 g of the monomer Sa-5, 39.5 g of the monomer Sb-3 and 100 g of THF as a solvent. In a nitrogen atmosphere, the reactor was cooled to -70°C, degassed under reduced pressure, and purged with nitrogen three times. The temperature was raised to room temperature, 0.1 g of AIBN was then added as a polymerization initiator, the temperature was raised to 60°C, and the mixture was reacted for 15 hours. The reaction solution was added to 1 L of hexane, and the precipitated white solid was separated by filtration. The resulting white solid was dried under reduced pressure at 60°C to obtain a polymer SP-6 as a random copolymer. The polymer SP-6 was analyzed for composition by ¹⁹F-NMR and ¹H-NMR spectroscopy and for Mw and Mw/Mn by GPC.

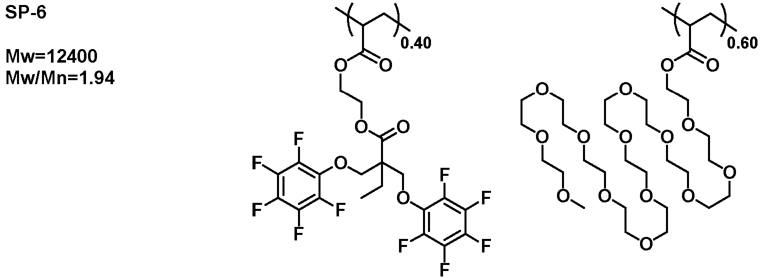

### Synthesis Example 7

### Synthesis of polymer SP-7

A reactor was charged with 13.8 g of the monomer Sa-6, 42.8 g of the monomer Sb-3 and 100 g of THF as a solvent. In a nitrogen atmosphere, the reactor was cooled to -70°C, degassed under reduced pressure, and purged with nitrogen three times. The temperature was raised to room temperature, 0.1 g of AIBN was then added as a polymerization initiator, the temperature was raised to 60°C, and the mixture was reacted for 15 hours. The reaction solution was added to 1 L of hexane, and the precipitated white solid was separated by filtration. The resulting white solid was dried under reduced pressure at 60°C to obtain a polymer SP-7 as a random copolymer. The polymer SP-7 was analyzed for composition by ¹⁹F-NMR and ¹H-NMR spectroscopy and for Mw and Mw/Mn by GPC.

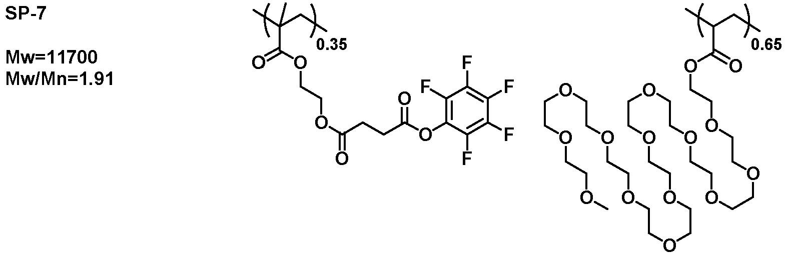

### Synthesis Example 8

### Synthesis of polymer SP-8

A reactor was charged with 9.8 g of the monomer Sa-7, 21.0 g of the monomer Sb-4 and 60 g of THF as a solvent. In a nitrogen atmosphere, the reactor was cooled to -70°C, degassed under reduced pressure, and purged with nitrogen three times. The temperature was raised to room temperature, 0.1 g of AIBN was then added as a polymerization initiator, the temperature was raised to 60°C, and the mixture was reacted for 15 hours. The reaction solution was added to 1 L of hexane, and the precipitated white solid was separated by filtration. The resulting white solid was dried under reduced pressure at 60°C to obtain a polymer SP-8 as a random copolymer. The polymer SP-8 was analyzed for composition by ¹⁹F-NMR and ¹H-NMR spectroscopy and for Mw and Mw/Mn by GPC.

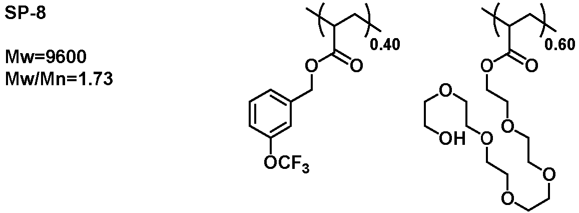

### Synthesis Example 9

### Synthesis of polymer SP-9

A reactor was charged with 13.6 g of the monomer Sa-8, 21.0 g of the monomer Sb-4 and 60 g of THF as a solvent. In a nitrogen atmosphere, the reactor was cooled to -70°C, degassed under reduced pressure, and purged with nitrogen three times. The temperature was raised to room temperature, 0.1 g of AIBN was then added as a polymerization initiator, the temperature was raised to 60°C, and the mixture was reacted for 15 hours. The reaction solution was added to 1 L of hexane, and the precipitated white solid was separated by filtration. The resulting white solid was dried under reduced pressure at 60°C to obtain a polymer SP-9 as a random copolymer. The polymer SP-9 was analyzed for composition by ¹⁹F-NMR and ¹H-NMR spectroscopy and for Mw and Mw/Mn by GPC.

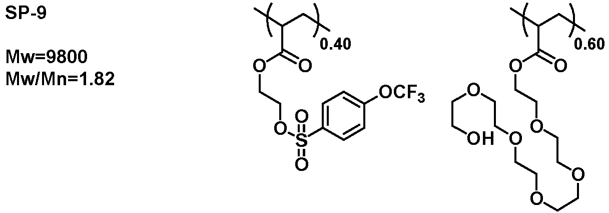

### Synthesis Example 10

### Synthesis of polymer SP-10

A reactor was charged with 13.6 g of the monomer Sa-9, 28.9 g of the monomer Sb-2 and 60 g of THF as a solvent. In a nitrogen atmosphere, the reactor was cooled to -70°C, degassed under reduced pressure, and purged with nitrogen three times. The temperature was raised to room temperature, 0.1 g of AIBN was then added as a polymerization initiator, the temperature was raised to 60°C, and the mixture was reacted for 15 hours. The reaction solution was added to 1 L of hexane, and the precipitated white solid was separated by filtration. The resulting white solid was dried under reduced pressure at 60°C to obtain a polymer SP-10 as a random copolymer. The polymer SP-10 was analyzed for composition by ¹⁹F-NMR and ¹H-NMR spectroscopy and for Mw and Mw/Mn by GPC.

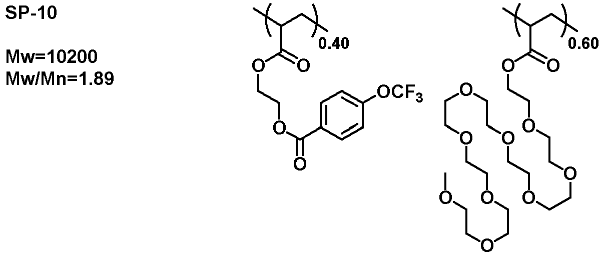

### Synthesis Example 11

### Synthesis of polymer SP-11

A reactor was charged with 11.0 g of the monomer Sa-10, 28.9 g of the monomer Sb-2 and 60 g of THF as a solvent. In a nitrogen atmosphere, the reactor was cooled to -70°C, degassed under reduced pressure, and purged with nitrogen three times. The temperature was raised to room temperature, 0.1 g of AIBN was then added as a polymerization initiator, the temperature was raised to 60°C, and the mixture was reacted for 15 hours. The reaction solution was added to 1 L of hexane, and the precipitated white solid was separated by filtration. The resulting white solid was dried under reduced pressure at 60°C to obtain a polymer SP-11 as a random copolymer. The polymer SP-11 was analyzed for composition by ¹⁹F-NMR and ¹H-NMR spectroscopy and for Mw and Mw/Mn by GPC.

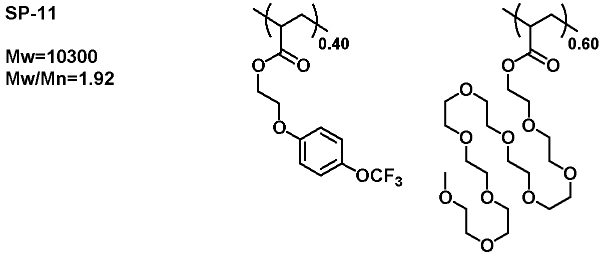

### Synthesis Example 12

### Synthesis of polymer SP-12

A reactor was charged with 11.0 g of the monomer Sa-11, 28.9 g of the monomer Sb-2 and 60 g of THF as a solvent. In a nitrogen atmosphere, the reactor was cooled to -70°C, degassed under reduced pressure, and purged with nitrogen three times. The temperature was raised to room temperature, 0.1 g of AIBN was then added as a polymerization initiator, the temperature was raised to 60°C, and the mixture was reacted for 15 hours. The reaction solution was added to 1 L of hexane, and the precipitated white solid was separated by filtration. The resulting white solid was dried under reduced pressure at 60°C to obtain a polymer SP-12 as a random copolymer. The polymer SP-12 was analyzed for composition by ¹⁹F-NMR and ¹H-NMR spectroscopy and for Mw and Mw/Mn by GPC.

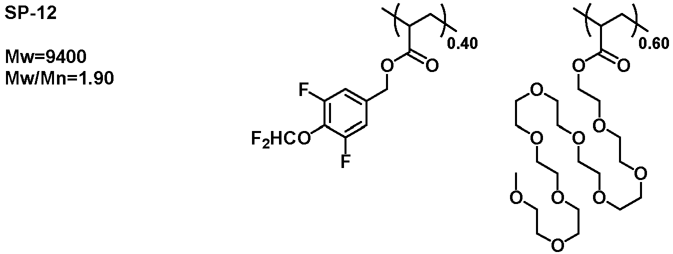

### Synthesis Example 13

### Synthesis of polymer SP-13

A reactor was charged with 19.8 g of the monomer Sa-12, 42.8 g of the monomer Sb-3 and 100 g of THF as a solvent. In a nitrogen atmosphere, the reactor was cooled to -70°C, degassed under reduced pressure, and purged with nitrogen three times. The temperature was raised to room temperature, 0.1 g of AIBN was then added as a polymerization initiator, the temperature was raised to 60°C, and the mixture was reacted for 15 hours. The reaction solution was added to 1 L of hexane, and the precipitated white solid was separated by filtration. The resulting white solid was dried under reduced pressure at 60°C to obtain a polymer SP-13 as a random copolymer. The polymer SP-13 was analyzed for composition by ¹⁹F-NMR and ¹H-NMR spectroscopy and for Mw and Mw/Mn by GPC.

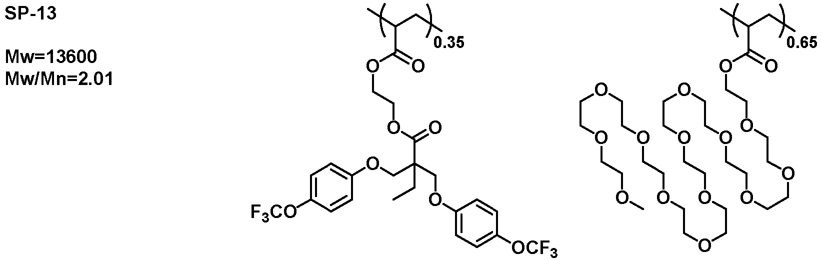

### Synthesis Example 14

### Synthesis of polymer SP-14

A reactor was charged with 12.8 g of the monomer Sa-13, 28.9 g of the monomer Sb-2 and 60 g of THF as a solvent. In a nitrogen atmosphere, the reactor was cooled to -70°C, degassed under reduced pressure, and purged with nitrogen three times. The temperature was raised to room temperature, 0.1 g of AIBN was then added as a polymerization initiator, the temperature was raised to 60°C, and the mixture was reacted for 15 hours. The reaction solution was added to 1 L of hexane, and the precipitated white solid was separated by filtration. The resulting white solid was dried under reduced pressure at 60°C to obtain a polymer SP-14 as a random copolymer. The polymer SP-14 was analyzed for composition by ¹⁹F-NMR and ¹H-NMR spectroscopy and for Mw and Mw/Mn by GPC.

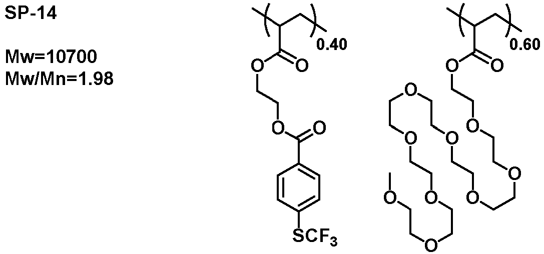

### Synthesis Example 15

### Synthesis of polymer SP-15

A reactor was charged with 11.6 g of the monomer Sa-14, 28.9 g of the monomer Sb-2 and 60 g of THF as a solvent. In a nitrogen atmosphere, the reactor was cooled to -70°C, degassed under reduced pressure, and purged with nitrogen three times. The temperature was raised to room temperature, 0.1 g of AIBN was then added as a polymerization initiator, the temperature was raised to 60°C, and the mixture was reacted for 15 hours. The reaction solution was added to 1 L of hexane, and the precipitated white solid was separated by filtration. The resulting white solid was dried under reduced pressure at 60°C to obtain a polymer SP-15 as a random copolymer. The polymer SP-15 was analyzed for composition by ¹⁹F-NMR and ¹H-NMR spectroscopy and for Mw and Mw/Mn by GPC.

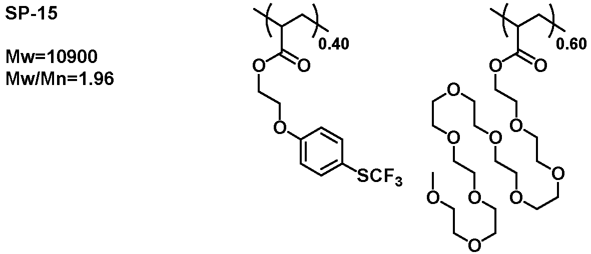

### Synthesis Example 16

### Synthesis of polymer SP-16

A reactor was charged with 33.2 g of the monomer Sa-15 and 80 g of THF as a solvent. In a nitrogen atmosphere, the reactor was cooled to -70°C, degassed under reduced pressure, and purged with nitrogen three times. The temperature was raised to room temperature, 0.1 g of AIBN was then added as a polymerization initiator, the temperature was raised to 60°C, and the mixture was reacted for 15 hours. The reaction solution was added to 1 L of hexane, and the precipitated white solid was separated by filtration. The resulting white solid was dried under reduced pressure at 60°C to obtain a polymer SP-16. The polymer SP-16 was analyzed for composition by ¹⁹F-NMR and ¹H-NMR spectroscopy and for Mw and Mw/Mn by GPC.

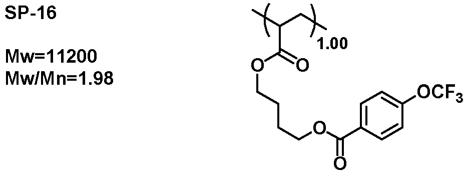

### Synthesis Example 17

### Synthesis of polymer SP-17

A reactor was charged with 34.8 g of the monomer Sa-16 and 80 g of THF as a solvent. In a nitrogen atmosphere, the reactor was cooled to -70°C, degassed under reduced pressure, and purged with nitrogen three times. The temperature was raised to room temperature, 0.1 g of AIBN was then added as a polymerization initiator, the temperature was raised to 60°C, and the mixture was reacted for 15 hours. The reaction solution was added to 1 L of hexane, and the precipitated white solid was separated by filtration. The resulting white solid was dried under reduced pressure at 60°C to obtain a polymer SP-17. The polymer SP-17 was analyzed for composition by ¹⁹F-NMR and ¹H-NMR spectroscopy and for Mw and Mw/Mn by GPC.

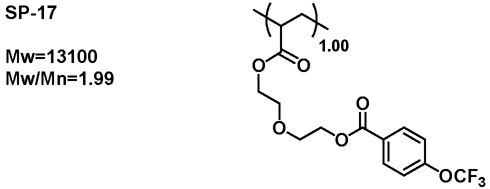

### Synthesis Example 18

### Synthesis of polymer SP-18

A reactor was charged with 17.0 g of the monomer Sa-17, 10.9 g of the monomer Sb-1 and 80 g of THF as a solvent. In a nitrogen atmosphere, the reactor was cooled to -70°C, degassed under reduced pressure, and purged with nitrogen three times. The temperature was raised to room temperature, 0.1 g of AIBN was then added as a polymerization initiator, the temperature was raised to 60°C, and the mixture was reacted for 15 hours. The reaction solution was added to 1 L of hexane, and the precipitated white solid was separated by filtration. The resulting white solid was dried under reduced pressure at 60°C to obtain a polymer SP-18 as a random copolymer. The polymer SP-18 was analyzed for composition by ¹⁹F-NMR and ¹H-NMR spectroscopy and for Mw and Mw/Mn by GPC.

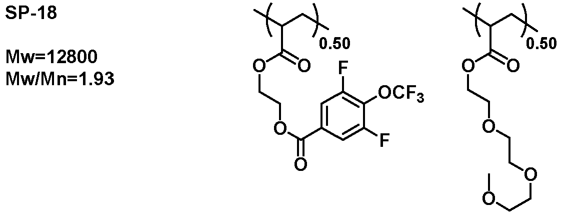

### Synthesis Example 19

### Synthesis of polymer SP-19

A reactor was charged with 19.4 g of the monomer Sa-18, 10.9 g of the monomer Sb-1 and 80 g of THF as a solvent. In a nitrogen atmosphere, the reactor was cooled to -70°C, degassed under reduced pressure, and purged with nitrogen three times. The temperature was raised to room temperature, 0.1 g of AIBN was then added as a polymerization initiator, the temperature was raised to 60°C, and the mixture was reacted for 15 hours. The reaction solution was added to 1 L of hexane, and the precipitated white solid was separated by filtration. The resulting white solid was dried under reduced pressure at 60°C to obtain a polymer SP-19 as a random copolymer. The polymer SP-19 was analyzed for composition by ¹⁹F-NMR and ¹H-NMR spectroscopy and for Mw and Mw/Mn by GPC.

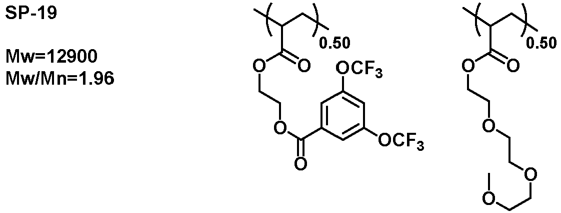

### Synthesis Example 20

### Synthesis of polymer SP-20

A reactor was charged with 24.3 g of the monomer Sa-9, 4.0 g of the monomer Sa-20 and 60 g of THF as a solvent. In a nitrogen atmosphere, the reactor was cooled to -70°C, degassed under reduced pressure, and purged with nitrogen three times. The temperature was raised to room temperature, 0.1 g of AIBN was then added as a polymerization initiator, the temperature was raised to 60°C, and the mixture was reacted for 15 hours. The reaction solution was added to 1 L of hexane, and the precipitated white solid was separated by filtration. The resulting white solid was dried under reduced pressure at 60°C to obtain a polymer SP-20 as a random copolymer. The polymer SP-20 was analyzed for composition by ¹⁹F-NMR and ¹H-NMR spectroscopy and for Mw and Mw/Mn by GPC.

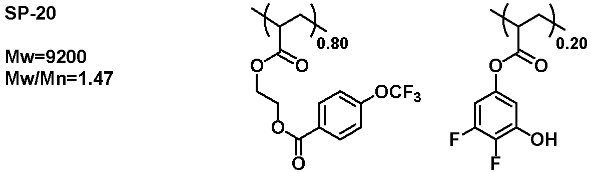

### Synthesis Example 21

### Synthesis of polymer SP-21

A reactor was charged with 24.3 g of the monomer Sa-9, 7.3 g of the monomer Sa-21 and 60 g of THF as a solvent. In a nitrogen atmosphere, the reactor was cooled to -70°C, degassed under reduced pressure, and purged with nitrogen three times. The temperature was raised to room temperature, 0.1 g of AIBN was then added as a polymerization initiator, the temperature was raised to 60°C, and the mixture was reacted for 15 hours. The reaction solution was added to 1 L of hexane, and the precipitated white solid was separated by filtration. The resulting white solid was dried under reduced pressure at 60°C to obtain a polymer SP-21 as a random copolymer. The polymer SP-21 was analyzed for composition by ¹⁹F-NMR and ¹H-NMR spectroscopy and for Mw and Mw/Mn by GPC.

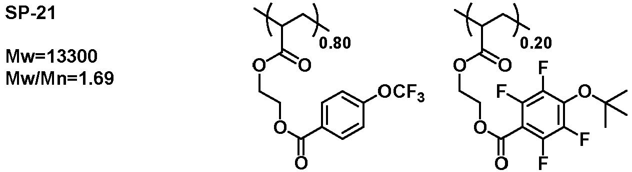

### Synthesis Example 22

### Synthesis of polymer SP-22

A reactor was charged with 24.3 g of the monomer Sa-9, 4.4 g of the monomer Sa-22 and 60 g of THF as a solvent. In a nitrogen atmosphere, the reactor was cooled to -70°C, degassed under reduced pressure, and purged with nitrogen three times. The temperature was raised to room temperature, 0.1 g of AIBN was then added as a polymerization initiator, the temperature was raised to 60°C, and the mixture was reacted for 15 hours. The reaction solution was added to 1 L of hexane, and the precipitated white solid was separated by filtration. The resulting white solid was dried under reduced pressure at 60°C to obtain a polymer SP-22 as a random copolymer. The polymer SP-22 was analyzed for composition by ¹⁹F-NMR and ¹H-NMR spectroscopy and for Mw and Mw/Mn by GPC.

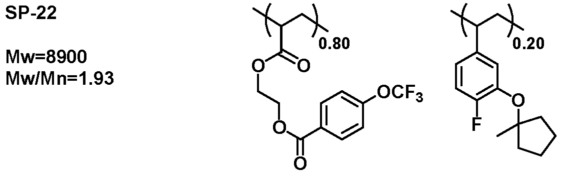

### Synthesis Example 23

### Synthesis of polymer SP-23

A reactor was charged with 35.5 g of the monomer Sa-23, 19.1 g of the monomer Sa-24 and 60 g of THF as a solvent. In a nitrogen atmosphere, the reactor was cooled to -70°C, degassed under reduced pressure, and purged with nitrogen three times. The temperature was raised to room temperature, 0.1 g of AIBN was then added as a polymerization initiator, the temperature was raised to 60°C, and the mixture was reacted for 15 hours. The reaction solution was added to 1 L of hexane, and the precipitated white solid was separated by filtration. The resulting white solid was dried under reduced pressure at 60°C to obtain a polymer SP-23 as a random copolymer. The polymer SP-23 was analyzed for composition by ¹⁹F-NMR and ¹H-NMR spectroscopy and for Mw and Mw/Mn by GPC.

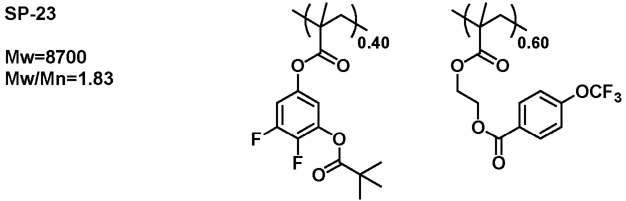

### Synthesis Example 24

### Synthesis of polymer SP-24

A reactor was charged with 24.3 g of the monomer Sa-9, 10.3 g of the monomer Sa-25 and 60 g of THF as a solvent. In a nitrogen atmosphere, the reactor was cooled to -70°C, degassed under reduced pressure, and purged with nitrogen three times. The temperature was raised to room temperature, 0.1 g of AIBN was then added as a polymerization initiator, the temperature was raised to 60°C, and the mixture was reacted for 15 hours. The reaction solution was added to 1 L of hexane, and the precipitated white solid was separated by filtration. The resulting white solid was dried under reduced pressure at 60°C to obtain a polymer SP-24 as a random copolymer. The polymer SP-24 was analyzed for composition by ¹⁹F-NMR and ¹H-NMR spectroscopy and for Mw and Mw/Mn by GPC.

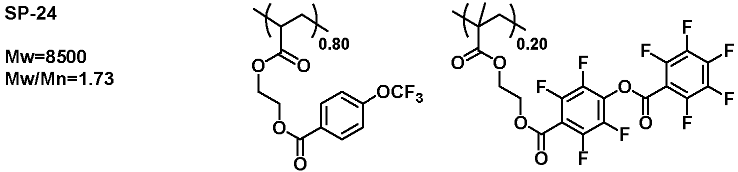

### Synthesis Example 25

### Synthesis of polymer SP-25

A reactor was charged with 24.3 g of the monomer Sa-9, 9.8 g of the monomer Sa-26 and 60 g of THF as a solvent. In a nitrogen atmosphere, the reactor was cooled to -70°C, degassed under reduced pressure, and purged with nitrogen three times. The temperature was raised to room temperature, 0.1 g of AIBN was then added as a polymerization initiator, the temperature was raised to 60°C, and the mixture was reacted for 15 hours. The reaction solution was added to 1 L of hexane, and the precipitated white solid was separated by filtration. The resulting white solid was dried under reduced pressure at 60°C to obtain a polymer SP-25 as a random copolymer. The polymer SP-25 was analyzed for composition by ¹⁹F-NMR and ¹H-NMR spectroscopy and for Mw and Mw/Mn by GPC.

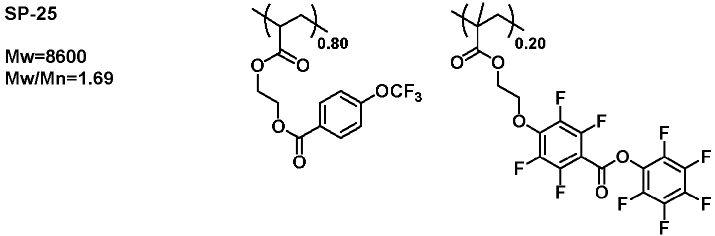

### Synthesis Example 26

### Synthesis of polymer SP-26

A reactor was charged with 17.8 g of p-trifluoromethoxyphenol, 90 g of a 37 wt% formalin aqueous solution and 5 g of oxalic acid, and the mixture was reacted with stirring at 100°C for 24 hours. The reaction solution was dissolved in 500 mL of methyl isobutyl ketone, the catalyst and metal impurities were removed by sufficient washing with water, the solvent was removed under reduced pressure, and the residue was decompressed to 2 mmHg at 150°C to remove moisture and unreacted monomers, thereby obtaining a polymer SP-26. The polymer SP-26 was analyzed for composition by ¹⁹F-NMR and ¹H-NMR spectroscopy and for Mw and Mw/Mn by GPC.

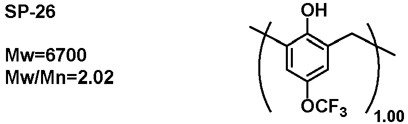

### Synthesis Example 27

### Synthesis of polymer SP-27

A reactor was charged with 17.8 g of p-trifluoromethoxyphenol, 20 g of 3-trifluoromethoxybenzaldehyde and 5 g of oxalic acid, and the mixture was reacted with stirring at 100°C for 24 hours. The reaction solution was dissolved in 500 mL of methyl isobutyl ketone, the catalyst and metal impurities were removed by sufficient washing with water, the solvent was removed under reduced pressure, and the residue was decompressed to 2 mmHg at 150°C to remove moisture and unreacted monomers, thereby obtaining a polymer SP-27. The polymer SP-27 was analyzed for composition by ¹⁹F-NMR and ¹H-NMR spectroscopy and for Mw and Mw/Mn by GPC.

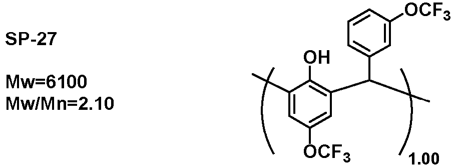

### Synthesis Example 28

### Synthesis of polymer SP-28

A reactor was charged with 35.0 g of 9,9-bis(4-hydroxyphenyl)fluorenemonotrifluoromethoxybenzmethanol, 20 g of 4-trifluoromethoxybenzaldehyde and 5 g of oxalic acid, and the mixture was reacted with stirring at 100°C for 24 hours. The reaction solution was dissolved in 500 mL of methyl isobutyl ketone, the catalyst and metal impurities were removed by sufficient washing with water, and the solvent was removed under reduced pressure. The residue was heated to 150°C, and decompressed to 2 mmHg to remove moisture and unreacted monomers, thereby obtaining a polymer SP-28. The polymer SP-28 was analyzed for composition by ¹⁹F-NMR and ¹H-NMR spectroscopy and for Mw and Mw/Mn by GPC.

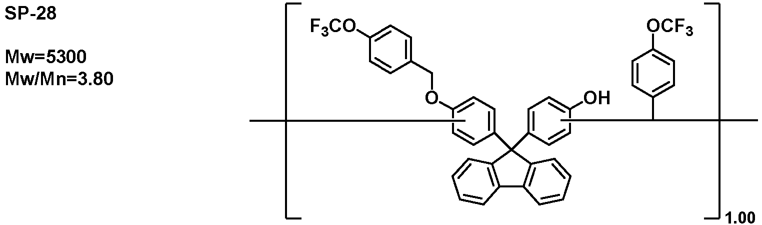

### Synthesis Example 29

### Synthesis of polymer SP-29

A reactor was charged with 45.0 g of 9,9-bis(6-hydroxynaphthyl)fluorenemonotrifluoromethoxybenzmethanol, 20 g of 4-trifluoromethoxybenzaldehyde and 5 g of oxalic acid, and the mixture was reacted with stirring at 100°C for 24 hours. The reaction solution was dissolved in 500 mL of methyl isobutyl ketone, the catalyst and metal impurities were removed by sufficient washing with water, and the solvent was removed under reduced pressure. The residue was heated to 150°C, and decompressed to 2 mmHg to remove moisture and unreacted monomers, thereby obtaining a polymer SP-29. The polymer SP-29 was analyzed for composition by ¹⁹F-NMR and ¹H-NMR spectroscopy and for Mw and Mw/Mn by GPC.

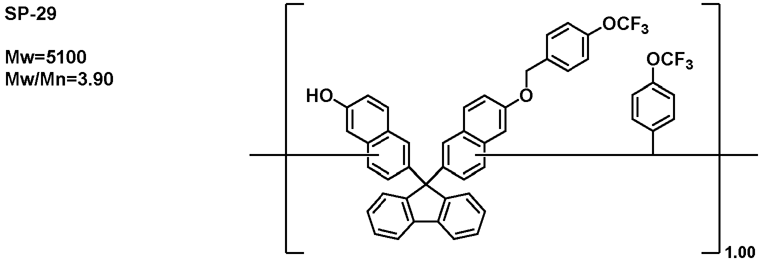

### Synthesis Example 30

### Synthesis of polymer SP-30

A reactor was charged with 44.0 g of 1,1,1-tris(4-hydroxyphenyl)ethanemonotrifluoromethoxybenzmethanol, 20 g of 4-trifluoromethoxybenzaldehyde and 5 g of oxalic acid, and the mixture was reacted with stirring at 100°C for 24 hours. The reaction solution was dissolved in 500 mL of methyl isobutyl ketone, the catalyst and metal impurities were removed by sufficient washing with water, and the solvent was removed under reduced pressure. The residue was heated to 150°C, and decompressed to 2 mmHg to remove moisture and unreacted monomers, thereby obtaining a polymer SP-30. The polymer SP-30 was analyzed for composition by ¹⁹F-NMR and ¹H-NMR spectroscopy and for Mw and Mw/Mn by GPC.

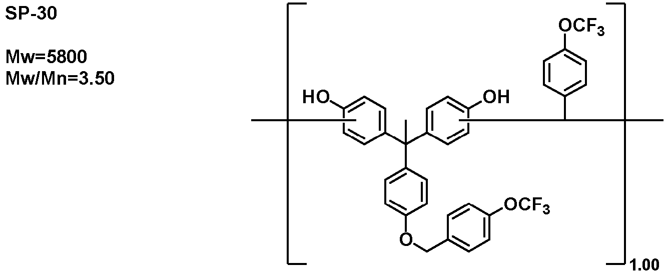

### Synthesis Example 31

### Synthesis of polymer SP-31

A reactor was charged with 38.0 g of 2,7-dihydroxynaphthalenemonotrifluoromethoxybenzmethanol, 20 g of 4-trifluoromethoxybenzaldehyde and 5 g of oxalic acid, and the mixture was reacted with stirring at 100°C for 24 hours. The reaction solution was dissolved in 500 mL of methyl isobutyl ketone, the catalyst and metal impurities were removed by sufficient washing with water, and the solvent was removed under reduced pressure. The residue was heated to 150°C, and decompressed to 2 mmHg to remove moisture and unreacted monomers, thereby obtaining a polymer SP-31. The polymer SP-31 was analyzed for composition by ¹⁹F-NMR and ¹H-NMR spectroscopy and for Mw and Mw/Mn by GPC.

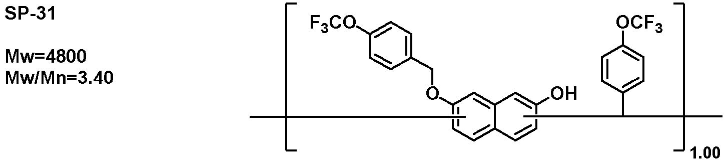

### Synthesis Example 32

### Synthesis of polymer SP-32

A reactor was charged with 14.7 g of the monomer Sa-27, 2.3 g of hydroxyethyl acrylate and 20 g of THF as a solvent. In a nitrogen atmosphere, the reactor was cooled to -70°C, degassed under reduced pressure, and purged with nitrogen three times. The temperature was raised to room temperature, 0.1 g of AIBN was then added as a polymerization initiator, the temperature was raised to 60°C, and the mixture was reacted for 15 hours. The reaction solution was added to 1 L of hexane, and the precipitated white solid was separated by filtration. The resulting white solid was dried under reduced pressure at 60°C to obtain a polymer SP-32 as a random copolymer. The polymer SP-32 was analyzed for composition by ¹⁹F-NMR and ¹H-NMR spectroscopy and for Mw and Mw/Mn by GPC.

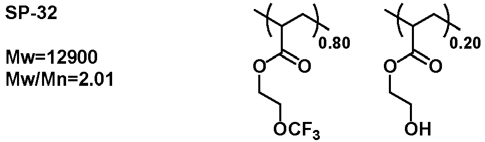

### Synthesis Example 33

### Synthesis of polymer SP-33

A reactor was charged with 29.5 g of the monomer Sa-28, 2.2 g of mono(2-acryloyloxyethyl) succinate and 50 g of THF as a solvent. In a nitrogen atmosphere, the reactor was cooled to -70°C, degassed under reduced pressure, and purged with nitrogen three times. The temperature was raised to room temperature, 0.1 g of AIBN was then added as a polymerization initiator, the temperature was raised to 60°C, and the mixture was reacted for 15 hours. The reaction solution was added to 1 L of hexane, and the precipitated white solid was separated by filtration. The resulting white solid was dried under reduced pressure at 60°C to obtain a polymer SP-33 as a random copolymer. The polymer SP-33 was analyzed for composition by ¹⁹F-NMR and ¹H-NMR spectroscopy and for Mw and Mw/Mn by GPC.

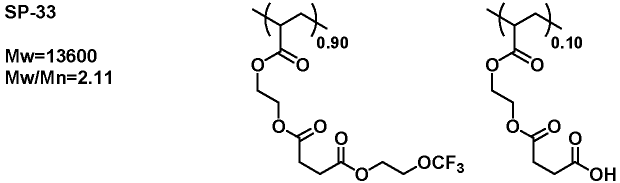

### Synthesis Example 34

### Synthesis of polymer SP-34

A reactor was charged with 15.2 g of the monomer Sa-29, 5.8 g of the monomer Sb-5 and 20 g of 1,2-dichloroethane as a solvent. The reactor was placed in a nitrogen atmosphere, 0.2 g of trifluoroboron was added as a polymerization initiator, and the mixture was heated to 60°C, and then reacted for 15 hours. The reaction solution was concentrated to half its original volume, and made to form a precipitate in a mixed solution of 1.5 L of methanol and 0.2 L of water, and the resulting white solid was separated by filtration, and dried under reduced pressure at 60°C to obtain a polymer SP-34 as a random copolymer. The polymer SP-34 was analyzed for composition by ¹⁹F-NMR and ¹H-NMR spectroscopy and for Mw and Mw/Mn by GPC.

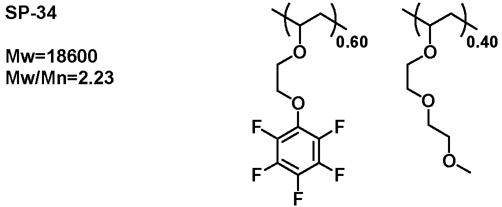

### Synthesis Example 35

### Synthesis of polymer SP-35

A reactor was charged with 14.9 g of the monomer Sa-30, 5.8 g of the monomer Sb-5 and 20 g of 1,2-dichloroethane as a solvent. The reactor was placed in a nitrogen atmosphere, 0.2 g of trifluoroboron was added as a polymerization initiator, and the mixture was heated to 60°C, and then reacted for 15 hours. The reaction solution was concentrated to half its original volume, and made to form a precipitate in a mixed solution of 1.5 L of methanol and 0.2 L of water, and the resulting white solid was separated by filtration, and dried under reduced pressure at 60°C to obtain a polymer SP-35 as a random copolymer. The polymer SP-35 was analyzed for composition by ¹⁹F-NMR and ¹H-NMR spectroscopy and for Mw and Mw/Mn by GPC.

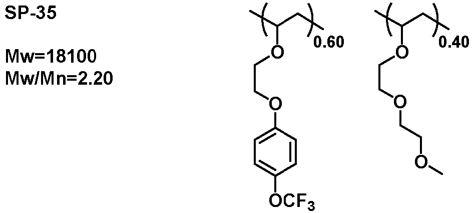

### Synthesis Example 36

### Synthesis of polymer SP-36

A reactor was charged with 38.1 g of the monomer Sa-31 and 60 g of THF as a solvent. In a nitrogen atmosphere, the reactor was cooled to -70°C, degassed under reduced pressure, and purged with nitrogen three times. The temperature was raised to room temperature, 0.1 g of AIBN was then added as a polymerization initiator, the temperature was raised to 60°C, and the mixture was reacted for 15 hours. The reaction solution was added to 1 L of hexane, and the precipitated white solid was separated by filtration. The resulting white solid was dried under reduced pressure at 60°C to obtain a polymer SP-36. The polymer SP-36 was analyzed for composition by ¹⁹F-NMR and ¹H-NMR spectroscopy and for Mw and Mw/Mn by GPC.

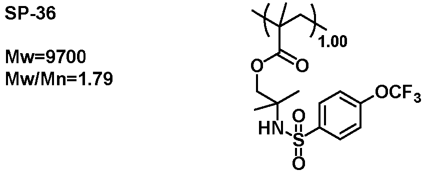

### Synthesis Example 37

### Synthesis of polymer SP-37

A reactor was charged with 38.7 g of the monomer Sa-32 and 60 g of THF as a solvent. In a nitrogen atmosphere, the reactor was cooled to -70°C, degassed under reduced pressure, and purged with nitrogen three times. The temperature was raised to room temperature, 0.1 g of AIBN was then added as a polymerization initiator, the temperature was raised to 60°C, and the mixture was reacted for 15 hours. The reaction solution was added to 1 L of hexane, and the precipitated white solid was separated by filtration. The resulting white solid was dried under reduced pressure at 60°C to obtain a polymer SP-37. The polymer SP-37 was analyzed for composition by ¹⁹F-NMR and ¹H-NMR spectroscopy and for Mw and Mw/Mn by GPC.

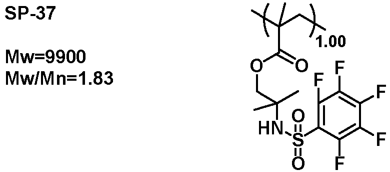

### Synthesis Example 38

### Synthesis of polymer SP-38

The polymer SP-27 was glycidylated, and reacted with p-trifluoromethoxybenzoic acid to obtain a polymer SP-38. The polymer SP-38 was analyzed for composition by ¹⁹F-NMR and ¹H-NMR spectroscopy and for Mw and Mw/Mn by GPC.

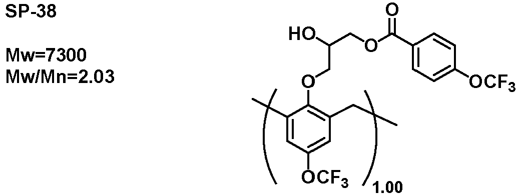

### Synthesis Example 39

### Synthesis of polymer SP-39

A reactor was charged with 29.4 g of the monomer Sa-33 and 80 g of THF as a solvent. In a nitrogen atmosphere, the reactor was cooled to -70°C, degassed under reduced pressure, and purged with nitrogen three times. The temperature was raised to room temperature, 0.1 g of AIBN was then added as a polymerization initiator, the temperature was raised to 60°C, and the mixture was reacted for 15 hours. The reaction solution was added to 1 L of hexane, and the precipitated white solid was separated by filtration. The resulting white solid was dried under reduced pressure at 60°C to obtain a polymer SP-39. The polymer SP-39 was analyzed for composition by ¹⁹F-NMR and ¹H-NMR spectroscopy and for Mw and Mw/Mn by GPC.

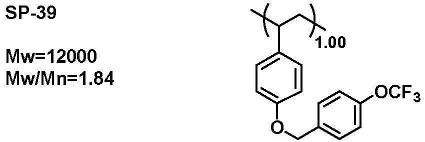

### Synthesis Examples 40 to 44

### Synthesis of base polymer (polymers P-1 to P-5)

Base polymers (polymers P-1 to P-5) each having the composition shown below were synthesized by combining monomers, effecting a copolymerization reaction in a THF solvent, pouring the reaction solution into methanol, washing the solid precipitate with hexane, isolation, and drying. The base polymers were analyzed for composition by ¹H-NMR spectroscopy and for Mw and Mw/Mn by GPC versus polystyrene standards using a THF solvent.

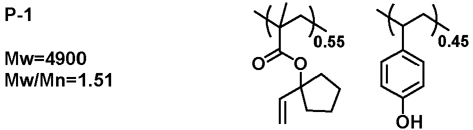

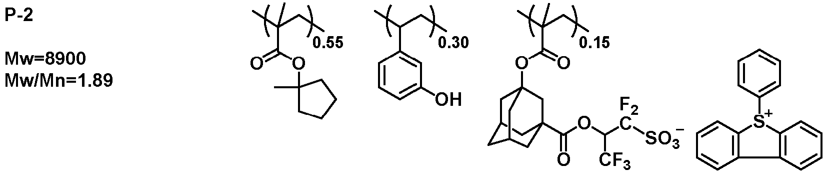

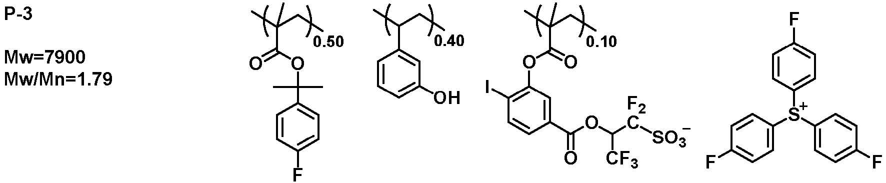

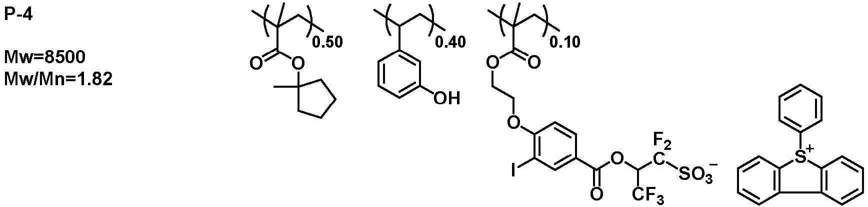

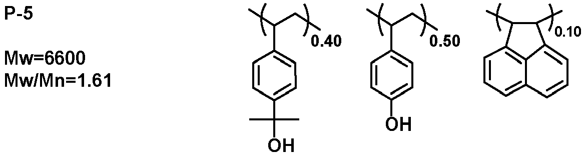

The components in Table 1 are as follows.
Organic solvents:
   PGMEA (propylene glycol monomethyl ether acetate)
   DAA (diacetone alcohol)
   EL (ethyl lactate)
Acid generator (PAG-1), quencher (Q-1)

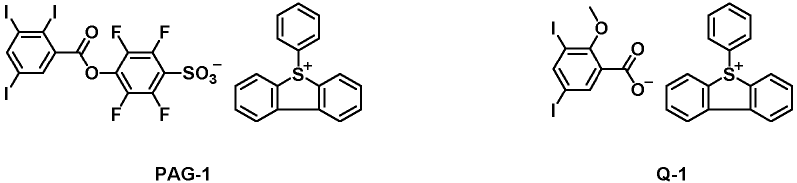

### Examples 1 to 40 and Comparative Example 1

A solution obtained by dissolving the components according to the composition shown in Tables 1 and 2 was filtered through a polyethylene filter with a pore size 3 nm to prepare a resist composition.

Each of the resist compositions shown in Tables 1 and 2 was dispensed on a silicon substrate having a diameter of 300 mm, then applied to the substrate by spin coating, and prebaked on a hotplate at 110°C for 30 seconds to form a resist film having a thickness of 60 nm. The thickness of the resist film was measured at 225 points along a concentric circle within the wafer plane using an optical film thickness meter, and a difference between the maximum value and the minimum value of the thickness was determined. The results are shown in Tables 1 and 2. The resist compositions of Examples 1 to 39 and Comparative Example 1 were of positive tone, and the resist composition of Example 40 was of negative tone.

**Table 1**

| | | Base polymer (pbw) | Organic solvent (pbw) | Surfactant (pbw) | Additive (pbw) | Thickness difference (Å) |
|---|---|---|---|---|---|---|
| | 1 | P-1 (100) | PGMEA (1500) | SP-1 (0.1) | PAG-1 (25.0) | 8 |
| | | | EL (1000) | | Q-1 (6.6) | |
| | 2 | P-1 (100) | PGMEA (1500) | SP-1 (0.2) | PAG-1 (25.0) | 6 |
| | | | EL (1000) | | Q-1 (6.6) | |
| | 3 | P-1 (100) | PGMEA (1500) | SP-1 (0.5) | PAG-1 (25.0) | 6 |
| | | | EL (1000) | | Q-1 (6.6) | |
| | 4 | P-2 (100) | PGMEA (1000) | SP-2 (0.2) | Q-1 (6.6) | 3 |
| | | | EL (1500) | | | |
| | 5 | P-3 (100) | PGMEA (1000) | SP-3 (0.2) | Q-1 (6.6) | 6 |
| | | | EL (1500) | | | |
| | 6 | P-4 (100) | PGMEA (1000) | SP-4 (0.2) | Q-1 (6.6) | 4 |
| | | | EL (1500) | | | |
| | 7 | P-2 (100) | EL (2500) | SP-5 (0.2) | Q-1 (6.6) | 4 |
| | 8 | P-2 (100) | PGMEA (2000) | SP-6 (0.12) | Q-1 (6.6) | 5 |
| | | | DAA (500) | | | |
| | 9 | P-2 (100) | PGMEA (2000) | SP-7 (0.2) | Q-1 (6.6) | 6 |
| | | | DAA (500) | | | |
| | 10 | P-2 (100) | PGMEA (2000) | SP-8 (0.2) | Q-1 (6.6) | 8 |
| | | | DAA (500) | | | |
| Example | 11 | P-2 (100) | PGMEA (2000) | SP-9 (0.2) | Q-1 (6.6) | 6 |
| | | | DAA (500) | | | |
| | 12 | P-2 (100) | PGMEA (2000) | SP-10 (0.2) | Q-1 (6.6) | 7 |
| | | | DAA (500) | | | |
| | 13 | P-2 (100) | PGMEA (2000) | SP-11 (0.2) | Q-1 (6.6) | 7 |
| | | | DAA (500) | | | |
| | 14 15 | P-2 (100) | PGMEA (2000) | SP-12 (0.2) | Q-1 (6.6) | 8 |
| | | | DAA (500) | | | |
| | | P-2 (100) | PGMEA (2000) | SP-13 (0.1) | Q-1 (6.6) | 5 |
| | | | DAA (500) | | | |
| | 16 | P-2 (100) | PGMEA (2000) | SP-14 (0.2) | Q-1 (6.6) | 7 |
| | | | DAA (500) | | | |
| | 17 | P-2 (100) | PGMEA (2000) | SP-15 (0.1) | Q-1 (6.6) | 6 |
| | | | DAA (500) | | | |
| | 18 | P-2 (100) | PGMEA (2000) | SP-16 (0.1) | Q-1 (6.6) | 6 |
| | | | DAA (500) | | | |
| | 19 | P-2 (100) | PGMEA (2000) | SP-17 (0.1) | Q-1 (6.6) | 5 |
| | | | DAA (500) | | | |
| | 20 | P-2 (100) | PGMEA (2000) | SP-18 (0.1) | Q-1 (6.6) | 6 |
| | | | DAA (500) | | | |
| | 21 | P-2 (100) | PGMEA (2000) | SP-19 (0.1) | Q-1 (6.6) | 7 |
| | | | DAA (500) | | | |

**Table 2**

| | | Base polymer (pbw) | Organic solvent (pbw) | Surfactant (pbw) | Additive (pbw) | Thickness difference (Å) |
|---|---|---|---|---|---|---|
| | 22 | P-2 (100) | PGMEA (2000) | SP-20 (4.0) | Q-1 (6.6) | 7 |
| | | | DAA (500) | | | |
| | 23 | P-2 (100) | PGMEA (2000) | SP-21 (5.0) | Q-1 (6.6) | 7 |
| | | | DAA (500) | | | |
| | 24 | P-2 (100) | PGMEA (2000) | SP-22 (3.3) | Q-1 (6.6) | 7 |
| | | | DAA (500) | | | |
| | 25 | P-2 (100) | PGMEA (2000) | SP-23 (2.8) | Q-1 (6.6) | 6 |
| | | | DAA (500) | | | |
| | 26 | P-2 (100) | PGMEA (2000) | SP-24 (2.1) | Q-1 (6.6) | 7 |
| | | | DAA (500) | | | |
| | 27 | P-2 (100) | PGMEA (2000) | SP-25 (2.1) | Q-1 (6.6) | 7 |
| | | | DAA (500) | | | |
| | 28 | P-2 (100) | PGMEA (2000) | SP-26 (0.5) | Q-1 (6.6) | 6 |
| | | | DAA (500) | | | |
| | 29 | P-2 (100) | PGMEA (2000) | SP-27 (0.5) | Q-1 (6.6) | 8 |
| | | | DAA (500) | | | |
| | 30 | P-2 (100) | PGMEA (2000) | SP-28 (0.5) | Q-1 (6.6) | 7 |
| | | | DAA (500) | | | |
| Example | 31 | P-2 (100) | PGMEA (2000) | SP-29 (0.5) | Q-1 (6.6) | 8 |
| | | | DAA (500) | | | |
| | 32 | P-2 (100) | PGMEA (2000) | SP-30 (0.1) | Q-1 (6.6) | 6 |
| | | | DAA (500) | | | |
| | 33 | P-2 (100) | PGMEA (2000) | SP-31 (0.1) | Q-1 (6.6) | 6 |
| | | | DAA (500) | | | |
| | 34 | P-2 (100) | PGMEA (2000) | SP-32 (0.1) | Q-1 (6.6) | 5 |
| | | | DAA (500) | | | |
| | 35 | P-2 (100) | PGMEA (2000) | SP-33 (0.1) | Q-1 (6.6) | 5 |
| | | | DAA (500) | | | |
| | 36 | P-2 (100) | PGMEA (2000) | SP-34 (0.1) | Q-1 (6.6) | 5 |
| | | | DAA (500) | SP-36 (4.0) | | |
| | 37 | P-2 (100) | PGMEA (2000) | SP-35 (0.1) | Q-1 (6.6) | 5 |
| | | | DAA (500) | SP-37 (4.0) | | |
| | 38 | P-2 (100) | PGMEA (2000) | SP-38 (0.1) | Q-1 (6.6) | 5 |
| | | | DAA (500) | | | |
| | 39 | P-2 (100) | PGMEA (2000) | SP-39 (0.1) | Q-1 (6.6) | 5 |
| | | | DAA (500) | | | |
| | 40 | P-5 (100) | PGMEA (2000) | SP-2 (0.2) | PAG-1 (25.0) | 4 |
| | | | DAA (500) | | Q-1 (6.6) | |
| Comparative Example | 1 | P-1 (100) | PGMEA (1500) | | Q-1 (6.6) | 20 |
| | | | EL (1000) | | | |

From the results shown in Tables 1 and 2, it was found that a resist film obtained from the resist composition of the present invention containing a surfactant made from a resin having an aromatic group substituted with a fluorine atom, a trifluoromethoxy group, a difluoromethoxy group, a trifluoromethylthio group or a difluoromethylthio group, a base polymer and an organic solvent had a uniform thickness.

## Claims

1. A coating material for photolithography comprising 0.0001 to 3 wt% of a surfactant made from a resin having an aromatic group substituted with a fluorine atom, a trifluoromethoxy group, a difluoromethoxy group, a trifluoromethylthio group, or a difluoromethylthio group.

2. The coating material for photolithography according to claim 1, wherein the resin is a polymer containing repeat units Sa having an aromatic group substituted with a fluorine atom, a trifluoromethoxy group, a difluoromethoxy group, a trifluoromethylthio group, or a difluoromethylthio group.

3. The coating material for photolithography according to claim 2, wherein the repeat unit Sa has one of the following formulae (Sa1) to (Sa5): 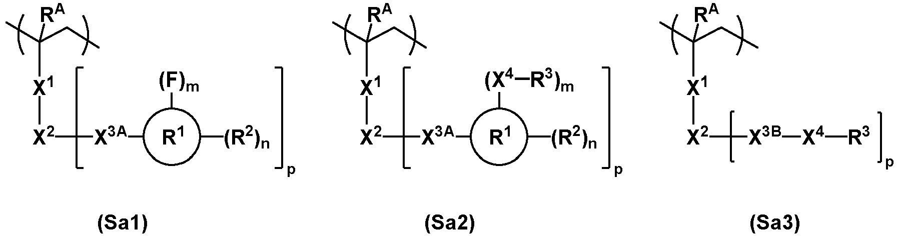 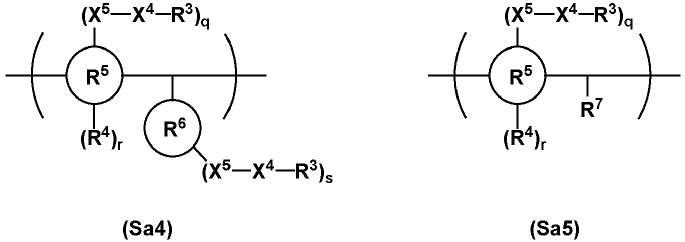 wherein m is each independently an integer of 1 to 5, n is each independently an integer of 0 to 4, p is each independently an integer of 1 to 3, q is each independently an integer of 0 to 3, r is an integer of 0 to 3, s is an integer of 0 to 4, provided that q + s is an integer of 1 to 5,
R^{A} is each independently a hydrogen atom or a methyl group,
X¹ is each independently a single bond, an ester bond, an ether bond, an amide bond or a phenylene group,
X² is each independently a single bond or a C₁-C₂₀ hydrocarbylene group when p is 1, a C₁-C₂₀ (p+1)-valent hydrocarbon group when p is 2 or 3, and the hydrocarbylene group and the (p+1)-valent hydrocarbon group may contain at least one selected from an oxygen atom, a sulfur atom, a nitrogen atom and a halogen atom,
X^{3A} is each independently a single bond, an ester bond, an ether bond, an amide bond, a sulfonic acid ester bond, a urethane bond, a thiourethane bond, a urea bond or -S(=O)-N(X³¹)-, X³¹ is a hydrogen atom or a C₁-C₆ saturated hydrocarbyl group,
X^{3B} is a single bond or a carbonyl group,
X⁴ is -O- or -S-,
X⁵ is a single bond or a C₁-C₁₂ hydrocarbylene group, and the hydrocarbylene group may have at least one selected from a hydroxy group, a C₁-C₆ saturated hydrocarbyloxy group, an ether bond and an ester bond,
the circle R¹ is each independently, a (m+n+1)-valent group derived from benzene or naphthalene,
R² is each independently a hydrogen atom, a C₁-C₆ hydrocarbyl group, a C₁-C₁₂ hydrocarbyloxy group, a C₂-C₆ hydrocarbyloxycarbonyl group, a C₂-C₁₂ hydrocarbylcarbonyloxy group, a hydroxy group, a carboxy group, a halogen atom, a cyano group or a nitro group,
R³ is each independently a trifluoromethyl group or a difluoromethyl group,
R⁴ is each independently a C₁-C₆ hydrocarbyl group, a C₁-C₁₂ hydrocarbyloxy group, a C₂-C₆ hydrocarbyloxycarbonyl group, a C₂-C₁₂ hydrocarbylcarbonyloxy group, a hydroxy group, a carboxy group, a halogen atom, a cyano group or a nitro group,
the circle R⁵ is each independently a C₆-C₃₀ (q+r+2)-valent aromatic hydrocarbon group,
the circle R⁶ is a (s+1)-valent group derived from benzene or naphthalene, and
R⁷ is a hydrogen atom or a C₁-C₁₀ hydrocarbyl group, and the hydrocarbyl group may contain an oxygen atom, provided that R⁷ does not have a group of -X⁵-X⁴-R³.

4. The coating material for photolithography according to claim 3, wherein at least one of X¹ and X² is not a single bond.

5. The coating material for photolithography according to claim 3, which is a polymer containing repeat units of formula (Sa1) and repeat units of formula (Sa2).

6. The coating material for photolithography according to claim 2, wherein the polymer further contains repeat units Sb having a hydrophilic group selected from an ether bond, an ester bond, a hydroxy group, a carboxy group, a sulfonamide bond, a sulfonimide bond and a sulfo group.

7. The coating material for photolithography according to claim 6, wherein the polymer is a block copolymer.

8. A resist composition comprising the coating material for photolithography of claim 1.

9. The resist composition according to claim 8, further comprising a base polymer and an organic solvent.

10. A pattern forming process comprising the steps of:
applying the resist composition of claim 8 or 9 onto a substrate to form a resist film on the substrate,
exposing the resist film to high-energy radiation, and
developing the exposed resist film in a developer.

11. The pattern forming process of claim 10, wherein the high-energy radiation is a g-ray, an i-ray, KrF excimer laser, ArF excimer laser, an ultraviolet ray, an electron beam, or extreme ultraviolet having a wavelength of 3 to 15 nm.
